# EUROPEAN PATENT SPECIFICATION

(11) **EP 4 464 758 B1**
(45) Date of publication and mention of the grant of the patent: **11.11.2026**
(21) Application number: 24175642.8
(22) Date of filing: 14.05.2024
(51) Int. Cl.: C09K 11/06, C07F 5/02, H10K 50/11, H10K 85/30, H10K 85/60, H10K 101/20

(54) **CONDENSED POLYCYCLIC COMPOUND, LIGHT-EMITTING DEVICE INCLUDING THE SAME, AND ELECTRONIC APPARATUS INCLUDING THE LIGHT-EMITTING DEVICE**
KONDENSIERTE POLYCYCLISCHE VERBINDUNG, LICHTEMITTIERENDE VORRICHTUNG DAMIT UND ELEKTRONISCHE VORRICHTUNG MIT DER LICHTEMITTIERENDEN VORRICHTUNG
COMPOSÉ POLYCYCLIQUE CONDENSÉ, DISPOSITIF ÉLECTROLUMINESCENT LE COMPRENANT ET APPAREIL ÉLECTRONIQUE COMPRENANT LE DISPOSITIF ÉLECTROLUMINESCENT

(30) Priority: 16.05.2023 KR 20230063362
(43) Date of publication of application: 20.11.2024
(73) Proprietor: Samsung Display Co., Ltd., Yongin-si, Gyeonggi-do 17113 (KR)
(72) Inventor: JEON, Soonok, 16678 Suwon-si (KR); KIM, Sangmo, 16678 Suwon-si (KR); MARUYAMA, Yusuke, 16678 Suwon-si (KR); LEE, Eunkyung, 16678 Suwon-si (KR); LEE, Halim, 16678 Suwon-si (KR); KIM, Jiwhan, 16678 Suwon-si (KR); NAM, Sungho, 16678 Suwon-si (KR); WON, Joonghee, 16678 Suwon-si (KR); IHN, Sooghang, 16678 Suwon-si (KR); JUNG, Yongsik, 16678 Suwon-si (KR)
(74) Representative: Elkington and Fife LLP

(56) References cited:
- WO-A1-2022/267721
- WO-A1-2023/068786
- CN-A- 114 539 287
- US-A1- 2023 133 149

## Description

### FIELD OF THE INVENTION

The disclosure relates to a condensed polycyclic compound, a light-emitting device including the same, and an electronic apparatus including the light-emitting device.

### BACKGROUND OF THE INVENTION

From among light-emitting devices, organic light-emitting devices (OLEDs) are self-emissive devices that, as compared with conventional devices, have wide viewing angles, high contrast ratios, short response times, and excellent characteristics in terms of luminance, driving voltage, and response speed, and produce full-color images.

In an example, an organic light-emitting device may include an anode, a cathode, and an interlayer that is arranged between the anode and the cathode and includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. The excitons may transition from an excited state to a ground state, thus generating light.

CN 114539287 and WO 2023/068786 disclose polycyclic compounds which may be used in a luminescent layer of an organic electroluminescent device.

### SUMMARY OF THE INVENTION

Provided are a condensed polycyclic compound, a light-emitting device employing the same, and an electronic apparatus including the light-emitting device.

Additional aspects will be set forth in part in the description which follows and, in part, will be apparent from the description, or may be learned by practice of the presented embodiments of the disclosure.

According to the invention, provided is a condensed polycyclic compound which does not include a metal and includes a condensed ring, wherein the condensed ring includes a 9-membered ring including nitrogen and carbon as ring-forming atoms and a 6-membered ring including nitrogen, carbon, and boron as ring-forming atoms, wherein the 9-membered ring and the 6-membered ring are condensed with each other while sharing a nitrogen and a carbon.

According to an embodiment, a light-emitting device includes a first electrode, a second electrode, and an interlayer arranged between the first electrode and the second electrode and including an emission layer, wherein the interlayer may include at least one condensed polycyclic compound described above.

According to another embodiment, an electronic apparatus includes the light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:
FIGURE is a schematic cross-sectional view of a light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

### Description of condensed polycyclic compound

The condensed polycyclic compound i) does not include a metal, and ii) includes a condensed ring. The condensed ring includes a 9-membered ring including nitrogen and carbon as ring-forming atoms and a 6-membered ring including nitrogen, carbon, and boron as ring-forming atoms, wherein the 9-membered ring and the 6-membered ring are condensed with each other while sharing a nitrogen and a carbon. In the specification, the "condensed ring" is the ring having the same meaning as described above.

In an embodiment, the condensed ring may include a moiety represented by Formula 1(1): 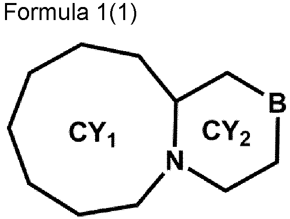 wherein, in Formula 1(1),
ring CY₁ may be a 9-membered ring including nitrogen and carbon, and
ring CY₂ may be a 6-membered ring including nitrogen, carbon, and boron.

In an embodiment, at least one cyclic group selected from a C₅-C₆₀ carbocyclic group and a C₃-C₆₀ heterocyclic group may be additionally condensed with moiety represented by Formula 1(1).

For example, the condensed ring may include a moiety represented by Formula 1(1)-a: 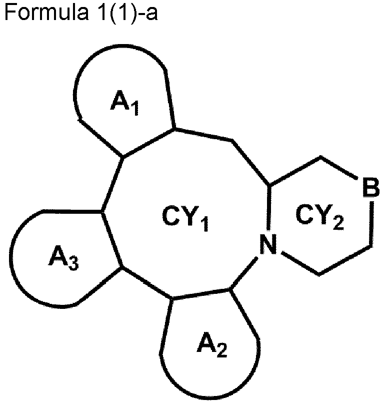 wherein, in Formula 1(1)-a,
ring CY₁ may be a 9-membered ring including nitrogen and carbon,
ring CY₂ may be a 6-membered ring including nitrogen, carbon, and boron, and
ring A₁ to ring A₃ may each independently be a C₅-C₆₀ carbocyclic group or a C₃-C₆₀ heterocyclic group. Ring A₁ and ring A₃ are each the same as described herein. For example, ring A₁ and ring A₃ may each independently be a benzene group, a pyridine group, a pyrimidine group, a pyrazine group, or a pyridazine group.

In one or more embodiments, in Formulae 1(1) and 1(1)-a, a boron-containing heterocyclic group may be additionally condensed with ring CY₂ while sharing boron. The boron-containing heterocyclic group may be, for example, a boron-containing 6-membered ring.

In the specification, the "boron-containing 6-membered ring" may include as ring-forming atoms, for example, i) oxygen, carbon, and boron, ii) sulfur, carbon, and boron, iii) nitrogen, carbon, and boron, iv) carbon and boron, or v) silicon, carbon, and boron.

For example, the condensed ring may include at least one moiety represented by one of Formulae 1(1)-1 to 1(1)-4: 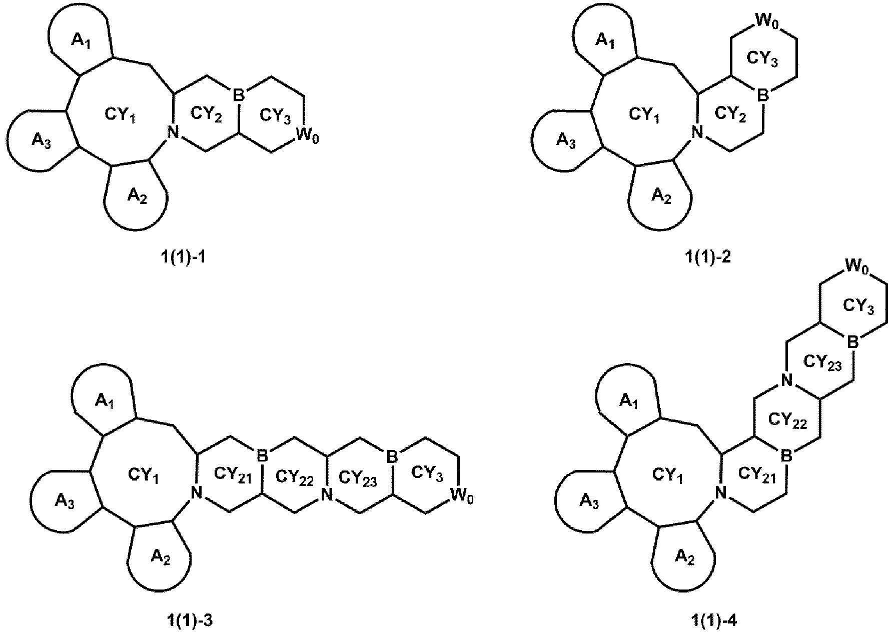 wherein, in Formulae 1(1)-1 to 1(1)-4,
ring CY₁ may be a 9-membered ring including nitrogen and carbon,
ring CY₂ and ring CY₂₁ to ring CY₂₃ may each be a 6-membered ring including nitrogen, carbon, and boron,
ring CY₃ may be a 6-membered ring including W₀, carbon, and boron (for example, a boron-containing 6-membered ring),
W₀ may include O, S, N, C, or Si, and
ring A₁ to ring A₃ may each independently be a C₅-C₆₀ carbocyclic group or a C₃-C₆₀ heterocyclic group. ring A₁ to ring A₃ are each the same as described herein.

In an embodiment, in Formulae 1(1), 1(1)-a, and 1(1)-1 to 1(1)-4, at least one cyclic group selected from a C₅-C₆₀ carbocyclic group and a C₃-C₆₀ heterocyclic group may be additionally condensed with each of ring CY₂, ring CY₂₁ to CY₂₃, and/or ring CY₃.

For example, in Formulae 1(1), 1(1)-a, and 1(1)-1 to 1(1)-4, at least one of a boron-containing 6-membered ring, an aromatic 6-membered ring (for example, a benzene group, a pyridine group, a pyrimidine group, a pyrazine group, a pyridazine group, etc.), a dibenzofuran group, a dibenzothiophene group, a carbazole group, a fluorene group, and a dibenzosilole group may be additionally condensed with each of ring CY₂, ring CY₂₁ to CY₂₃, and/or ring CY₃.

For example, the condensed ring of Compound 1 includes a moiety represented by Formula 1(1)-2, the condensed ring of Compound 25 includes a moiety represented by Formula 1(1)-1, the condensed ring of Compound 90 includes a moiety represented by Formula 1(1)-4, and the condensed ring of Compound 92 includes a moiety represented by Formula 1(1)-3.

In an embodiment, the number of the moiety presented by Formula 1(1) in the condensed polycyclic compound may be 1, 2, 3, or 4. For example, the number of the moiety presented by Formula 1(1) in Compound 1 is 2, and the number of the moiety presented by Formula 1(1) in Compound 14 is 1.

In one or more embodiments, the number of 9-membered rings in the condensed polycyclic compound (for example, ring CY₁ in Formulae 1(1), 1(1)-1, and 1(1)-2) may be 1, 2, 3, or 4. For example, the number of 9-membered rings in Compound 1 is 2, and the number of 9-membered rings in Compound 14 is 1.

In one or more embodiments, the number of boron-containing 6-membered rings in the condensed polycyclic compound may be 1 to 10. For example, the number of boron-containing 6-membered rings in Compound 1 is 2, and the number of boron-containing 6-membered ring in Compound 73 is 4.

In one or more embodiments, the number of boron atoms included as ring-forming atoms in the condensed polycyclic compound may be 1 to 10. For example, the number of boron atoms included as ring-forming atoms in Compound 1 may be 1, and the number of boron atoms included as ring-forming atoms in Compound 73 may be 2.

The condensed polycyclic compound may be a delayed fluorescence material. That is, the condensed polycyclic compound may emit delayed fluorescence.

The condensed ring may be unsubstituted. Or, the condensed ring may be substituted with at least one substituent. The substituent is the same as described herein in connection with R₁ to R₃, Z₁ to Z₃, Z₂₁ to Z₂₃, T₁₁, T₁₂, T₂₁, T₂₂, T₃₁, T₃₂, etc.

For example, the condensed polycyclic compound may be a multiple resonance thermally activated delayed fluorescence material.

In an embodiment, the condensed polycyclic compound may be represented by Formula 1, 2, or 3: 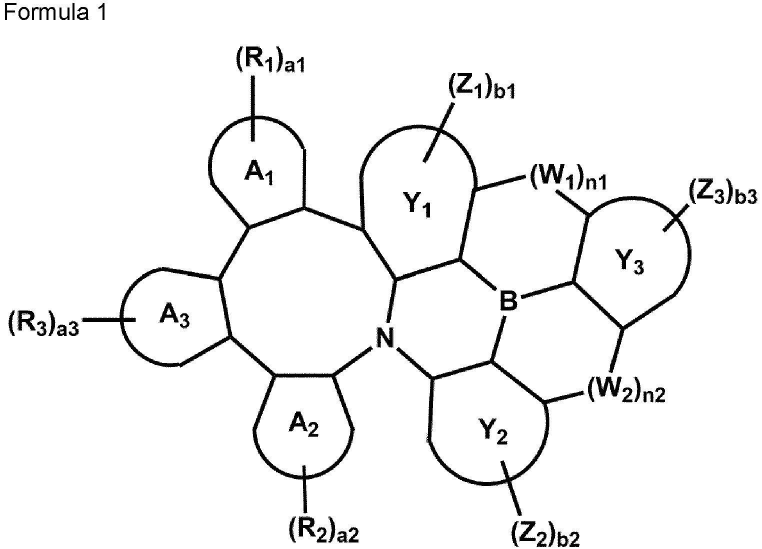 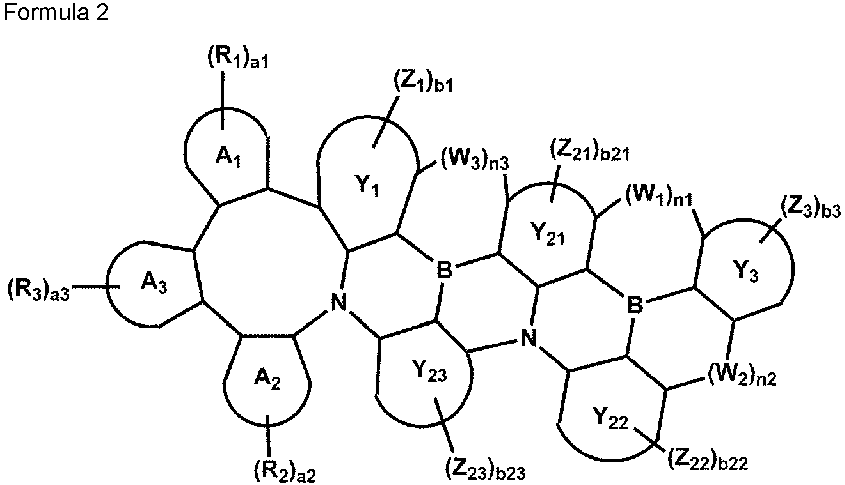 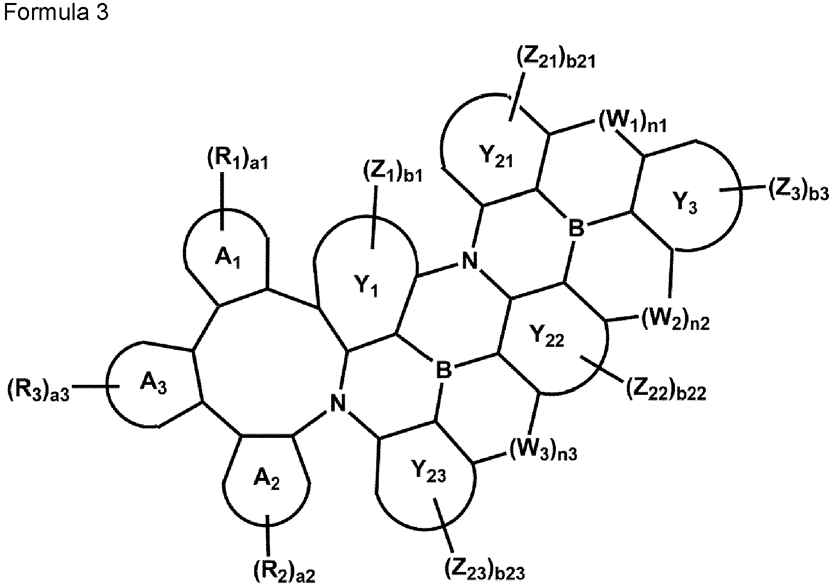 wherein, in Formulae 1, 2, and 3,
ring A₁ to ring A₃, ring Y₁ to ring Y₃, and ring Y₂₁ to ring Y₂₃ may each independently be a C₅-C₆₀ carbocyclic group or a C₃-C₆₀ heterocyclic group,
W₁ may be a single bond, O, S, N(T₁₁), C(T₁₁)(T₁₂), or Si(T₁₁)(T₁₂),
W₂ may be a single bond, O, S, N(T₂₁), C(T₂₁)(T₂₂), or Si(T₂₁)(T₂₂),
W₃ may be a single bond, O, S, N(T₃₁), C(T₃₁)(T₃₂), or Si(T₃₁)(T₃₂),
n1, n2, and n3 may each independently be 0 or 1,
when n1 is 0, *-(W₁)ₙ₁-*' may not be present,
when n2 is 0, *-(W₂)ₙ₂-*' may not be present,
when n3 is 0, *-(W₃)ₙ₃-*' may not be present,
the sum of n1 and n2 in Formula 1 may be 1 or more and the sum of n1, n2 and n3 in Formulae 2 and 3 may be 1 or more,
R₁ to R₃, Z₁ to Z₃, and Z₂₁ to Z₂₃ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
a1 to a3, b1 to b3, and b21 to b23 may each independently be an integer from 0 to 10,
T₁₁, T₁₂, T₂₁, T₂₂, T₃₁, and T₃₂ may each i) be the same as defined in connection with Z₁, or ii) be linked to a neighboring substituent to form a condensed ring with a neighboring ring,
two or more of R₁, R₂, R₃, Z₁, Z₂, Z₃, Z₂₁, Z₂₂, Z₂₃, T₁₁, T₁₂, T₂₁, T₂₂, T₃₁, and T₃₂ may optionally be linked to each other to form a substituted or unsubstituted C₅-C₃₀ carbocyclic group or a substituted or unsubstituted C₁-C₃₀ heterocyclic group,
a substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be:
   deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
   a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), - P(Q₂₈)(Q₂₉), or any combination thereof;
   -N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
   any combination thereof, and
   Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; an amino group; an amidino group; a hydrazine group; a hydrazone group; a carboxylic acid group or a salt thereof; a sulfonic acid group or a salt thereof; a phosphoric acid group or a salt thereof; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, a C₁-C₆₀ alkyl group, a C₆-C₆₀ aryl group, or any combination thereof.

In an embodiment, ring A₁ to ring A₃, ring Y₁ to Y₃, and ring Y₂₁ to ring Y₂₃ in Formulae 1 to 3 may each independently be a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, or an azadibenzosilole group.

In one or more embodiments, ring A₁ to ring A₃, ring Y₁ to ring Y₃, and ring Y₂₁ to ring Y₂₃ in Formulae 1 to 3 may each independently be a benzene group, a dibenzofuran group, a dibenzothiophene group, a carbazole group, a fluorene group, or a dibenzosilole group.

One or more embodiments provide a condensed polycyclic compound represented by Formula 1, wherein n1 may be 1, W₁ may be N(T₁₁), and Condition 1A or 1B may be satisfied:
Condition 1A
one of Z₁ in the number of b1 and T₁₁ are linked to each other to form a condensed ring with a neighboring ring; and
Condition 1B
one of Z₃ in the number of b3 and T₁₁ are linked to each other to form a condensed ring with a neighboring ring.

For example, Compound 1 may be a condensed polycyclic compound represented by Formula 1, wherein, in Formula 1, n1 may be 1, W₁ may be N(T₁₁), and Condition 1A may be satisfied. In Condition 1A, i) one of Z₁ in the number of b1 may be a phenyl group, and T₁₁ may be a biphenyl group, or ii) one of Z₁ in the number of b1 may be a biphenyl group, and T₁₁ may be a phenyl group.

One or more embodiments provide a condensed polycyclic compound represented by Formula 2 or 3, wherein n1 may be 1, W₁ may be N(T₁₁), and Condition 2A or 2B may be satisfied:
Condition 2A
one of Z₂₁ in the number of b21 and T₁₁ are linked to each other to form a condensed ring with a neighboring ring; and
Condition 2B
one of Z₃ in the number of b3 and T₁₁ are linked to each other to form a condensed ring with a neighboring ring.

One or more embodiments provide a condensed polycyclic compound represented by Formula 1, wherein n2 may be 1, W₂ may be N(T₂₁), and Condition 1C or 1D may be satisfied:
Condition 1C
one of Z₂ in the number of b2 and T₂₁ are linked to each other to form a condensed ring with a neighboring ring; and
Condition 1D
one of Z₃ in the number of b3 and T₂₁ are linked to each other to form a condensed ring with a neighboring ring.

For example, Compound 7 may be a condensed polycyclic compound represented by Formula 1, wherein, in Formula 1, n2 may be 1, W₂ may be N(T₂₁), and Condition 1D may be satisfied. In Condition 1D, i) one of Z₃ in the number of b3 may be a phenyl group, and T₂₁ may be a biphenyl group, or ii) one of Z₃ in the number of b3 may be a biphenyl group, and T₂₁ may be a phenyl group.

One or more embodiments provide a condensed polycyclic compound represented by Formula 2 or 3, wherein n2 may be 1, W₂ may be N(T₂₁), and Condition 2C or 2D may be satisfied:
Condition 2C
one of Z₂₂ in the number of b22 and T₂₁ are linked to each other to form a condensed ring with a neighboring ring; and
Condition 2D
one of Z₃ in the number of b3 and T₂₁ are linked to each other to form a condensed ring with a neighboring ring.

According to another embodiment, the condensed polycyclic compound represented by Formula 1 may satisfy at least one of Conditions 1E, 1F, and 1G:
Condition 1E
ring Y₁ is a C₃-C₆₀ heteropolycyclic group including at least one boron as a ring-forming atom,
wherein the C₃-C₆₀ heteropolycyclic group is a heteropolycyclic group comprising
   i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
   ii) at least one boron-containing 6-membered ring,
wherein i) and ii) are condensed with each other;
Condition 1F
ring Y₂ is a C₃-C₆₀ heteropolycyclic group including at least one boron as a ring-forming atom,
wherein the C₃-C₆₀ heteropolycyclic group is a heteropolycyclic group comprising
   i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
   ii) at least one boron-containing 6-membered ring,
wherein i) and ii) are condensed with each other; and
Condition 1G
ring Y₃ is a C₃-C₆₀ heteropolycyclic group including at least one boron as a ring-forming atom,
wherein the C₃-C₆₀ heteropolycyclic group is a heteropolycyclic group comprising
   i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
   ii) at least one boron-containing 6-membered ring,
wherein i) and ii) are condensed with each other.

In one or more embodiments, the condensed polycyclic compound represented by Formula 2 or 3 may satisfy at least one of Conditions 2E, 2F, 2G, 2H, and 2I:
Condition 2E
ring Y₁ is a C₃-C₆₀ heteropolycyclic group including at least one boron as a ring-forming atom,
wherein the C₃-C₆₀ heteropolycyclic group is a heteropolycyclic group comprising
   i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
   ii) at least one boron-containing 6-membered ring,
wherein i) and ii) are condensed with each other;
Condition 2F
ring Y₂₁ is a C₃-C₆₀ heteropolycyclic group including at least one boron as a ring-forming atom,
wherein the C₃-C₆₀ heteropolycyclic group is a heteropolycyclic group comprising
   i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
   ii) at least one boron-containing 6-membered ring,
whrein i) and ii) are condensed with each other;
Condition 2G
ring Y₂₂ is a C₃-C₆₀ heteropolycyclic group including at least one boron as a ring-forming atom,
wherein the C₃-C₆₀ heteropolycyclic group is a heteropolycyclic group comprising
   i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
   ii) at least one boron-containing 6-membered ring,
wherein i) and ii) are condensed with each other;
Condition 2H
ring Y₂₃ is a C₃-C₆₀ heteropolycyclic group including at least one boron as a ring-forming atom,
wherein the C₃-C₆₀ heteropolycyclic group is a heteropolycyclic group comprising
   i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
   ii) at least one boron-containing 6-membered ring,
wherein i) and ii) are condensed with each other; and
Condition 2I
ring Y₃ is a C₃-C₆₀ heteropolycyclic group including at least one boron as a ring-forming atom,
wherein the C₃-C₆₀ heteropolycyclic group is a heteropolycyclic group comprising
   i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
   ii) at least one boron-containing 6-membered ring,
wherein i) and ii) are condensed with each other.

In one or more embodiments, in Formulae 1 to 3,
i) n1 may be 0, and n2 may be 1,
ii) n1 may be 1, and n2 may be 0, or
iii) n1 and n2 may each be 1.

In one or more embodiments, in Formulae 1 to 3, R₁ to R₃, Z₁ to Z₃, Z₂₁ to Z₂₃, T₁₁, T₁₂, T₂₁, T₂₂, T₃₁, and T₃₂ may each independently be:
hydrogen or deuterium;
a C₁-C₂₀ alkyl group, a phenyl group, a biphenyl group, or a carbazolyl group, each unsubstituted or substituted with deuterium, a C₁-C₂₀ alkyl group, a phenyl group, a biphenyl group, a carbazolyl group, or any combination thereof; or
-N(Q₁)(Q₂), and
Q₁ and Q₂ may each independently be a phenyl group, a biphenyl group, or a carbazolyl group, each unsubstituted or substituted with deuterium, a C₁-C₂₀ alkyl group, a phenyl group, a biphenyl group, a carbazolyl group, or any combination thereof.

In one or more embodiments, in Formulae 1 to 3, R₁ to R₃, Z₁ to Z₃, Z₂₁ to Z₂₃, T₁₁, T₁₂, T₂₁, T₂₂, T₃₁, and T₃₂ may each independently include:
hydrogen or deuterium;
a C₁-C₂₀ alkyl group, a phenyl group, a biphenyl group, or a carbazolyl group, each unsubstituted or substituted with deuterium, a C₁-C₂₀ alkyl group, a phenyl group, a biphenyl group, a carbazolyl group, or any combination thereof; or
-N(Q₁)(Q₂).
Q₁ and Q₂ are each the same as described herein.

In one or more embodiments, in Formulae 1 to 3, R₁ to R₃, Z₁ to Z₃, Z₂₁ to Z₂₃, T₁₁, T₁₂, T₂₁, T₂₂, T₃₁, and T₃₂ may each independently be:
hydrogen, deuterium, a C₁-C₁₀ alkyl group (for example, a tert-butyl group, etc.), or a deuterated C₁-C₁₀ alkyl group;
a phenyl group, a biphenyl group, or an N-carbazolyl group, each unsubstituted or substituted with deuterium, a C₁-C₁₀ alkyl group (for example, a tert-butyl group, etc.), a deuterated C₁-C₁₀ alkyl group, a phenyl group, a deuterated phenyl group, a (C₁-C₁₀ alkyl)phenyl group, a deuterated (C₁-C₁₀ alkyl)phenyl group, an N-carbazolyl group, a deuterated N-carbazolyl group, a (C₁-C₁₀ alkyl) N-carbazolyl group, a deuterated (C₁-C₁₀ alkyl) N-carbazolyl group, or any combination thereof; or
-N(Q₁)(Q₂).

In one or more embodiments, Formulae 1 to 3 may each include deuterium, a tert-butyl group, a phenyl group, a phenyl group substituted with a tert-butyl group, a biphenyl group, a biphenyl group substituted with a tert-butyl group, an N-carbazolyl group, an N-carbazolyl group substituted with a tert-butyl group, a phenyl group substituted with an N-carbazolyl group, a diphenylamino group, a di(phenyl substituted with a tert-butyl group)amino group, or any combination thereof.

In one or more embodiments, the condensed polycyclic compound may include deuterium, a tert-butyl group, a phenyl group, a phenyl group substituted with a tert-butyl group, a biphenyl group, an N-carbazolyl group, an N-carbazolyl group substituted with a tert-butyl group, a diphenylamino group, a di(phenyl substituted with a tert-butyl group)amino group, or any combination thereof.

In one or more embodiments, the condensed polycyclic compound may include at least one deuterium.
In one or more embodiments, the condensed ring may include a moiety represented by one of Formulae 1A-1 to 1A-3, 1B-1 to 1B-2, 1C-1 to 1C-5, 1D-1 to 1D-5, and 1E-1 to 1E-5, or a moiety represented by 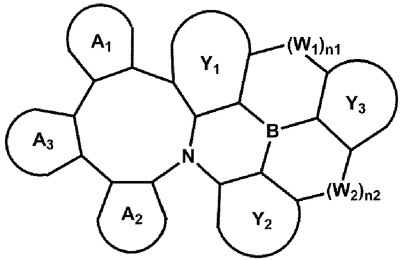 in Formula 1 may be represented by one of Formulae 1A-1 to 1A-3, 1B-1 to 1B-2, 1C-1 to 1C-5, 1D-1 to 1D-5, and 1E-1 to 1E-5: 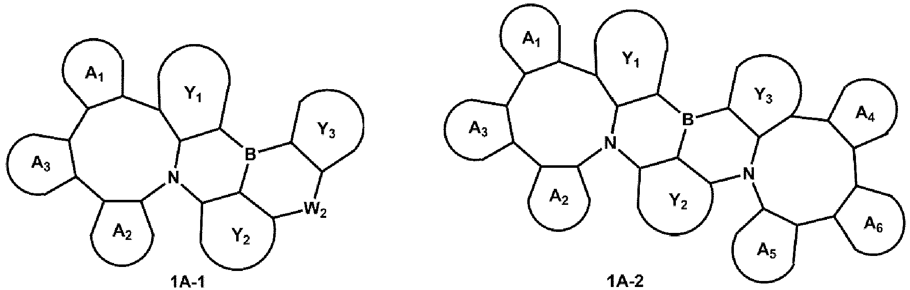 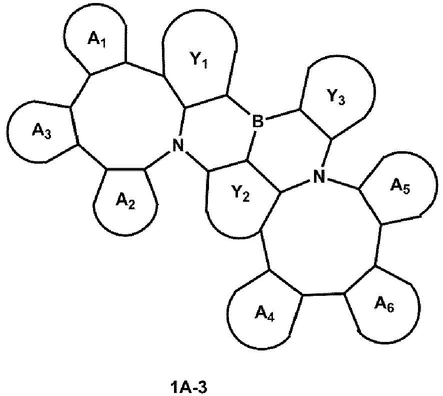 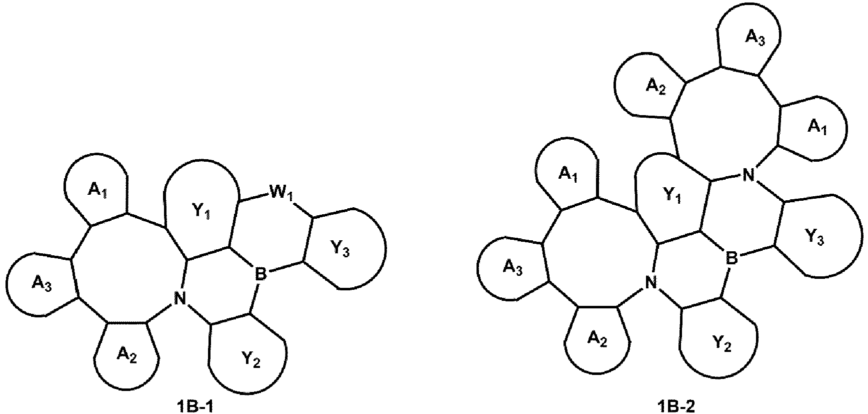 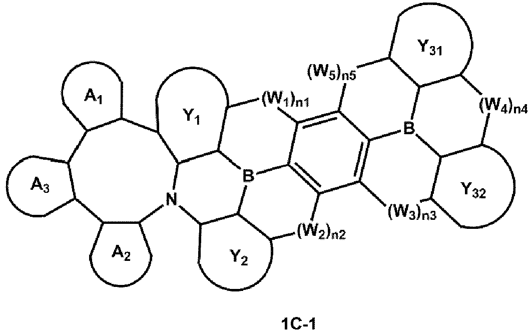 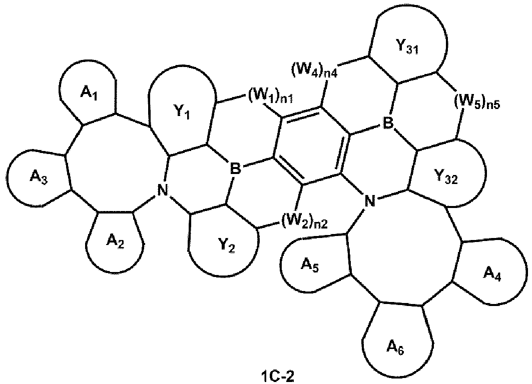 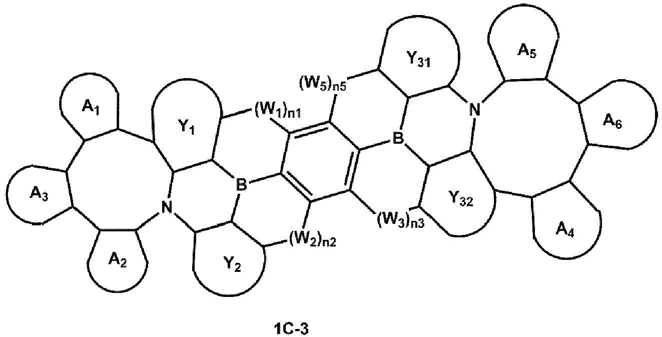 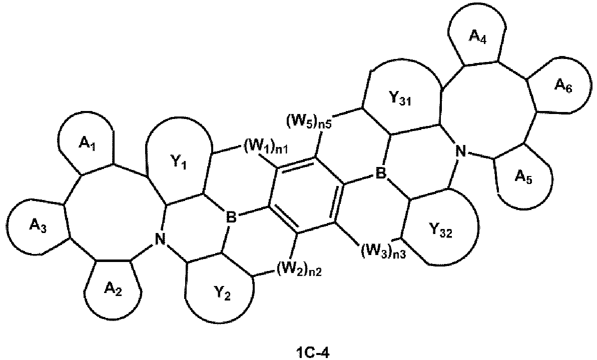 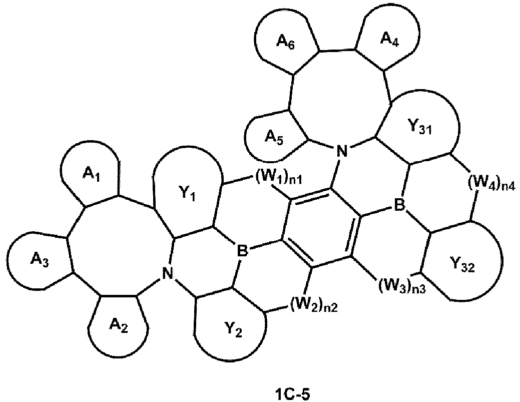 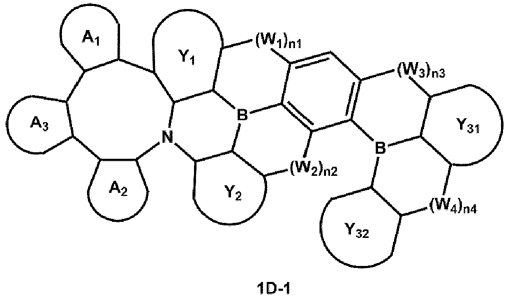 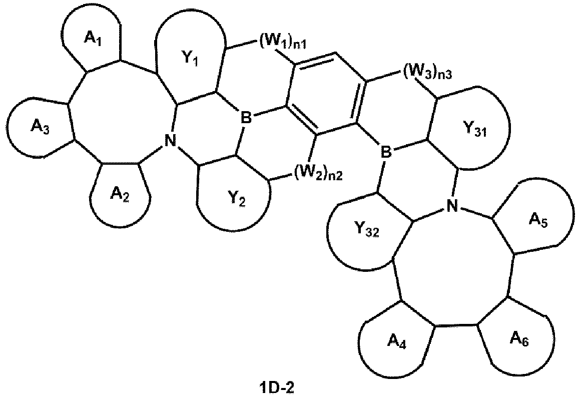 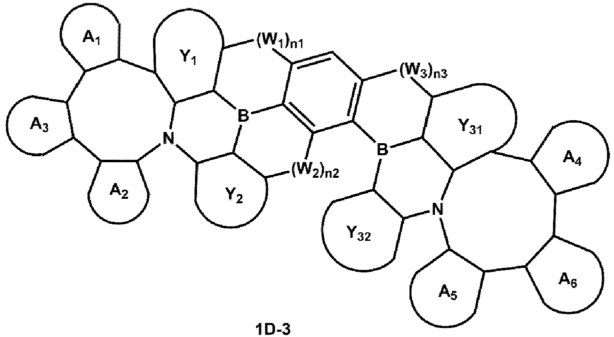 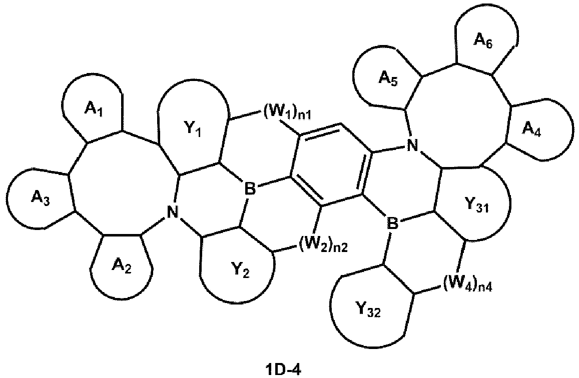 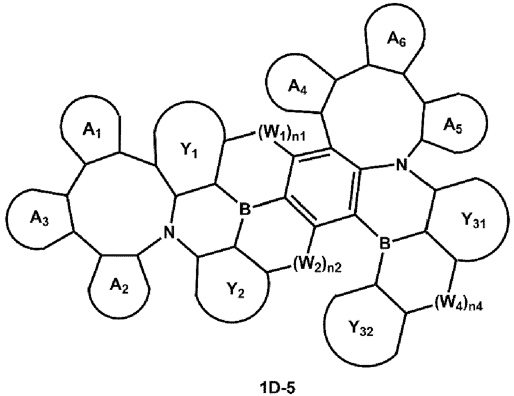 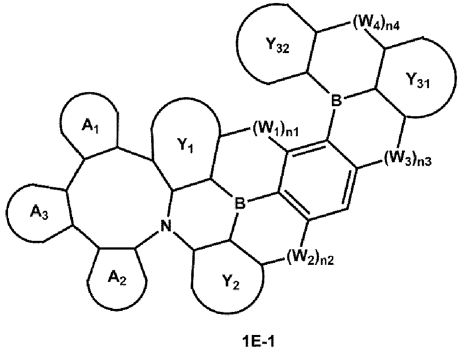 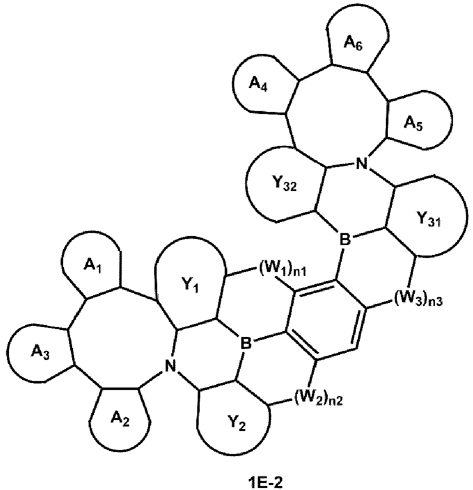 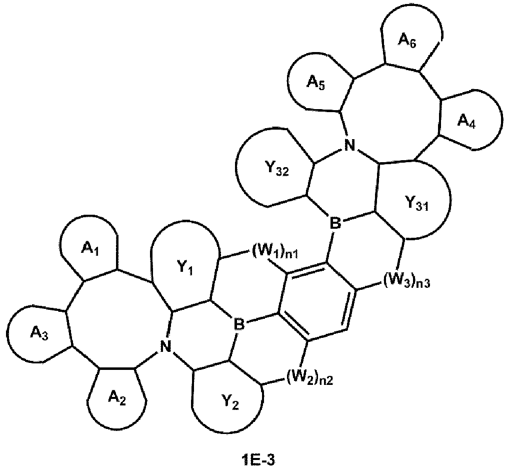 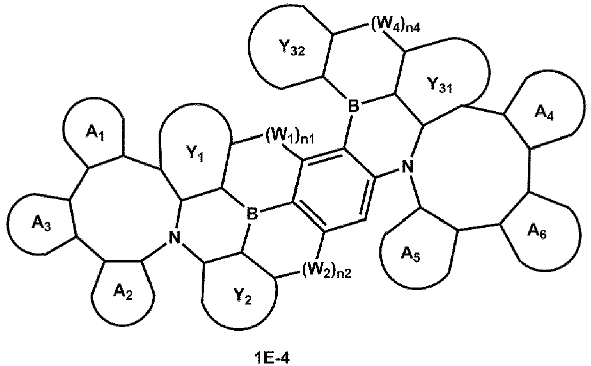 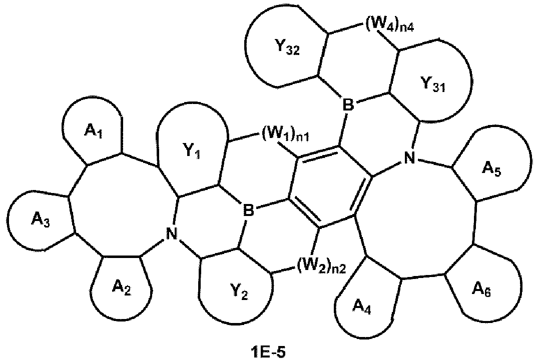
wherein, in Formulae 1A-1 to 1A-3, 1B-1 to 1B-2, 1C-1 to 1C-5, 1D-1 to 1D-5, and 1E-1 to 1E-5,
ring A₁ to ring A₃, ring Y₁ to ring Y₃, W₁, W₂, n1, and n2 are each the same as defined herein,
ring A₄ to ring A₆ are each the same as defined herein in connection with ring A₁,
ring Y₃₁ and ring Y₃₂ are each the same as defined herein in connection with ring Y₃ (for example, ring Y₃₁ and ring Y₃₂ may each be independently a C₅-C₃₀ carbocyclic group or a C₃-C₃₀ heterocyclic group (for example, a C₅-C₁₀ carbocyclic group or a C₃-C₁₀ heterocyclic group)),
W₃ may be a single bond, O, S, N(T₃₁), C(T₃₁)(T₃₂), or Si(T₃₁)(T₃₂),
W₄ may be a single bond, O, S, N(T₄₁), C(T₄₁)(T₄₂), or Si(T₄₁)(T₄₂),
W₅ may be a single bond, O, S, N(T₅₁), C(T₅₁)(T₅₂), or Si(T₅₁)(T₅₂),
T₃₁, T₃₂, T₄₁, T₄₂, T₅₁, and T₅₂ may each i) be the same as defined in connection with Z₁, or ii) be linked to a neighboring substituent to form a condensed ring with a neighboring ring,
n3 to n5 may each independently be 0 or 1,
when n3 is 0, *-(W₃)ₙ₃-*' may not be present,
when n4 is 0, *-(W₄)ₙ₄-*' may not be present,
when n5 is 0, *-(W₅)ₙ₅-*' may not be present,
in Formula 1C-1, the sum of n3, n4, and n5 may be 1 or more,
in Formula 1C-2, the sum of n4 and n5 may be 1 or more,
in Formulae 1C-3 and 1C-4, the sum of n3 and n5 may be 1 or more,
in Formulae 1C-5, 1D-1, and 1E-1, the sum of n3 and n4 may be 1 or more,
in Formulae 1D-2, 1D-3, 1E-2, and 1E-3, n3 may be 1, and
in Formulae 1D-4, 1D-5, 1E-4, and 1E-5, n4 may be 1.

In Formulae 1A-1 to 1A-3, 1B-1 to 1B-2, 1C-1 to 1C-5, 1D-1 to 1D-5, and 1E-1 to 1E-5, each ring (including ring A₁ to ring A₆, ring Y₁ to ring Y₃, ring Y₃₁ and ring Y₃₂) may be independently a benzene ring. In this case, for example, there may be a substituent at the para-position or meta-position of the benzene ring. The para-position and the meta-position are determined relative to the carbon linked to B atom in an adjacent ring in the benzene ring. For example, in Compound 1, a deuterated carbazolyl group is present at the para-position of the benzene ring. For example, in Formula 1A-1, a substituent may be present at the para-position or meta-position (e.g., para-position) of ring Y₁, and/or a substituent may be present at the para-position or meta-position (e.g., para-position) of ring Y₃. In Formula 1A-2, a substituent may be present at the meta-position of ring Y₁, and/or a substituent may be present at the meta-position of ring Y₃, and/or a substituent may be present at the meta-position of ring Y₂. In Formula 1A-3, a substituent may be present at the para-position or meta-position of ring Y₁, and/or a substituent may be present at the para-position or meta-position of ring Y₃. In Formula 1B-2, a substituent may be present at the para-position or meta-position of ring Y₂, and/or a substituent may be present at the para-position or meta-position of ring Y₃.

In one or more embodiments, the condensed polycyclic compound represented by Formula 1 may have an asymmetric structure with respect to the bond connecting ring Y₂ or ring Y₁ and B in Formula 1.

In one or more embodiments, the condensed polycyclic compound represented by Formula 1 may have a symmetric structure with respect to the bond connecting ring Y₂ or ring Y₁ and B in Formula 1.

In the specification, "N-carbazolyl group" refers to a monovalent group of which hydrogen is separated from N of a carbazole group and may be bonded to other groups, and is represented by 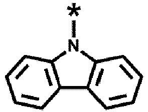 (wherein * indicates a binding site to a neighboring atom).

In various backbones such as Formulae 1A-1 to 1A-3, 1B-1 to 1B-2, 1C-1 to 1C-5, 1D-1 to 1D-5, and 1E-1 to 1E-5 may be unsubstituted or substituted with R₁ to R₃ and Z₁ to Z₃ as described herein according to definition of Formula 1.

In one or more embodiments, the condensed polycyclic compound may be one of Compounds 1 to 94:

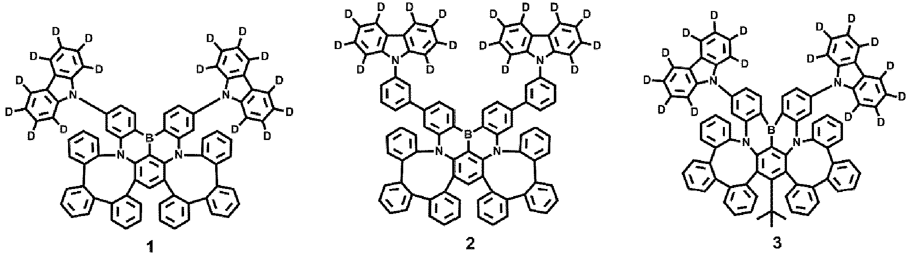

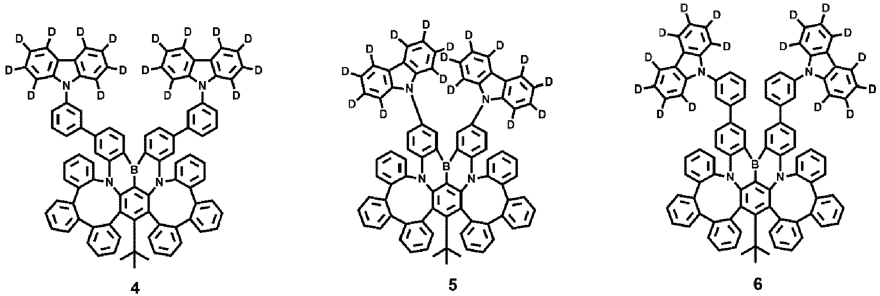

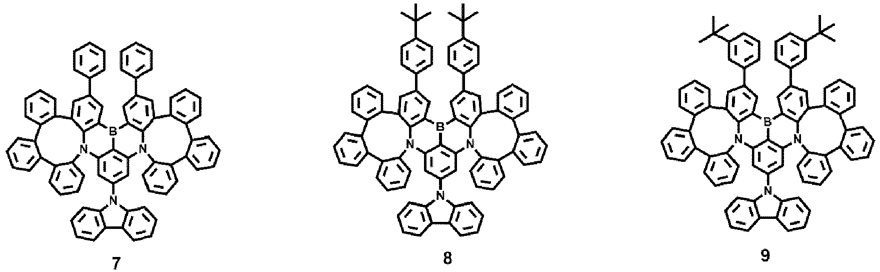

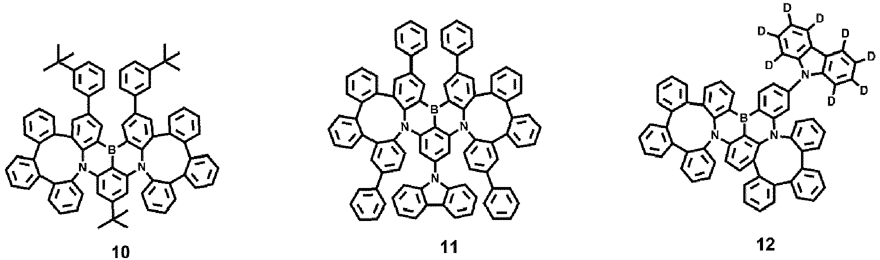

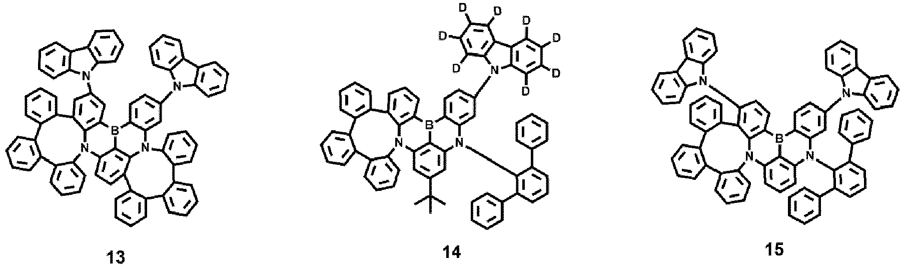

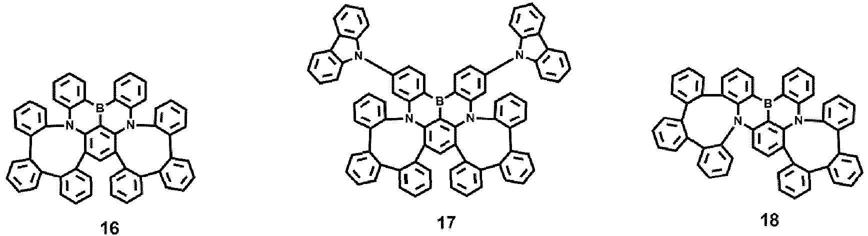

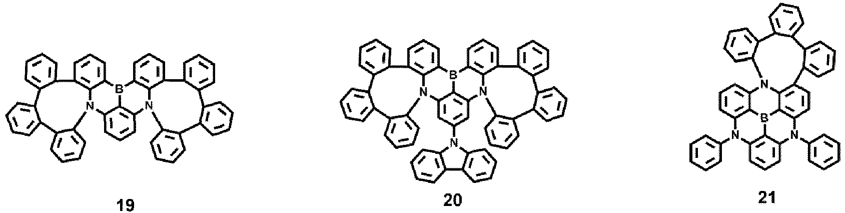

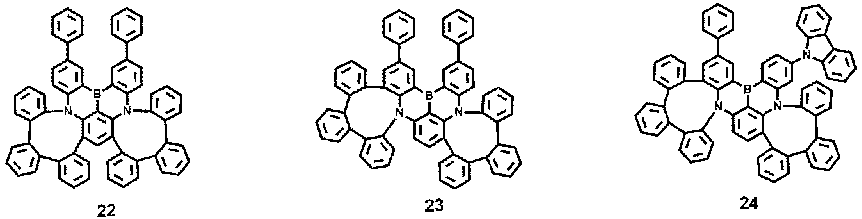

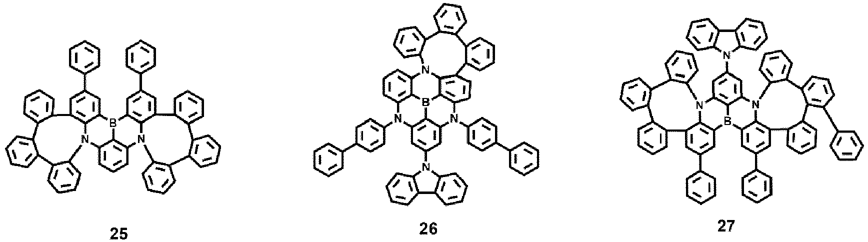

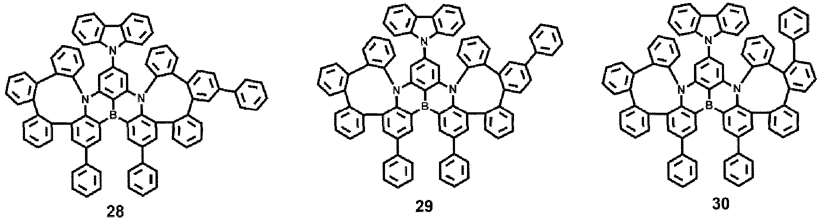

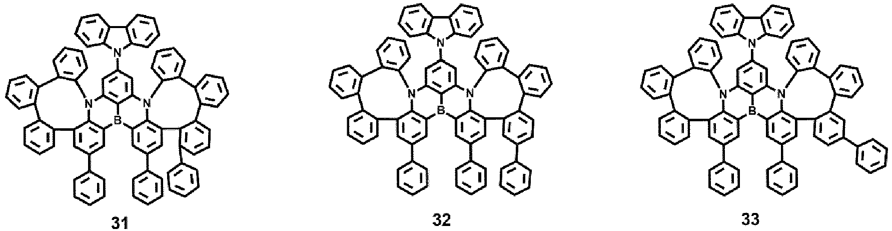

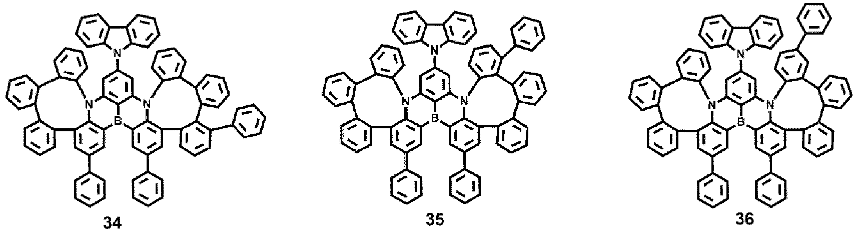

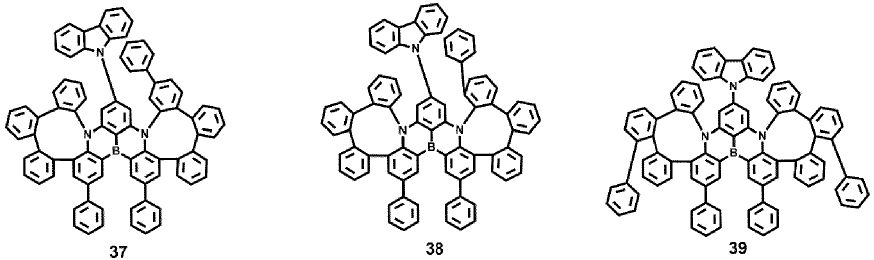

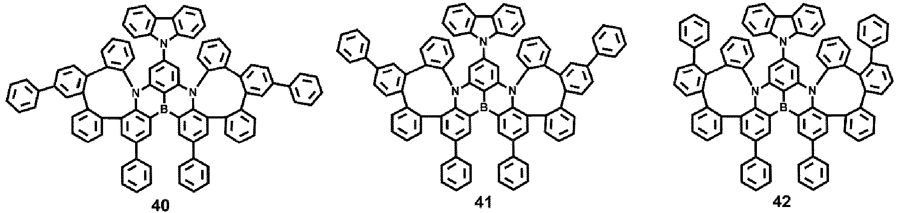

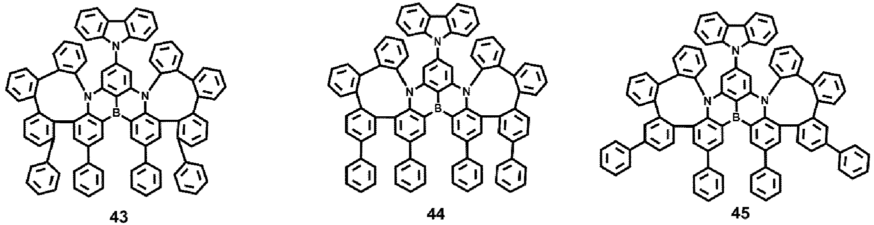

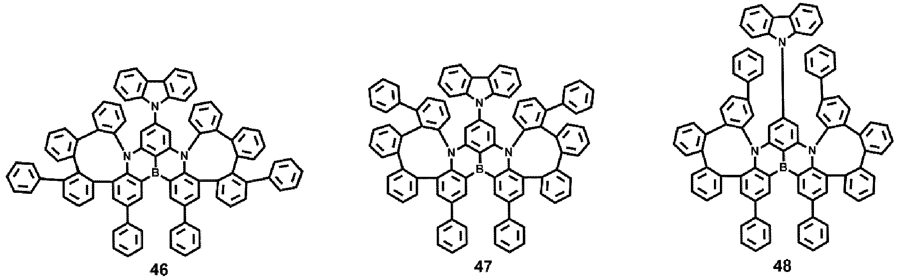

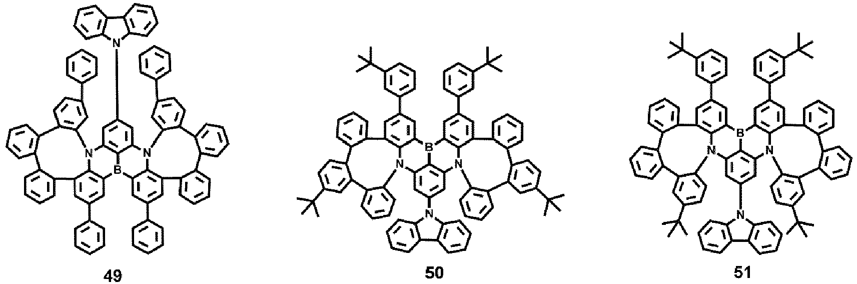

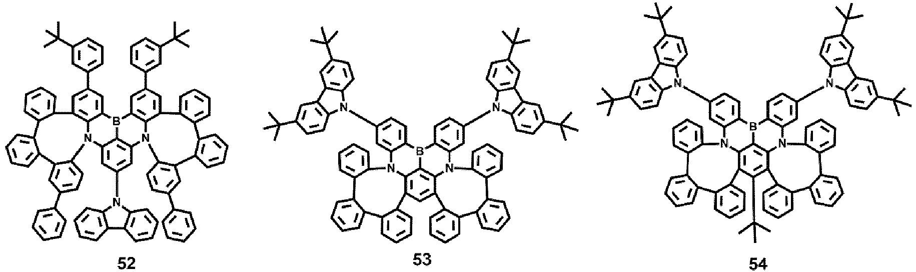

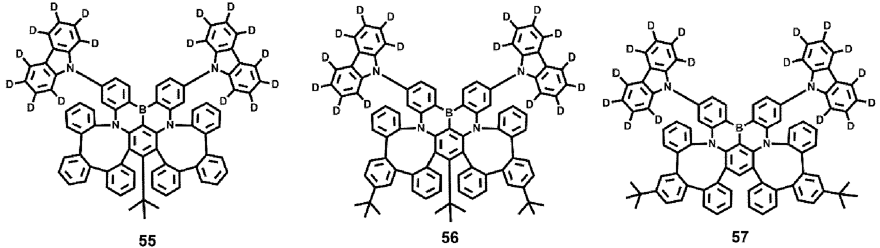

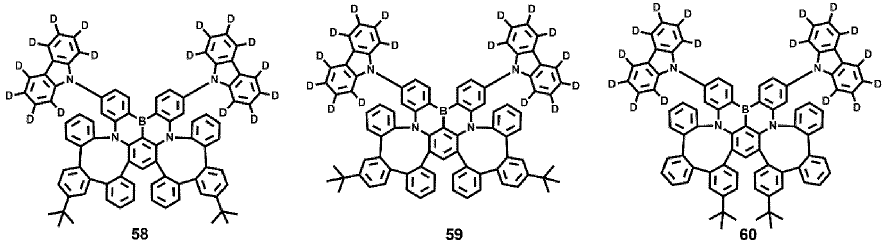

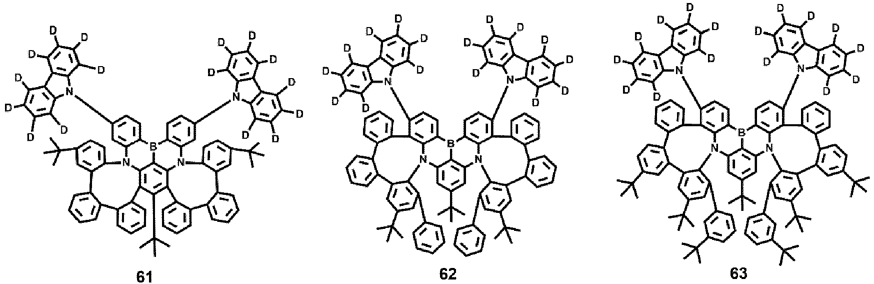

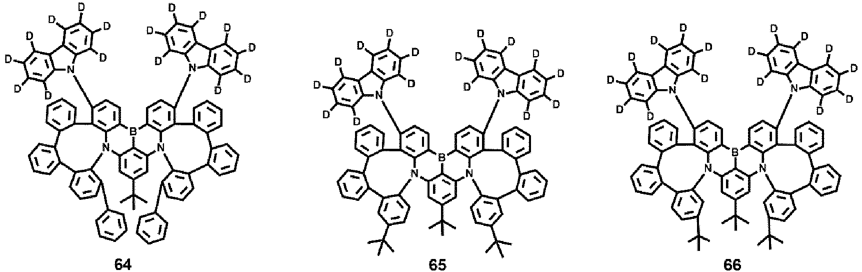

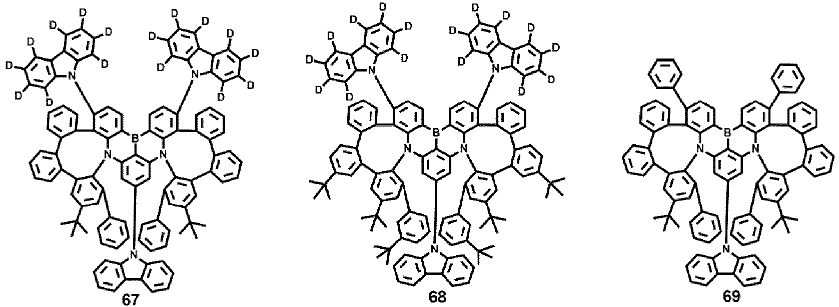

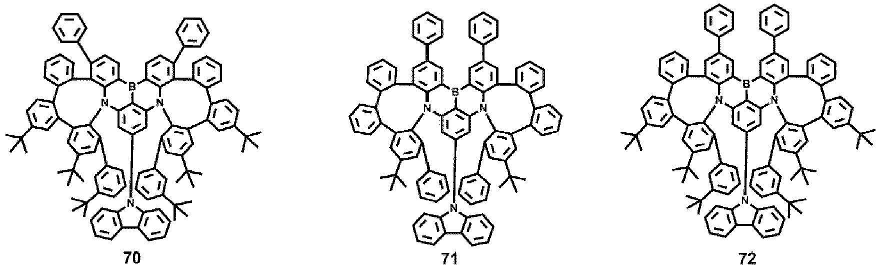

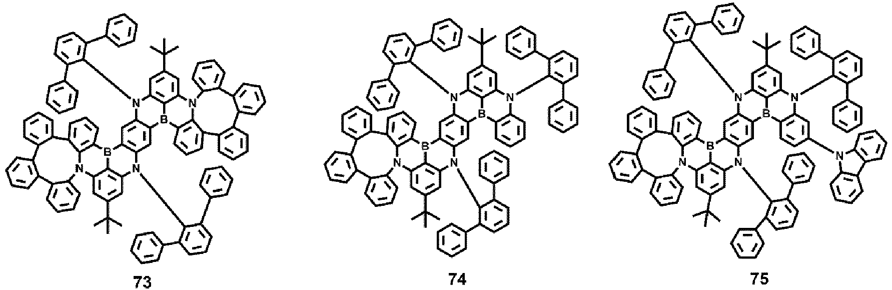

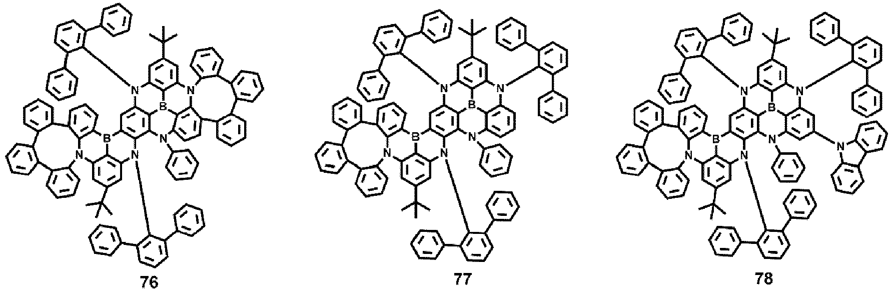

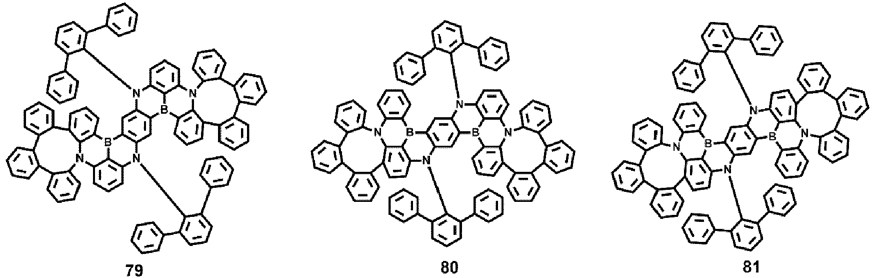

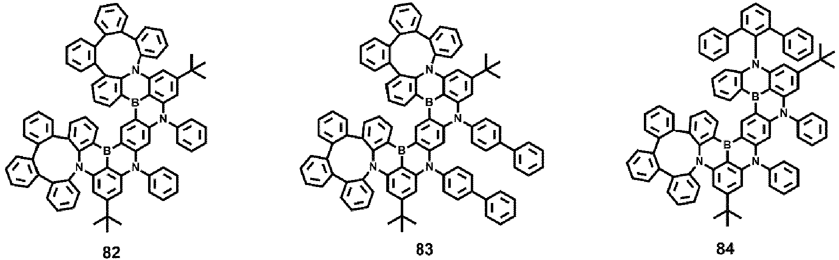

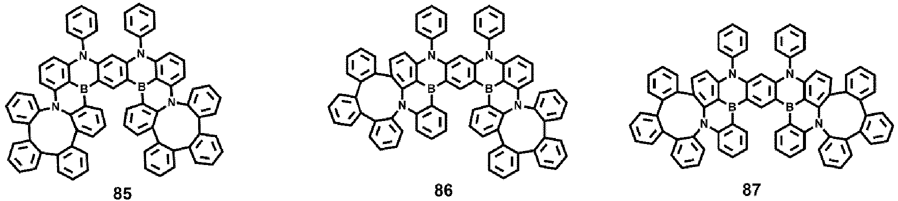

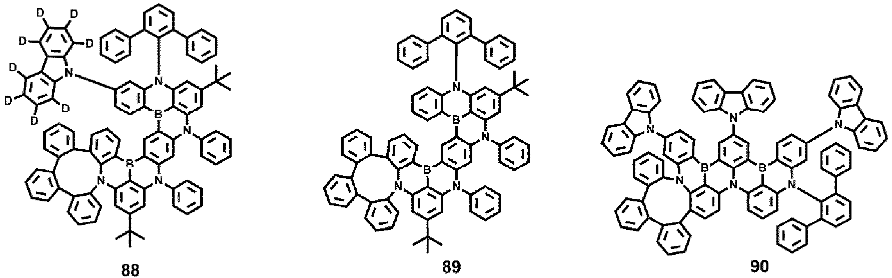

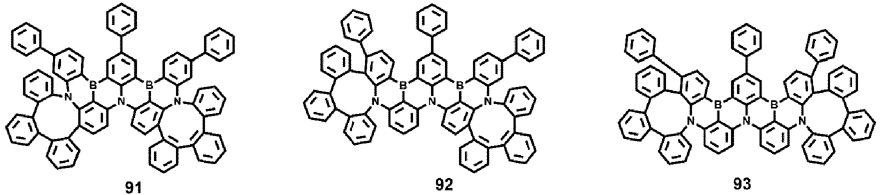

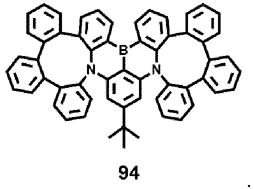

The condensed polycyclic compound does not include a metal. Thus, the condensed polycyclic compound may be clearly differentiated from other various organometallic compounds including a center metal such as platinum, palladium, gold, etc. and an organic ligand bonded thereto.

In addition, the condensed polycyclic compound includes a condensed ring described above, and the condensed ring includes a 9-membered ring including nitrogen and carbon as ring-forming atoms and a 6-membered ring including nitrogen, carbon, and boron as ring-forming atoms, wherein the 9-membered ring and the 6-membered ring are condensed with each other while sharing nitrogen and carbon. Due to the 9-membered ring condensed with the 6-membered ring, as the condensed polycyclic compound has excellent thermal and electric stability according to the shielding effect to the born atom included in the 6-membered ring, exhibits relatively less steric hindrance effect, and emits blue light having a relatively small full width at half maximum (FWHM) and shifted to a short wavelength, an electronic device employing the condensed polycyclic compound, for example, a light-emitting device employing the condensed polycyclic compound may have an improved driving voltage, higher external quantum efficiency, increased luminescence efficiency, and/or longer lifespan characteristics.

In an embodiment, the FWHM in the emission spectrum of the condensed polycyclic compound may be about 5 nm to about 30 nm, for example, about 10 nm to about 25 nm.

In one or more embodiments, the emission peak wavelength in the emission spectrum of the condensed polycyclic compound may be about 400 nm to about 500 nm, for example, 440 nm to 470 nm.

In one or more embodiments, the singlet (S₁) energy level of the condensed polycyclic compound may be about 2.4 eV to about 3.1 eV.

In one or more embodiments, the absolute value of the difference between the singlet (S₁) energy level and the triplet (T₁) energy level of the condensed polycyclic compound may be about 0 eV to about 1 eV (or, greater than about 0 eV and less than or equal to about 1 eV).

In one or more embodiments, the highest occupied molecular orbital (HOMO) energy level of the condensed polycyclic compound may be about 4.0 eV to about 6.5 eV.

Synthesis methods of the condensed polycyclic compound may be recognized by one of ordinary skill in the art by referring to the Synthesis Examples provided below.

### Light-emitting device

The condensed polycyclic compound may be used as a material of an interlayer of a light-emitting device, for example, an emission layer of the interlayer, and according to another aspect of the disclosure, provided is a light-emitting device including: a first electrode; a second electrode; and an interlayer arranged between the first electrode and the second electrode and including an emission layer, wherein the interlayer may include at least one condensed polycyclic compound described above.

As the light-emitting device includes interlayer including at least one condensed polycyclic compound described above, the light-emitting device may emit blue light having a relatively small FWHM and shifted to a short wavelength, and have an improved driving voltage, higher external quantum efficiency, increased luminescence efficiency, and/or longer lifespan characteristics.

The condensed polycyclic compound may be used between a pair of electrodes of the light-emitting device. For example, the condensed polycyclic compound may be included in the emission layer. In this case, the emission layer may further include a host. The amount (weight) of the host may be greater than the amount (weight) of the condensed polycyclic compound. The emission layer may emit red light, green light, or blue light. For example, the emission layer may emit blue light.

In an embodiment, the CIEy value of light emitted from the emission layer may be about 0.040 to about 0.170, about 0.050 to about 0.170, about 0.060 to about 0.170, about 0.040 to about 0.165, about 0.050 to about 0.165, or about 0.060 to about 0.165.

In one or more embodiments, the emission peak wavelength of light emitted from the emission layer may be about 440 nm to about 470 nm, about 445 nm to about 470 nm, about 450 nm to about 470 nm, about 455 nm to about 470 nm, about 460 nm to about 470 nm, about 440 nm to about 465 nm, about 445 nm to about 465 nm, about 450 nm to about 465 nm, about 455 nm to about 465 nm, or about 460 nm to about 465 nm.

The emission layer may further include a host. The host may be understood by referring to the description of the host provided herein.

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

For example, in the organic light-emitting device, the first electrode may be an anode, the second electrode may be a cathode, and the interlayer may further include a hole transport region between the first electrode and the emission layer and an electron transport region between the emission layer and the second electrode, wherein the hole transport region may include a hole injection layer, a hole transport layer, an electron-blocking layer, an auxiliary layer, or any combination thereof, and the electron transport region may include a buffer layer, a hole-blocking layer, an electron transport layer, an electron injection layer, or any combination thereof.

The term "interlayer" as used herein refers to a single layer and/or a plurality of layers arranged between the first electrode and the second electrode of the organic light-emitting device. The "interlayer" may include not only organic compounds but also organometallic complexes including metals.

For example, the emission layer may have a feature described in the first embodiment or the second embodiment provided below.

### <First embodiment>

The emission layer may include at least one condensed polycyclic compound described above, and the condensed polycyclic compound may function as an emitter, for example, a delayed fluorescence emitter. That is, the condensed polycyclic compound may be an emitter. For example, a ratio of a luminescent component emitted from the condensed polycyclic compound with respect to all luminescent components of the emission layer may be 80 % or more, 85 % or more, 90 % or more, or 95 % or more. Light emitted from the condensed polycyclic compound may be blue light. The emission layer may further include a sensitizer, and the sensitizer may be different from the condensed polycyclic compound. The sensitizer may be an organometallic compound, a delayed fluorescence material, a prompt fluorescence material, or any combination thereof. The amount (weight) of the sensitizer may be about 0.01 parts by weight to about 10 parts by weight based on 100 parts by weight of the emission layer.

### <Second embodiment>

The emission layer may include at least one condensed polycyclic compound described above, and the condensed polycyclic compound may function as a sensitizer or an auxiliary dopant. That is, the condensed polycyclic compound may be a sensitizer or an auxiliary dopant. The sensitizer may facilitate effective transfer of excitons of a host to an emitter. The emission layer may further include an emitter, and the emitter may be different from the condensed polycyclic compound. The emitter may be an organometallic compound, a delayed fluorescence material, a prompt fluorescence material, or any combination thereof.

In the specification, the emitter refers to a material capable of receiving excitons from a host, a sensitizer, and/or an auxiliary dopant and emitting light by the transition of the excitons to the ground state.

In the first and second embodiments, the amount (weight) of the condensed polycyclic compound may be about 0.01 parts by weight to about 40 parts by weight, about 0.1 parts by weight to about 20 parts by weight, or about 1 part by weight to about 20 parts by weight based on 100 parts by weight of the emission layer.

In the first and second embodiments, the organometallic compound may include a transition metal and n ligands bonded to the transition metal, wherein n maybe an integer from 1 to 4.

In an embodiment, the transition metal in the organometallic compound may be platinum (Pt) or palladium (Pd), n may be 1, and the ligand may be a tetradentate ligand. The tetradentate ligand may include, for example, a carbene moiety bonded to the transition metal.

In one or more embodiments, the organometallic compound may include a transition metal and a tetradentate ligand bonded to the transition metal, wherein the transition metal may be platinum or palladium, and the tetradentate ligand may include a carbene moiety bonded to the transition metal.

In one or more embodiments, the transition metal in the organometallic compound may be iridium (Ir) or osmium (Os), n may be 3, and at least one of the n ligands may be a bidentate ligand including -F, a cyano group, or any combination thereof or a bidentate ligand including a carbene moiety bonded to the transition metal. For example, the bidentate ligand may further include an imidazole group or a triazole group.

In one or more embodiments, the organometallic compound may be an organometallic compound represented by Formula 30 and/or an organometallic compound represented by Formula 5. Formulae 30 and 5 will be described in detail later.

In the first and second embodiments, the delayed fluorescence material may be, for example, a thermally activated delayed fluorescence material. In another embodiment, the delayed fluorescence material may be a multiple resonance thermally activated delayed fluorescence material.

The multiple resonance thermally activated delayed fluorescence material may be a polycyclic compound i) which does not include a transition metal, and ii) includes a core in which two or more C₃-C₆₀ cyclic groups are condensed with each other. In this regard, two C₃-C₆₀ cyclic groups of the core may be condensed with each other while sharing boron (B) or nitrogen (N).

In an embodiment, the delayed fluorescence material may be a polycyclic compound represented by Formula 4. Formula 4 will be described in detail later.

The prompt fluorescence material in the first and second embodiments may be an amino group-containing compound, a styryl group-containing compound, etc. For example, the prompt fluorescence material may include a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group(tetracene group), a picene group, a perylene group, a pentaphene group, an indenoanthracene group, a group represented by one of Formulae 501-1 to 501-21, or any combination thereof:

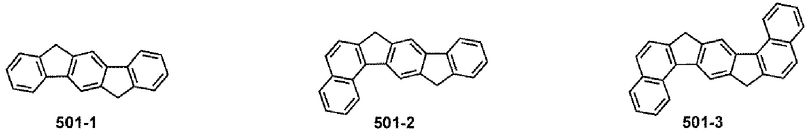

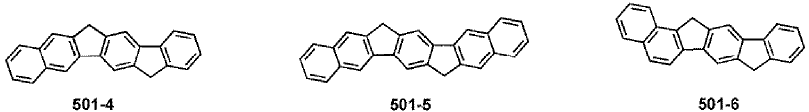

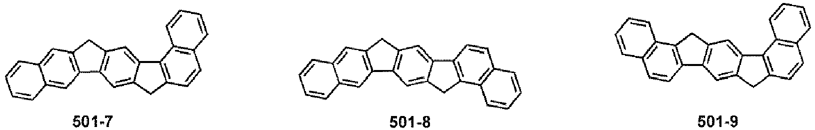

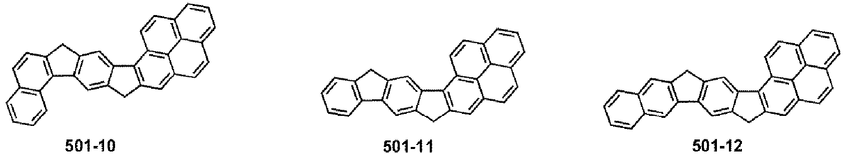

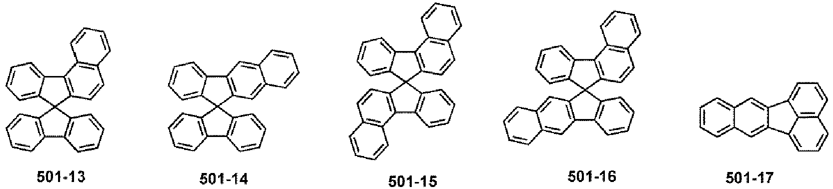

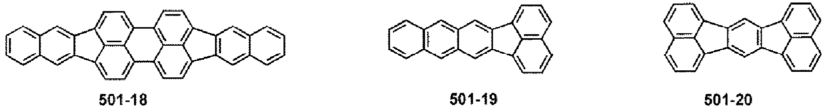

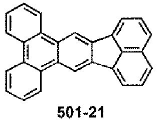

In one or more embodiments, the prompt fluorescence material may include a compound represented by Formula 501A or 501B: 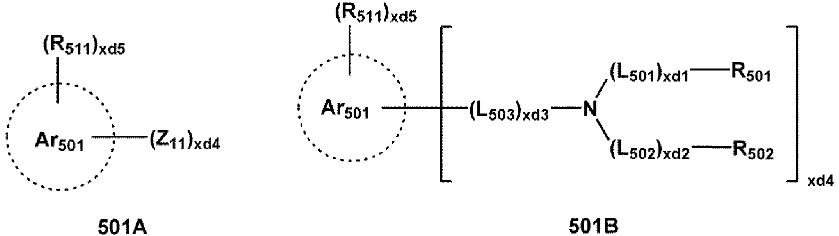 wherein, in Formulae 501A and 501B,
Ar₅₀₁ may be a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a bisanthracene group, or a group represented by one of Formulae 501-1 to 501-21,
R₅₁₁ may be hydrogen, deuterium, -F, -Cl, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or -Si(Q₅₀₁)(Q₅₀₂)(Q₅₀₃),
xd5 may be an integer from 0 to 10,
L₅₀₁ to L₅₀₃ may each independently be:
   a single bond; or
   a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, or a divalent non-aromatic condensed heteropolycyclic group, each unsubstituted or substituted with deuterium, -F, -Cl, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₅₀₁)(Q₅₀₂)(Q₅₀₃), or any combination thereof,
   xd1 to xd3 may each independently be 1, 2, or 3,
   R₅₀₁ and R₅₀₂ may each independently be a phenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, a dibenzothiophenyl group, or a dibenzosilolyl group, each unsubstituted or substituted with deuterium, -F, -Cl, - Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - Si(Q₅₀₁)(Q₅₀₂)(Q₅₀₃), or any combination thereof,
   Z₁₁ may be a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - Si(Q₅₀₁)(Q₅₀₂)(Q₅₀₃), or any combination thereof,
   xd4 may be 1, 2, 3, 4, 5, or 6, and
   Q₅₀₁ to Q₅₀₃ may each independently be hydrogen, a C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, or a monovalent non-aromatic condensed heteropolycyclic group.

In one or more embodiments, the prompt fluorescence material may include a compound represented by Formula 501A or 501B, wherein in Formula 501A, xd4 may be 1, 2, 3, 4, 5, or 6, and in Formula 501B, xd4 may be 2, 3, or 4.

### Description of host

The host in the emission layer may include a hole-transporting compound, an electron-transporting compound, a bipolar compound, or any combination thereof. The host may not include a transition metal.

For example, the host in the emission layer may include a hole-transporting compound and an electron-transporting compound, wherein the hole-transporting compound and the electron-transporting compound may be different from each other.

In an embodiment, the hole-transporting compound may include at least one π electron-rich C₃-C₆₀ cyclic group and may not include an electron-transporting group. Examples of the electron-transporting groups may include a cyano group, a fluoro group, a π electron-depleted nitrogen-containing cyclic group, a phosphine oxide group, a sulfoxide group, etc.

The "π electron-depleted nitrogen-containing cyclic group" as used herein may be a C₁-C₆₀ heterocyclic group including at least one *-N=*' moiety as a ring-forming moiety. Examples of the π electron-depleted nitrogen-containing cyclic group may include a triazine group, an imidazole group, and the like.

The "π electron-rich C₃-C₆₀ cyclic group" as used herein may be a C₃-C₆₀ cyclic group which does not include a *-N=*' moiety as a ring-forming moiety. Examples of the π electron-rich C₃-C₆₀ cyclic group may include a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, a dibenzocarbazole group, and the like.

For example, the hole-transporting compound may include two or more carbazole groups.

In an embodiment, the electron-transporting compound may be a compound including at least one electron-transporting group. The electron-transporting group may be a cyano group, a fluoro group, a π electron-depleted nitrogen-containing C₁-C₆₀ cyclic group, a phosphine oxide group, a sulfoxide group, or a combination thereof. In an embodiment, the electron-transporting compound may include a triazine group.

For example, the electron-transporting compound may include at least one electron-transporting group (for example, a triazine group) and at least one π electron-rich C₃-C₆₀ cyclic group (for example, a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, a dibenzocarbazole group, or any combination thereof).

In an embodiment, the hole-transporting compound may be a compound represented by Formula 6: 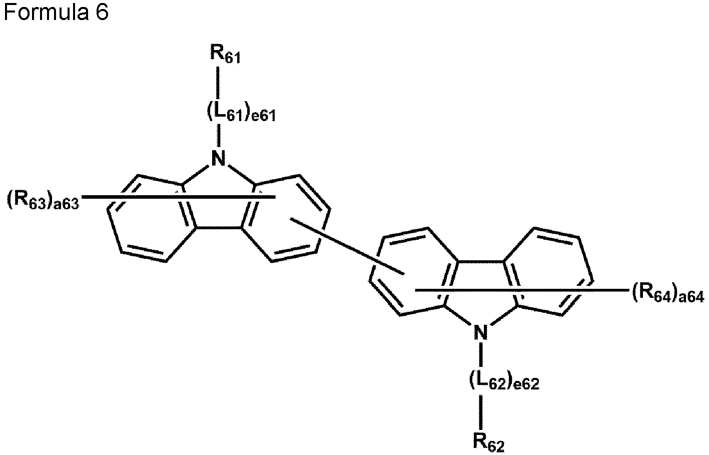 wherein, in Formula 6,
L₆₁ and L₆₂ may each independently be a π electron-rich C₃-C₆₀ cyclic group unsubstituted or substituted with deuterium, a C₁-C₂₀ alkyl group, a deuterated C₁-C₂₀ alkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, - Si(Q₃₃)(Q₃₄)(Q₃₅), or any combination thereof,
e61 and e62 may each independently be an integer from 1 to 6,
R₆₁ to R₆₄ may each independently be:
   hydrogen, deuterium, a C₁-C₂₀ alkyl group, or a deuterated C₁-C₂₀ alkyl group;
   a π electron-rich C₃-C₆₀ cyclic group unsubstituted or substituted with deuterium, a C₁-C₂₀ alkyl group, a deuterated C₁-C₂₀ alkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, -Si(Q₃₃)(Q₃₄)(Q₃₅), or any combination thereof; or
   -Si(Q₃)(Q₄)(Q₅), and
   a63 and a64 may each independently be an integer from 0 to 7.
   Q₃ to Q₅ and Q₃₃ to Q₃₅ may each be the same as described herein.

In one or more embodiments, the hole-transporting compound may be a compound represented by Formula 6-1, 6-2, or 6-3: 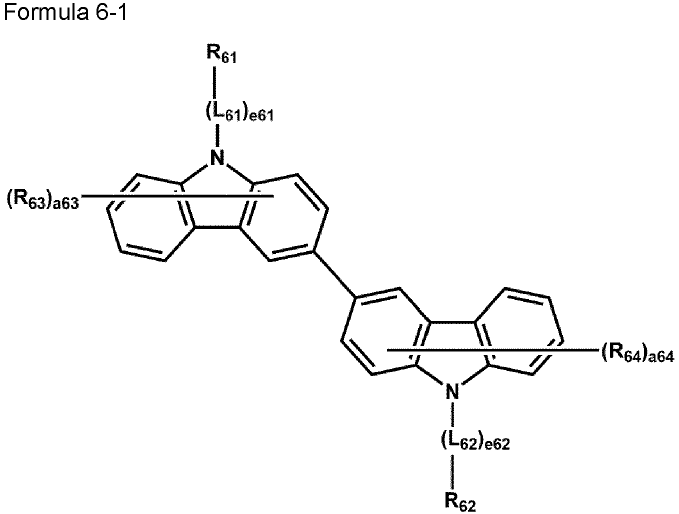 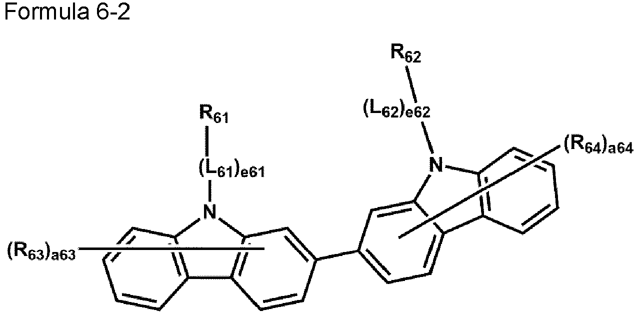 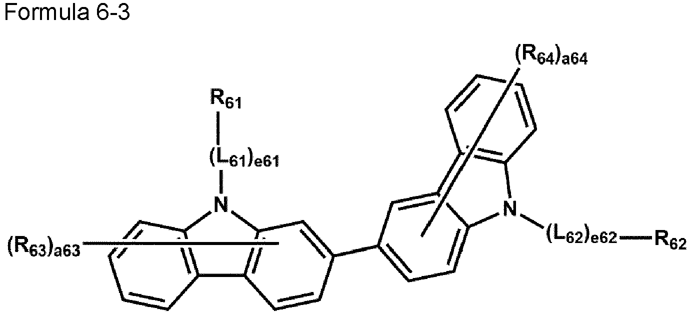 wherein, in Formulae 6-1 to 6-3, L₆₁, L₆₂, R₆₁ to R₆₄, e61, e62, a63, and a64 may each be the same as described herein.
In one or more embodiments, the hole-transporting compound may be one of Compounds HTH1 to HTH6:

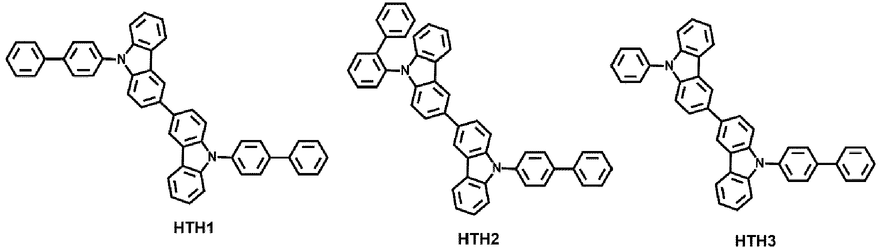

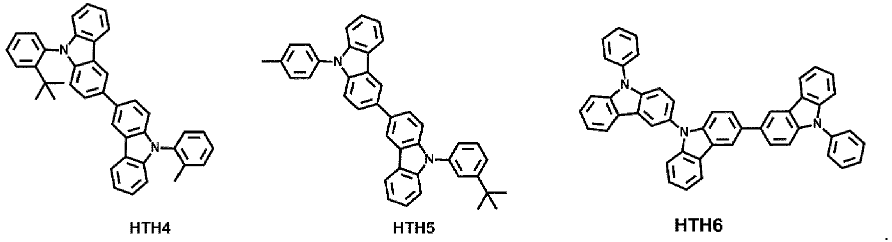

In one or more embodiments, the electron-transporting compound may be a compound represented by Formula 7: 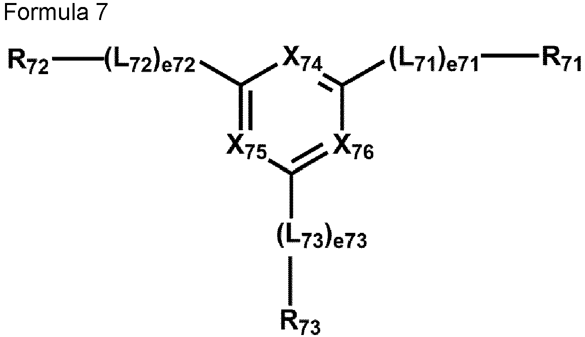 wherein, in Formula 7,
X₇₄ may be C(R₇₄) or N, X₇₅ may be C(R₇₅) or N, X₇₆ may be C(R₇₆) or N, and at least one of X₇₄ to X₇₆ may be N,
L₇₁ to L₇₃ may each independently be a C₅-C₃₀ carbocyclic group or a C₁-C₃₀ heterocyclic group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof,
e71 to e73 may each independently be an integer from 1 to 10, and
R₇₁ to R₇₆ may each independently be:
   hydrogen, deuterium, -F, or a cyano group;
   a C₁-C₂₀ alkyl group unsubstituted or substituted with deuterium, -F, a cyano group, or any combination thereof;
   a C₅-C₃₀ carbocyclic group or a C₁-C₃₀ heterocyclic group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof; or
   -Si(Q₃)(Q₄)(Q₅).
   Q₃ to Q₅ and Q₃₃ to Q₃₅ may each be the same as described herein.

In one or more embodiments, X₇₄ to X₇₆ in Formula 7 may each be N.

In one or more embodiments, L₇₁ to L₇₃ in Formula 7 may each independently be a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, or a dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof.

In one or more embodiments, in Formula 7, at least one of L₇₁ in the number of e71, at least one of L₇₂ in the number of e72, at least one of L₇₃ in the number of e73, or any combination thereof may each independently be a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, or a dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof.

In one or more embodiments, in Formula 7, at least one of L₇₁ in the number of e71, at least one of L₇₂ in the number of e72, at least one of L₇₃ in the number of e73, or any combination thereof may include a carbazole group, an indolocarbazole group, a benzocarbazole group, a naphthocarbazole group, or a dibenzocarbazole group, wherein a nitrogen atom of a pyrrole group of, the carbazole group, the indolocarbazole group, the benzocarbazole group, the naphthocarbazole group, or the dibenzocarbazole group, may be linked to a carbon atom of a 6-membered ring including X₇₄ to X₇₆ in Formula 7 via a single bond or with neighboring L₇₁, L₇₂, and/or L₇₃ located therebetween.

In one or more embodiments, e71 to e73 in Formula 7 indicate the numbers of L₇₁ to L₇₃, respectively, and may each independently be 1, 2, 3, 4, or 5.

In one or more embodiments, R₇₁ to R₇₆ in Formula 7 may each independently be:
hydrogen, deuterium, -F, or a cyano group;
a C₁-C₂₀ alkyl group unsubstituted or substituted with deuterium, -F, a cyano group, or any combination thereof;
a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, or a dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof; or
-Si(Q₃)(Q₄)(Q₅).

In one or more embodiments, the electron-transporting compound may be one of Compounds ETH1 to ETH7:

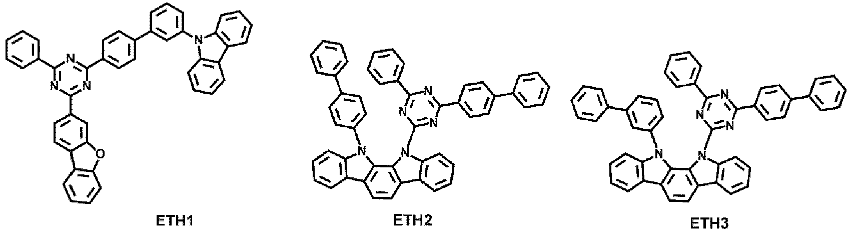

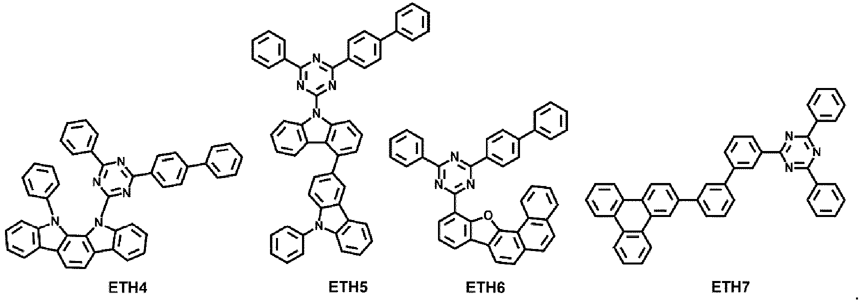

### Description of Formula 30

In the first and second embodiments, the organometallic compound may be an organometallic compound represented by Formula 30: 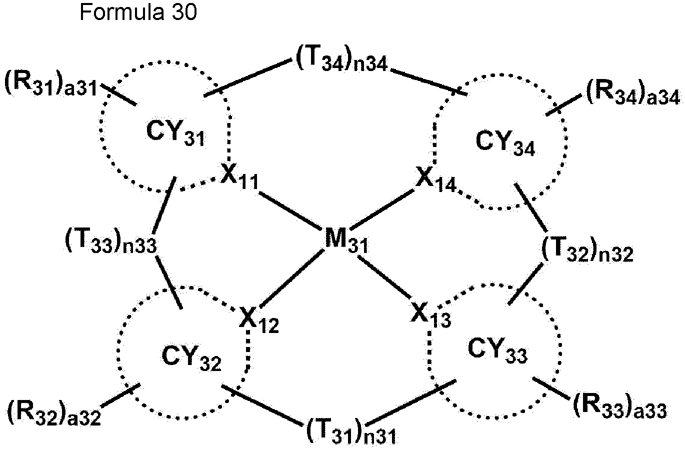 wherein, in Formula 30,
M₃₁ may be a transition metal,
X₁₁ to X₁₄ may each independently be C or N,
two bonds of a bond between X₁₁ and M₃₁, a bond between X₁₂ and M₃₁, a bond between X₁₃ and M₃₁, and a bond between X₁₄ and M₃₁ may each be a coordinate bond, and the other two bonds may each be a covalent bond,
ring CY₃₁ to ring CY₃₄ may each independently be a C₅-C₃₀ carbocyclic group or a C₁-C₃₀ heterocyclic group,
T₃₁ may be a single bond, a double bond, *-N(R₃₅ₐ)-*, *-B(R₃₅ₐ)-*', *-P(R₃₅ₐ)-*', *-C(R₃₅ₐ)(R_{35b})-*', *-Si(R₃₅ₐ)(R_{35b})-*', *-Ge(R₃₅ₐ)(R_{35b})-*', *-S-*', *-Se-*', *-O-*', *-C(=O)-*', *-S(=O)-*', *-S(=O)₂-*', *-C(R₃₅ₐ)=*', *=C(R₃₅ₐ)-*', *-C(R₃₅ₐ)=C(R_{35b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
T₃₂ may be a single bond, a double bond, *-N(R₃₆ₐ)-*', *-B(R₃₆ₐ)-*', *-P(R₃₆ₐ)-*', *-C(R₃₆ₐ)(R_{36b})-*', *-Si(R₃₆ₐ)(R_{36b})-*', *-Ge(R₃₆ₐ)(R_{36b})-*', *-S-*', *-Se-*', *-O-*', *-C(=O)-*', *-S(=O)-*', *-S(=O)₂-*', *-C(R₃₆ₐ)=*', *=C(R₃₆ₐ)-*', *-C(R₃₆ₐ)=C(R_{36b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
T₃₃ may be a single bond, a double bond, *-N(R₃₇ₐ)-*', *-B(R₃₇ₐ)-*', *-P(R₃₇ₐ)-*', *-C(R₃₇ₐ)(R_{37b})-*', *-Si(R₃₇ₐ)(R_{37b})-*', *-Ge(R₃₇ₐ)(R_{37b})-*', *-S-*', *-Se-*', *-O-*', *-C(=O)-*', *-S(=O)-*', *-S(=O)₂-*', *-C(R₃₇ₐ)=*', *=C(R₃₇ₐ)-*', *-C(R₃₇ₐ)=C(R_{37b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
T₃₄ may be a single bond, a double bond, *-N(R₃₈ₐ)-*', *-B(R₃₈ₐ)-*', *-P(R₃₈ₐ)-*', *-C(R₃₈ₐ)(R_{38b})-*', *-Si(R₃₈ₐ)(R_{38b})-*', *-Ge(R₃₈ₐ)(R_{38b})-*', *-S-*', *-Se-*', *-O-*', *-C(=O)-*', *-S(=O)-*', *-S(=O)₂-*', *-C(R₃₈ₐ)=*', *=C(R₃₈ₐ)-*', *-C(R₃₈ₐ)=C(R_{38b})-*', *-C(=S)-*', *-C≡C-*', a C₅-C₃₀ carbocyclic group unsubstituted or substituted with at least one R₁₀ₐ, or a C₁-C₃₀ heterocyclic group unsubstituted or substituted with at least one R₁₀ₐ,
n31 to n34 may each independently be an integer from 0 to 5, and three or more of n31 to n34 may each independently be an integer from 1 to 5,
when n31 is 0, T₃₁ may not be present, when n32 is 0, T₃₂ may not be present, when n33 is 0, T₃₃ may not be present, and when n34 is 0, T₃₄ may not be present,
when n31 is 2 or more, two or more of T₃₁ may be identical to or different from each other, when n32 is 2 or more, two or more of T₃₂ may be identical to or different from each other, when n33 is 2 or more, two or more of T₃₃ may be identical to or different from each other, and when n34 is 2 or more, two or more of T₃₄ may be identical to or different from each other,
R₃₁ to R₃₄, R₃₈ₐ, R_{35b}, R₃₆ₐ, R_{36b}, R₃₇ₐ, R_{37b}, R₃₈ₐ, and R_{38b} may each independently be hydrogen, deuterium, -F, -Cl, -Br, -I, -CD₃, -CD₂H, -CDH₂, -CF₃, - CF₂H, -CFH₂, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ heteroaryl alkyl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), - B(Q₆)(Q₇), -P(=O)(Q₈)(Q₉), or -P(Q₈)(Q₉),
a31 to a34 may each independently be an integer from 0 to 20,
two or more of R₃₁ in the number of a31 may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₂ in the number of a32 may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₃ in the number of a33 may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₄ in the number of a34 may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₁, R₃₂, R₃₃, R₃₄, R₃₅ₐ, R_{35b}, R₃₆ₐ, R_{36b}, R₃₇ₐ, R_{37b}, R₃₈ₐ, and R_{38b} may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is the same as described in connection with R₃₁,
* and *' each indicate a binding site to a neighboring atom,
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ heteroaryl alkyl group, the substituted monovalent non-aromatic condensed polycyclic group, and the substituted monovalent non-aromatic condensed heteropolycyclic group may be:
   deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
   a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C_{10 h}eterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), - B(Q₁₆)(Q₁₇), -P(=O)(Q₁₈)(Q₁₉), -P(Q₁₈)(Q₁₉), or any combination thereof;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), or any combination thereof;
   -N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
   any combination thereof, and
   Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

In an embodiment, M₃₁ in Formula 30 may be Pt, Pd, or Au.

In one or more embodiments, M₃₁ in Formula 30 may be Pt or Pd.

In one or more embodiments, in Formula 30, a bond between X₁₁ and M₃₁ may be a coordinate bond.

In one or more embodiments, in Formula 30, X₁₁ may be C, and a bond between X₁₁ and M₃₁ may be a coordinate bond. That is, X₁₁ in Formula 30 may be C in a carbene moiety.

In one or more embodiments, ring CY₃₁ to ring CY₃₄ in Formula 30 may each independently be i) a first ring, ii) a second ring, iii) a condensed ring in which two or more first rings are condensed with each other, iv) a condensed ring in which two or more second rings are condensed with each other, or v) a condensed ring in which at least one first ring is condensed with at least one second ring,
the first ring may be a cyclopentane group, a cyclopentadiene group, a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, a triazine group, an oxazine group, a thiazine group, a dihydropyrazine group, a dihydropyridine group, or a dihydroazasilane group.

In an embodiment, R₃₁ to R₃₄, R₃₅ₐ, R_{35b}, R₃₆ₐ, R_{36b}, R₃₇ₐ, R_{37b}, R₃₈ₐ, and R_{38b} may each independently be:
hydrogen, deuterium, -F, -Cl, -Br, -I, -CD₃, -CD₂H, -CDH₂, -CF₃, -CF₂H, -CFH₂, a cyano group (CN), a nitro group, an amino group, a C₁-C₂₀ alkyl group, or a C₁-C₂₀ alkoxy group;
a C₁-C₂₀ alkyl group or a C₁-C₂₀ alkoxy group, each substituted with at least one of deuterium, -F, -Cl, -Br, -I, -CD₃, -CD₂H, -CDH₂, -CF₃, -CF₂H, -CFH₂, a cyano group (CN), a nitro group, an amino group, and a phenyl group; or
a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, or an anthracenyl group, each unsubstituted or substituted with at least one of deuterium, -F, -Cl, -Br, -I, -CD₃, -CD₂H, -CDH₂, -CF₃, -CF₂H, -CFH₂, a cyano group (CN), a nitro group, an amino group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, and an anthracenyl group.

In an embodiment, the organometallic compound represented by Formula 30 may be an organometallic compound represented by Formula 3-1 or 3-2:

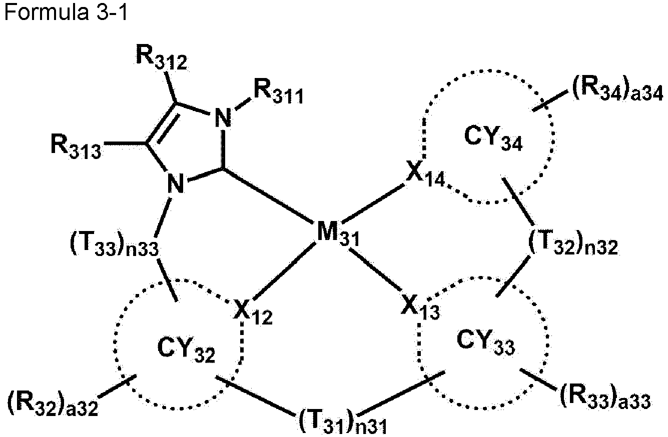

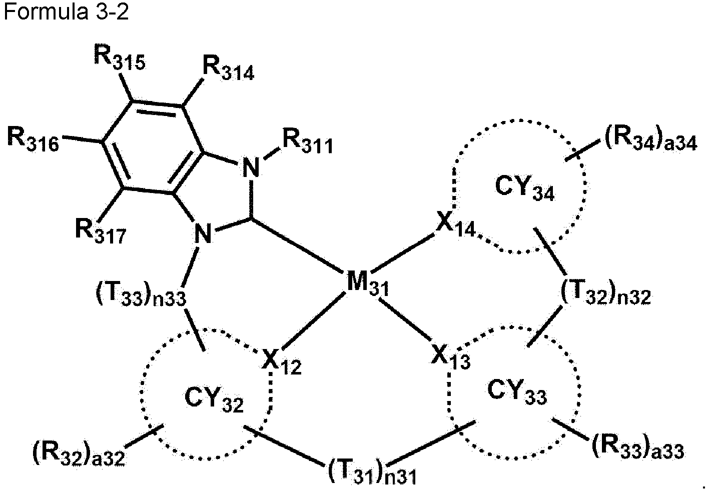

In Formula 3-1, a bond between carbon of an imidazole group and M₃₁ may be a coordinate bond. That is, the imidazole group in Formula 3-1 may include a carbene moiety bonded to M₃₁.

In Formula 3-2, a bond between carbon of a benzimidazole group and M₃₁ may be a coordinate bond. That is, the benzimidazole group in Formula 3-2 may include a carbene moiety bonded to M₃₁.

Therefore, Formula 3-1' in which the carbon bonded to M₃₁ in the imidazole group is carbene, is the same as Formula 3-1, and Formula 3-2' in which the carbon bonded to M₃₁ in the benzimidazole group is carbene, is the same as Formula 3-2: 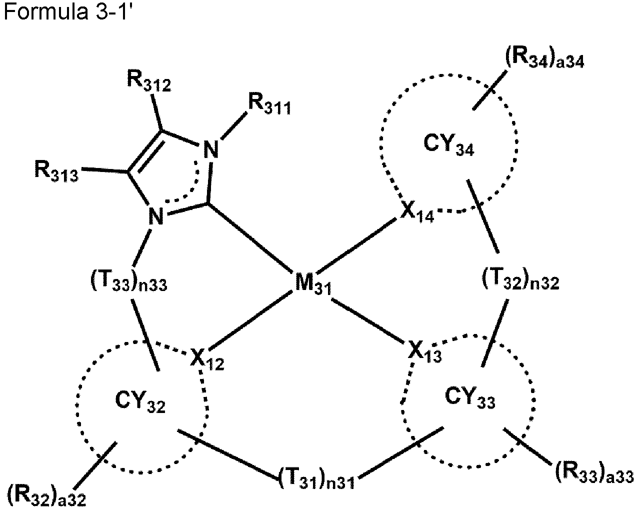 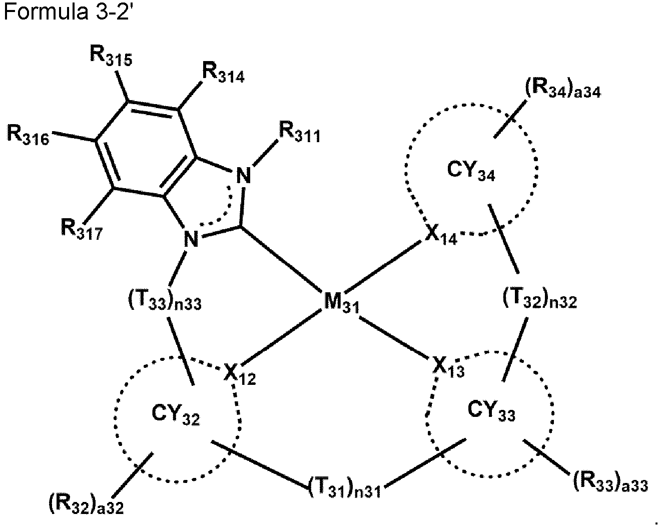 In Formulae 3-1 and 3-2,
M₃₁, CY₃₂, CY₃₃, CY₃₄, X₁₂, X₁₃, X₁₄, T₃₁, T₃₂, T₃₃, n31, n32, n33, R₃₂, R₃₃, R₃₄, a32, a33, and a34 may respectively be understood by referring to the descriptions of M₃₁, CY₃₂, CY₃₃, CY₃₄, X₁₂, X₁₃, X₁₄, T₃₁, T₃₂, T₃₃, n31, n32, n33, R₃₂, R₃₃, R₃₄, a32, a33, and a34 provided herein, and
R₃₁₁ to R₃₁₇ may each be understood by referring to the description of R₃₁ provided herein.

In an embodiment, in Formulae 3-1 and 3-2,

R₃₁₁ to R₃₁₇ may each independently be:
hydrogen, deuterium, -F, -Cl, -Br, -I, -CD₃, -CD₂H, -CDH₂, -CF₃, -CF₂H, -CFH₂, -SF₅, a hydroxyl group, a cyano group, a nitro group, an amidino group, a hydrazine group, a hydrazone group, a carboxylic acid group or a salt thereof, a sulfonic acid group or a salt thereof, or a phosphoric acid group or a salt thereof;
a C₁-C₂₀ alkyl group or a C₁-C₂₀ alkoxy group, each unsubstituted or substituted with deuterium, -F, -Cl, -Br, -I, -CD₃, -CD₂H, -CDH₂, -CF₃, -CF₂H, -CFH₂, - SF₅, a hydroxyl group, a cyano group, a nitro group, an amidino group, a hydrazine group, a hydrazone group, or any combination thereof;
a C₃-C₁₀ cycloalkyl group, a C₁-C₁₀ heterocycloalkyl group, a C₆-C₆₀ aryl group, a C₇-C₆₀ arylalkyl group, a C₆-C₆₀ aryloxy group, a C₆-C₆₀ arylthio group, a C₁-C₆₀ heteroaryl group, a substituted or unsubstituted C₂-C₆₀ heteroaryl alkyl group, a monovalent non-aromatic condensed polycyclic group, a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, -SF₅, a hydroxyl group, a cyano group, a nitro group, an amidino group, a hydrazine group, a hydrazone group, a C₁-C₂₀ alkyl group, a C₁-C₂₀ alkoxy group, or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉).

For example, in Formulae 3-1 and 3-2, at least one of R₃₁₁ to R₃₁₇ may include a C₁-C₂₀ alkyl group, a C₆-C₆₀ aryl group, or a C₇-C₆₀ arylalkyl group, each unsubstituted or substituted with a methyl group, an ethyl group, an n-propyl group, an isopropyl group, an n-butyl group, an isobutyl group, a sec-butyl group, a tert-butyl group, a phenyl group, a cumyl group, or a combination thereof.

According to an embodiment, the organometallic compound represented by Formula 30 may be an organometallic compound represented by Formula 3-1(1) or an organometallic compound represented by Formula 3-2(1):

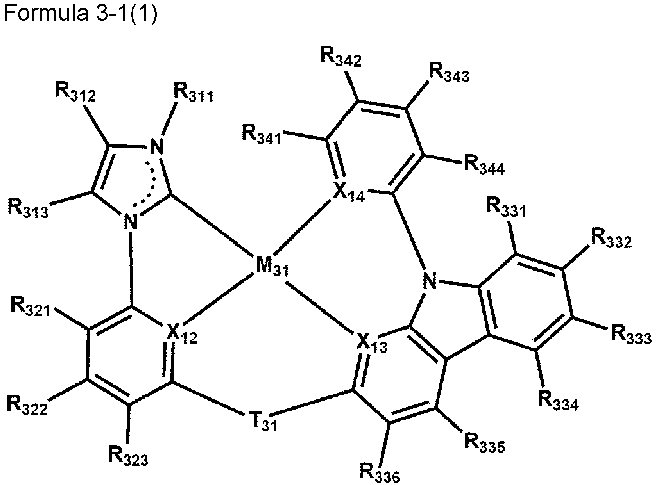

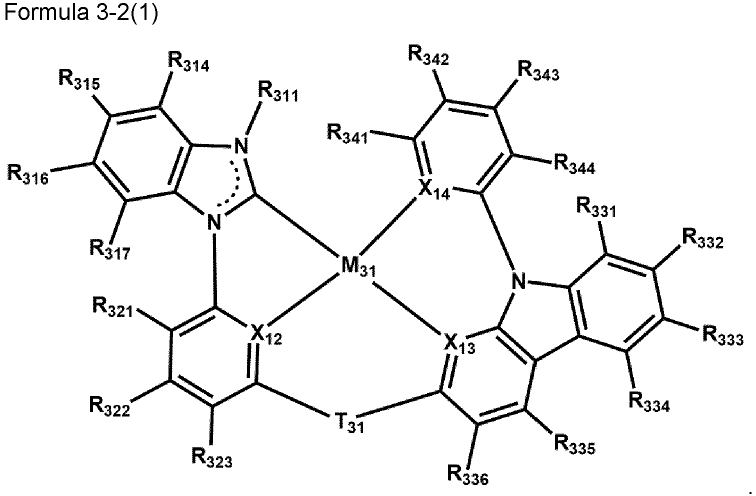

In Formulae 3-1(1) and 3-2(1),
M₃₁, X₁₂, X₁₃, X₁₄, and T₃₁ are each the same as described herein,
R₃₁₁ to R₃₁₇ may each be the same as described in connection with R₃₁,
R₃₂₁ to R₃₂₃ may each be the same as described in connection with R₃₂, and two or more of R₃₂₁ to R₃₂₃ may optionally be bonded together to form a C₅-C₃₀ carbocyclic group unsubstituted or substituted with at least one R₁₀ₐ or a C₁-C₃₀ heterocyclic group unsubstituted or substituted with at least one R₁₀ₐ,
R₃₃₁ to R₃₃₆ may each be the same as described in connection with R₃₃, and two or more of R₃₃₁ to R₃₃₆ may optionally be bonded together to form a C₅-C₃₀ carbocyclic group unsubstituted or substituted with at least one R₁₀ₐ or a C₁-C₃₀ heterocyclic group unsubstituted or substituted with at least one R₁₀ₐ, and
R₃₄₁ to R₃₄₄ may each be the same as described in connection with R₃₄, and two or more of R₃₄₁ to R₃₄₄ may optionally be bonded together to form a C₅-C₃₀ carbocyclic group unsubstituted or substituted with at least one R₁₀ₐ or a C₁-C₃₀ heterocyclic group unsubstituted or substituted with at least one R₁₀ₐ.

### Description of Formula 5

In the first and second embodiments, the organometallic compound may be an organometallic compound represented by Formula 5:

Formula 5 M₅₁(L₅₁)ₙ₅₁(L₅₂)ₙ₅₂

wherein, in Formula 5, M₅₁ may be a transition metal.

In some embodiments, M₅₁ may be a first-row transition metal, a second-row transition metal, or a third-row transition metal.

In some embodiments, M₅₁ may be iridium (Ir), platinum (Pt), osmium (Os), titanium (Ti), zirconium (Zr), hafnium (Hf), europium (Eu), terbium (Tb), thulium (Tm), or rhodium (Rh).

In some embodiments, M₅₁ may be Ir, Pt, Os, or Rh.

In one or more embodiments, M₅₁ may be Ir or Os.

In Formula 5, L₅₁ may be a ligand represented by Formula 5A, and L₅₂ may be a ligand represented by Formula 5B: 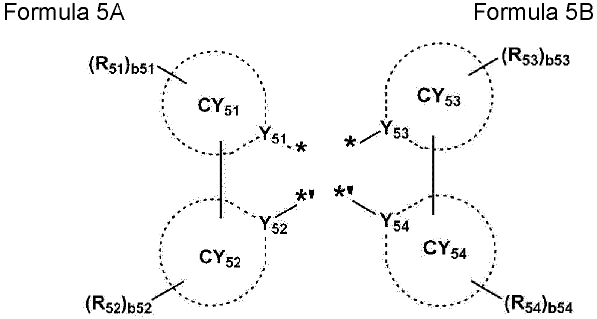 wherein Formulae 5A and 5B are each the same as described in the specification.
n51 in Formula 5 may be 1, 2, or 3, wherein, when n51 is 2 or more, two or more of L₅₁ may be identical to or different from each other.
n52 in Formula 5 may be 0, 1, or 2, wherein, when n52 is 2, two L₅₂ may be identical to or different from each other.

The sum of n51 and n52 in Formula 5 may be 2 or 3. For example, the sum of n51 and n52 may be 3.

In an embodiment, in Formula 5, i) M may be Ir, and n51+n52=3; or ii) M may be Pt, and n51+n52=2.

In one or more embodiments, in Formula 5, M may be Ir, and i) n51 may be 1, and n52 may be 2, or ii) n51 may be 2, and n52 may be 1.

L₅₁ and L₅₂ in Formula 5 may be different from each other.

Y₅₁ to Y₅₄ in Formulae 5A to 5B may each independently be C or N. For example, Y₅₁ and Y₅₃ may each be N, and Y₅₂ and Y₅₄ may each be C.

Ring CY₅₁ to ring CY₅₄ in Formulae 5A and 5B may each independently be a C₅-C₃₀ carbocyclic group or a C₁-C₃₀ heterocyclic group.

For example, ring CY₅₁ to ring CY₅₄ in Formulae 5A and 5B may each independently include i) a third ring, ii) a fourth ring, iii) a condensed ring in which two or more third rings are condensed with each other, iv) a condensed ring in which two or more fourth rings are condensed with each other, or v) a condensed ring in which at least one third ring is condensed with at least one fourth ring,
the third ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the fourth ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In some embodiments, in Formulae 5A and 5B, ring CY₁ to ring CY₄ may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isooxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

For example, ring CY₅₁ and ring CY₅₃ in Formulae 5A and 5B may be different from each other.

In one or more embodiments, ring CY₅₂ and ring CY₅₄ in Formulae 5A and 5B may be different from each other.

In one or more embodiments, ring CY₅₁ to ring CY₅₄ in Formulae 5A and 5B may be different from each other.

R₅₁ to R₅₄ in Formulae 5A and 5B may each independently be hydrogen, deuterium, - F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₅₁)(Q₅₂), -Si(Q₅₃)(Q₅₄)(Q₅₅), - Ge(Q₅₃)(Q₅₄)(Q₅₅), -B(Q₅₆)(Q₅₇), -P(=O)(Q₅₈)(Q₅₉), or -P(Q₅₈)(Q₅₉). Q₅₁ to Q₅₉ are each the same as described in the specification.

In an embodiment, R₅₁ to R₅₄ in Formulae 5A and 5B may each independently be: hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a (phenyl)C₁-C₁₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
   -N(Q₅₁)(Q₅₂), -Si(Q₅₃)(Q₅₄)(Q₅₅), -Ge(Q₅₃)(Q₅₄)(Q₅₅), -B(Q₅₆)(Q₅₇), - P(=O)(Q₅₈)(Q₅₉), or -P(Q₅₈)(Q₅₉), and
Q₅₁ to Q₅₉ may each independently be:
   -CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, or -CD₂CDH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

In one or more embodiments, R₅₁ to R₅₄ may each independently be:
hydrogen, deuterium, -F, or a cyano group;
a C₁-C₂₀ alkyl group unsubstituted or substituted with deuterium, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ heterocycloalkyl group, a phenyl group, or a biphenyl group, each unsubstituted or substituted with deuterium, a cyano group, a C₁-C₂₀ alkyl group, a deuterated C₁-C₂₀ alkyl group, fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or
-Si(Q₅₃)(Q₅₄)(Q₅₅) or -Ge(Q₅₃)(Q₅₄)(Q₅₅).
b51 to b54 in Formulae 5A and 5B indicate the numbers of R₅₁ to R₅₄, respectively, and may each independently be an integer from 0 to 20. When b51 is 2 or more, two or more of R₅₁ may be identical to or different from each other, when b52 is 2 or more, two or more of R₅₂ may be identical to or different from each other, when b53 is 2 or more, two or more of R₅₃ may be identical to or different from each other, and when b54 is 2 or more, two or more of R₅₄ may be identical to or different from each other. For example, b51 to b54 may each independently be an integer from 0 to 8.

In an embodiment, in Formula 5A, Y₅₂ may be C, a bond between Y₅₂ and M₅₁ may be a covalent bond, and at least one of R₅₂ in the number of b52 may be a cyano group or -F.

In one or more embodiments, in Formula 5A, Y₅₁ may be N, a bond between Y₅₁ and M₅₁ may be a coordinate bond, CY₅₁ may be an imidazole group, a triazole group, a benzimidazole group, or a triazolopyridine group, and at least one of R₅₂ in the number of b52 may be a cyano group or -F.

In one or more embodiments, in Formula 5A, Y₅₁ may be C, and a bond between Y₅₁ and M₅₁ may be a coordinate bond.

In one or more embodiments, in Formula 5A, Y₅₁ may be C, a bond between Y₅₁ and M₅₁ may be a coordinate bond, and CY₅₁ may be a benzimidazole group or an imidazopyrazine group.

### Specific examples of organometallic compound represented by Formula 30 or 5

For example, the organometallic compound represented by Formula 30 or 5 may be one of Compounds P1 to P52:

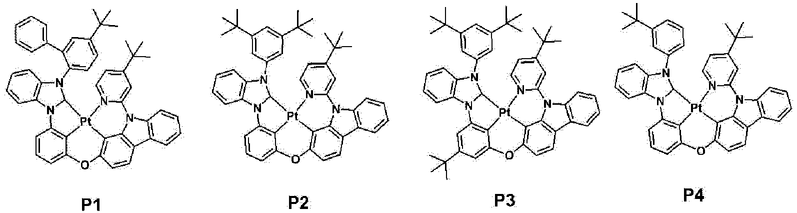

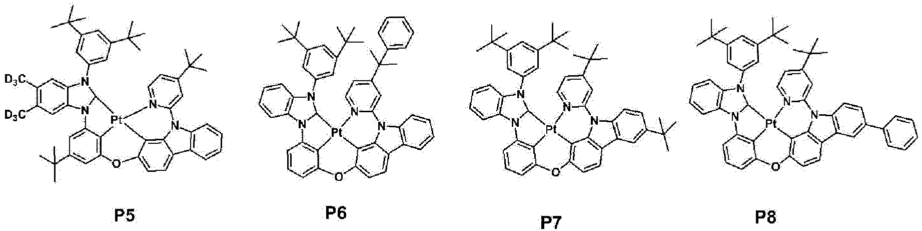

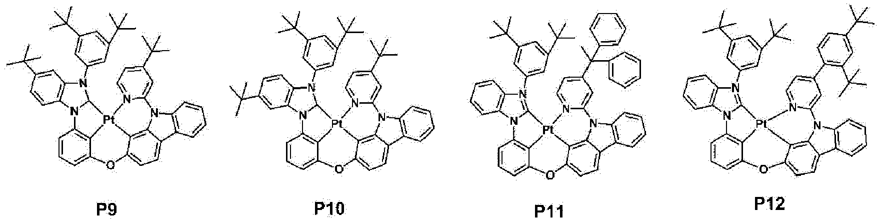

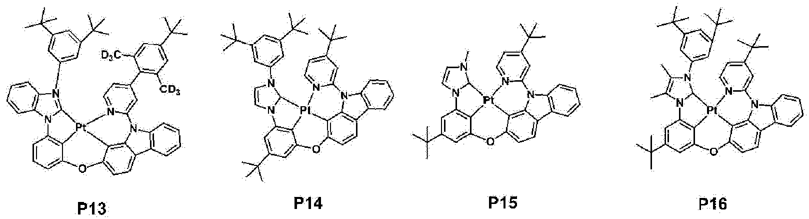

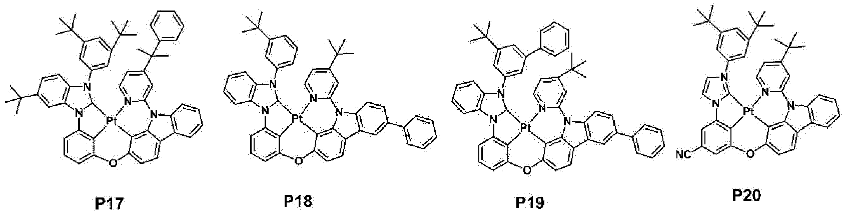

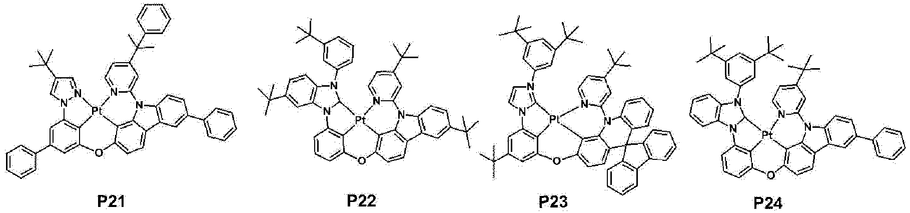

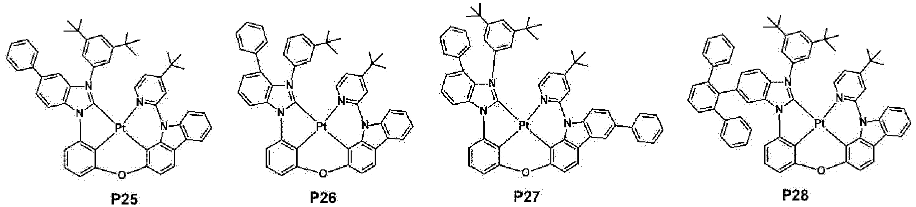

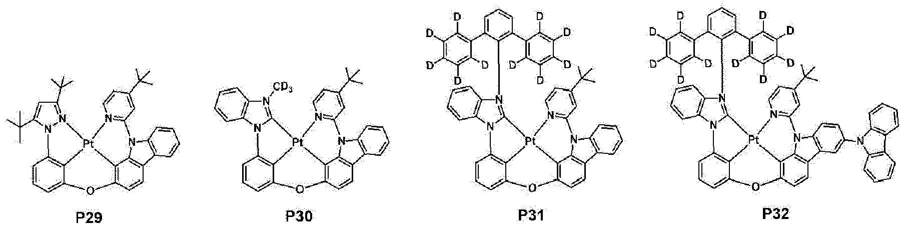

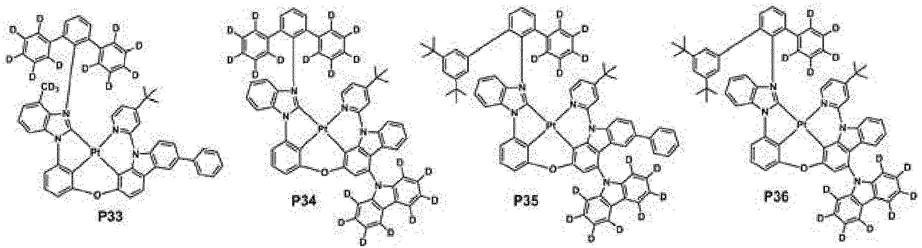

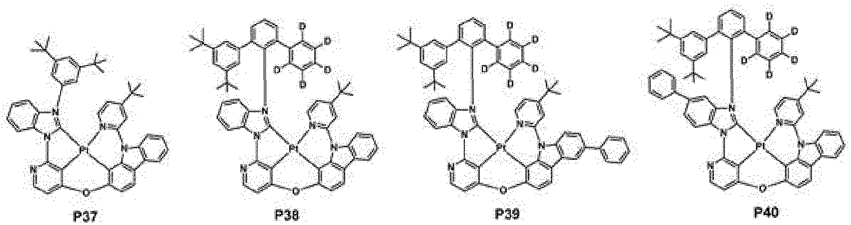

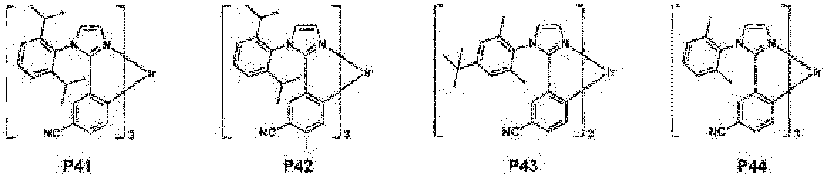

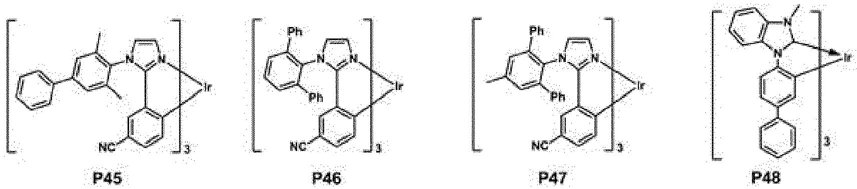

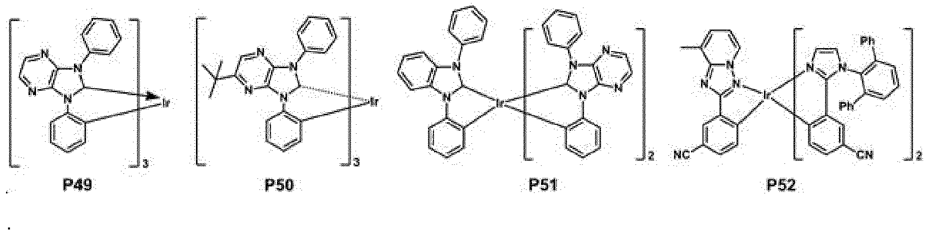

### Description of Formula 4

In the first and second embodiments, the delayed fluorescence material may be a polycyclic compound represented by Formula 4: 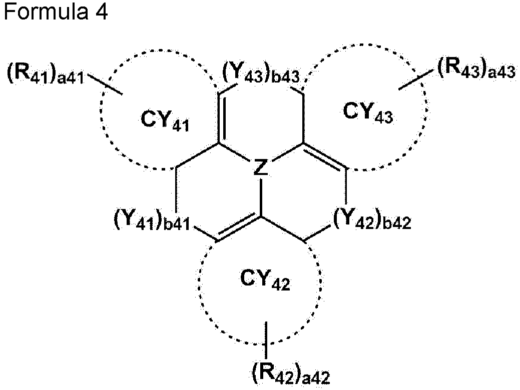 wherein, in Formula 4,
Z may be B or N,
ring CY₄₁ to ring CY₄₃ may each independently be a C₅-C₆₀ carbocyclic group or a C₁-C₆₀ heterocyclic group,
Y₄₁ may be a single bond, *-N(R₄₄)-*', *-B(R₄₄)-*', *-P(R₄₄)-*', *-C(R₄₄)(R₄₅)-*', *-Si(R₄₄)(R₄₅)-*', *-Ge(R₄₄)(R₄₅)-*', *-O-*', *-S-*', *-Se-*', *-C(=O)-*', or *-S(=O)₂-*',
Y₄₂ may be a single bond, *-N(R₄₆)-*', *-B(R₄₆)-*', *-P(R₄₆)-*', *-C(R₄₆)(R₄₇)-*', *-Si(R₄₆)(R₄₇)-*', *-Ge(R₄₆)(R₄₇)-*', *-O-*', *-S-*', *-Se-*', *-C(=O)-*', or *-S(=O)₂-*',
Y₄₃ may be a single bond, *-N(R₄₈)-*', *-B(R₄₈)-*', *-P(R₄₈)-*', *-C(R₄₈)(R₄₉)-*', *-Si(R₄₈)(R₄₉)-*', *-Ge(R₄₈)(R₄₉)-*', *-O-*', *-S-*', *-Se-*', *-C(=O)-*', or *-S(=O)₂-*',
b41 to b43 may each independently be 0 or 1,
when b41 is 0, Y₄₁ may is not present, when b42 is 0, Y₄₂ is not present, and when b43 is 0, Y₄₃ is not present,
R₄₁ to R₄₉ may each independently be hydrogen, deuterium, -F, -Cl, -Br, -I, - SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ heteroaryl alkyl group, a substituted or unsubstituted monovalent non-aromatic condensed polycyclic group, a substituted or unsubstituted monovalent non-aromatic condensed heteropolycyclic group, - N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉),
a41 to a43 may each independently be an integer from 0 to 20,
two or more of R₄₁ in the number of a41 may optionally be bonded to each other to form a C₅-C₃₀ carbocyclic group unsubstituted or substituted with at least one R_{10b} or a C₁-C₃₀ heterocyclic group unsubstituted or substituted with at least one R_{10b},
two or more of R₄₂ in the number of a42 may optionally be bonded to each other to form a C₅-C₃₀ carbocyclic group unsubstituted or substituted with at least one R_{10b} or a C₁-C₃₀ heterocyclic group unsubstituted or substituted with at least one R_{10b},
two or more of R₄₃ in the number of a43 may optionally be bonded to each other to form a C₅-C₃₀ carbocyclic group unsubstituted or substituted with at least one R_{10b} or a C₁-C₃₀ heterocyclic group unsubstituted or substituted with at least one R_{10b},
two or more of R₄₁ to R₄₉ may optionally be bonded to each other to form a C₅-C₃₀ carbocyclic group unsubstituted or substituted with at least one R_{10b} or a C₁-C₃₀ heterocyclic group unsubstituted or substituted with at least one R_{10b},
R_{10b} is the same as described in connection with R₄₁,
* and *' each indicate a binding site to a neighboring atom,
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ heteroaryl alkyl group, the substituted monovalent non-aromatic condensed polycyclic group, and the substituted monovalent non-aromatic condensed heteropolycyclic group may be:
   deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
   a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C_{10 h}eterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), - B(Q₁₆)(Q₁₇), -P(=O)(Q₁₈)(Q₁₉), -P(Q₁₈)(Q₁₉), or any combination thereof;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), or any combination thereof;
   -N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
   any combination thereof, and
   Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

In an embodiment, ring CY₄₁ to ring CY₄₃ may each independently be i) a benzene group, or ii) a polycyclic group in which two or more C₃-C₃₀ cyclic groups are condensed with each other. In this regard, two C₃-C₃₀ cyclic groups of the polycyclic group may be condensed with each other while sharing boron (B) or nitrogen (N).

In one or more embodiments, at least one of b41 to b43 or at least two of b41 to b43 may each be 1. In one or more embodiments, two of b41 to b43 may be 1, and the other one may be 0.

In one or more embodiments, R₄₁ to R₄₉ may each independently be:
hydrogen, deuterium, -F, -Cl, -Br, -I, a hydroxyl group, a cyano group (CN), a nitro group, an amino group, a C₁-C₆₀ alkyl group, or a C₁-C₆₀ alkoxy group;
a C₁-C₆₀ alkyl group or a C₁-C₆₀ alkoxy group, each substituted with at least one of deuterium, -F, -Cl, -Br, -I, a hydroxyl group, a cyano group (CN), a nitro group, an amino group, a phenyl group, a biphenyl group, a naphthyl group, a fluorenyl group, a phenanthrenyl group, an anthracenyl group, a fluoranthenyl group, a triphenylenyl group, a pyrenyl group, and a chrysenyl group; or
a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, or a carbazolyl group, each unsubstituted or substituted with at least one of deuterium, -F, -Cl, -Br, -I, a hydroxyl group, a cyano group (CN), a nitro group, an amino group, a C₁-C₆₀ alkyl group, a C₁-C₆₀ alkoxy group, a cyclopentyl group, a cyclohexyl group, a cycloheptyl group, a cyclopentenyl group, a cyclohexenyl group, a cycloheptenyl group, a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, and a carbazolyl group.

In one or more embodiments, the polycyclic compound represented by Formula 4 may be a polycyclic compound represented by one of Formulae 4-1 to 4-9: 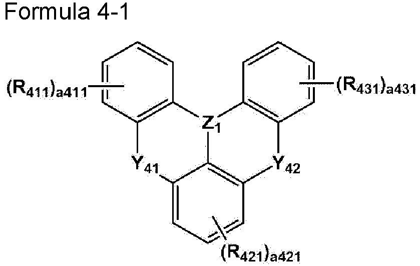 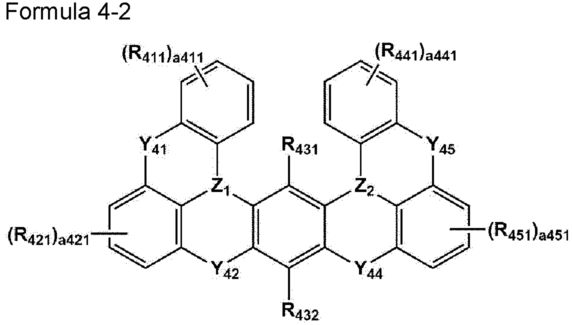 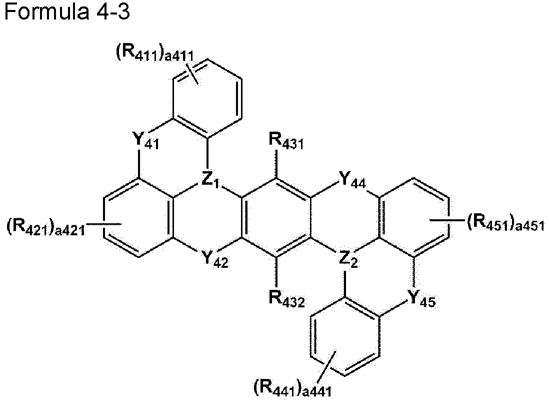 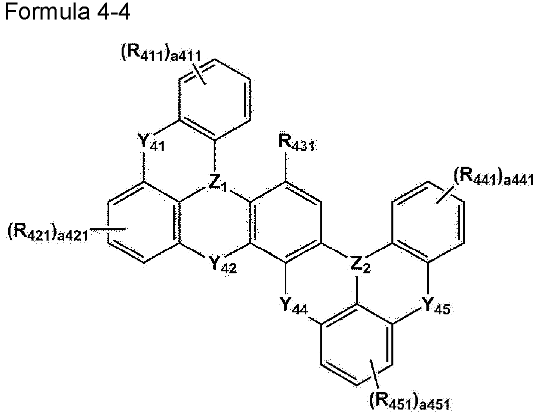 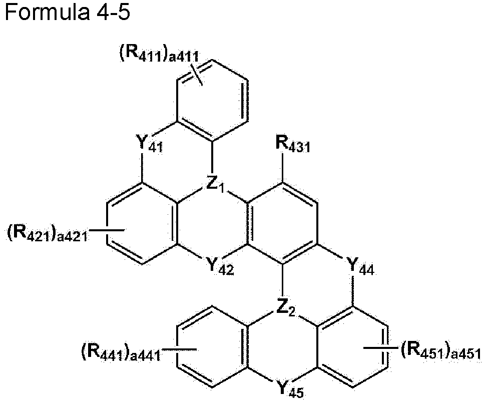 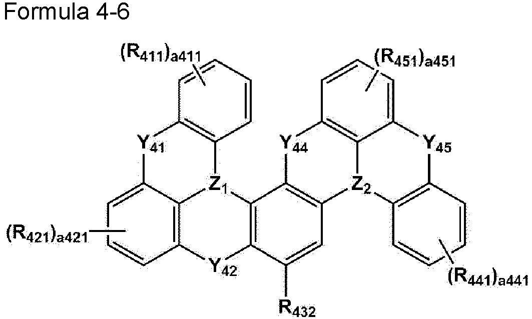 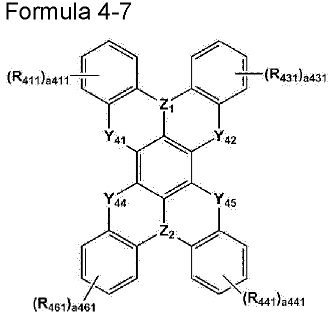 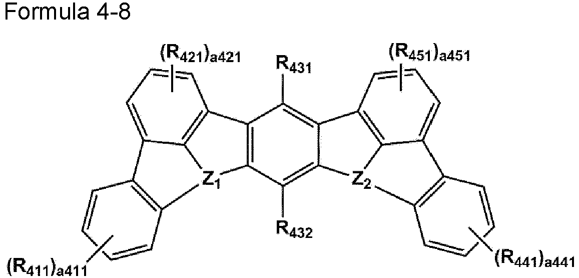 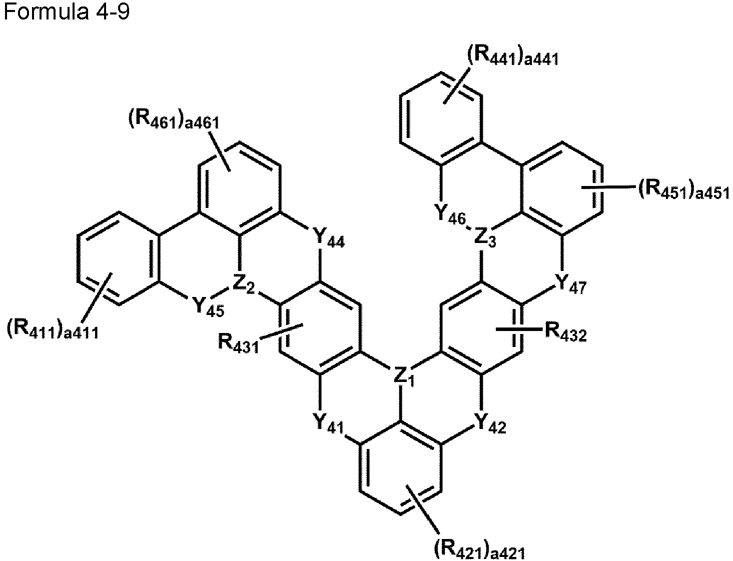 wherein, in Formulae 4-1 to 4-9,
Z₁ to Z₃ may each be understood by referring to the description of Z provided herein,
Y₄₁ and Y₄₂ may each be the same as described herein,
Y₄₄ to Y₄₇ may each be understood by referring to the description of Y₄₁ and Y42,
R₄₁₁ is the same as described in connection with R₄₁, R₄₂₁ is the same as described in connection with R₄₂, R₄₃₁ and R₄₃₂ are each the same as described in connection with R₄₃, R₄₄₁ is the same as described in connection with R₄₁, R₄₅₁ is the same as described in connection with R₄₂, and R₄₆₁ is the same as described in connection with R₄₃,
a411 may be an integer from 0 to 4,
a421 may be an integer from 0 to 3,
a431 may be an integer from 0 to 4,
a441 may be an integer from 0 to 4,
a451 may be an integer from 0 to 3, and
a461 may be an integer from 0 to 3.

### Specific examples of polycyclic compound represented by Formula 4

The polycyclic compound represented by Formula 4 may be selected from Compounds D1 to D30:

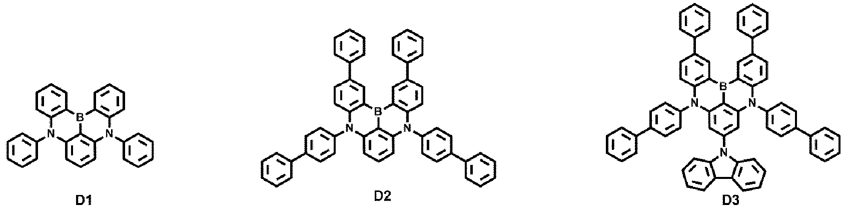

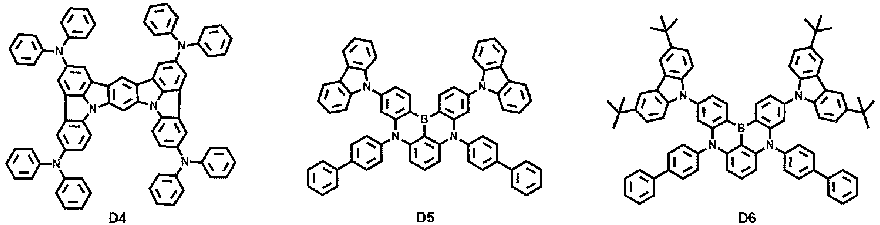

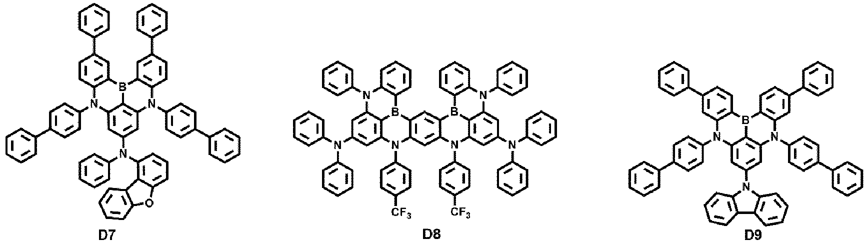

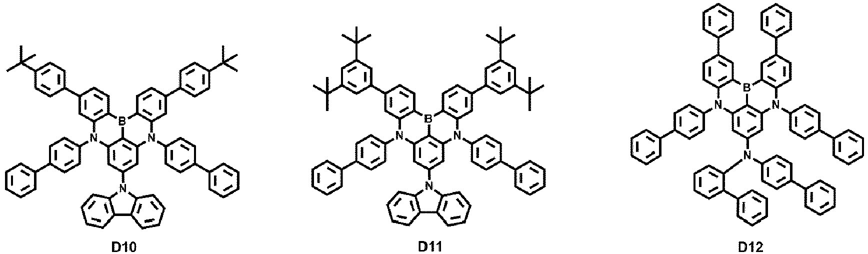

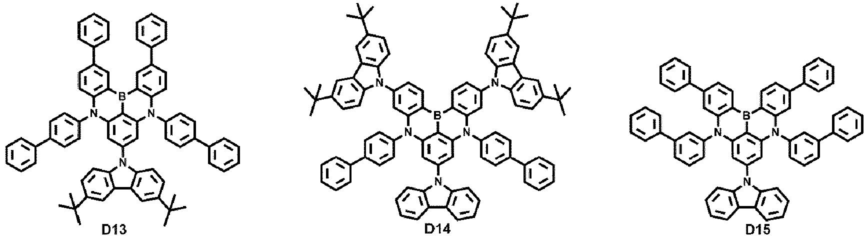

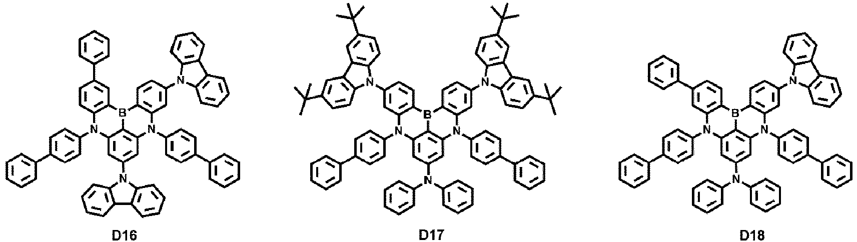

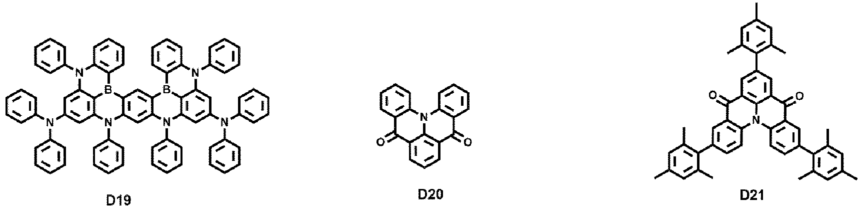

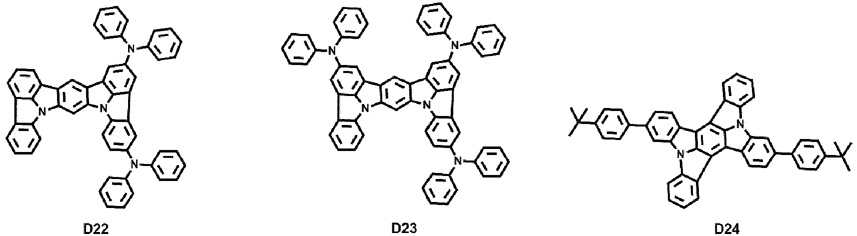

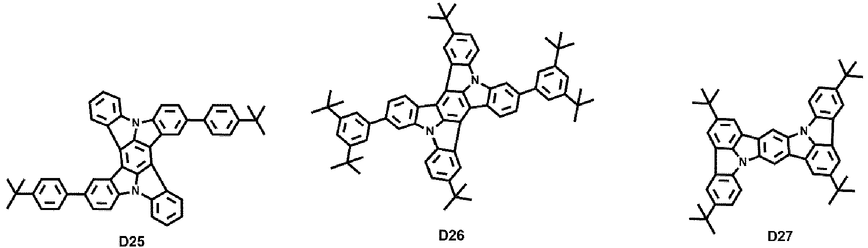

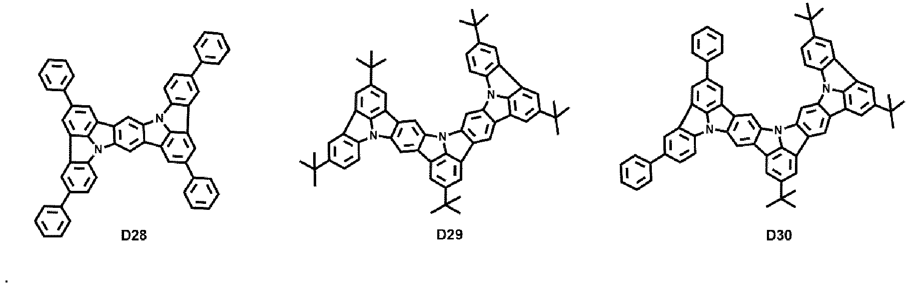

### Description of FIGURE

FIGURE is a schematic cross-sectional view of an organic light-emitting device 10 according to an embodiment. Hereinafter, the structure and manufacturing method of the organic light-emitting device 10 according to an embodiment of the disclosure will be described in connection with FIGURE.

In FIGURE, an organic light-emitting device 10 includes a first electrode 11, a second electrode 19 facing the first electrode 11, and an interlayer 10A between the first electrode 11 and the second electrode 19.

In FIGURE, the interlayer 10A includes an emission layer 15, a hole transport region 12 is between the first electrode 11 and an emission layer 15, and an electron transport region 17 is between the emission layer 15 and the second electrode 19.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and water repellency.

### [First electrode 11]

The first electrode 11 may be produced by depositing or sputtering, onto the substrate, a material for forming the first electrode 11. The first electrode 11 may be an anode. The material for forming the first electrode 11 may include materials with a high work function to facilitate hole injection.

The first electrode 11 may be a reflective electrode, a semi-transmissive electrode, or a transmissive electrode. When the first electrode 11 is a transmissive electrode, the material for forming the first electrode 11 may include indium tin oxide (ITO), indium zinc oxide (IZO), tin oxide (SnO₂), zinc oxide (ZnO), or any combinations thereof. In some embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 11 may have a single-layered structure or a multi-layered structure including a plurality of layers.

### [Emission layer 15]

A thickness of the emission layer 15 may be in a range of about 100 Å to about 1,000 Å, for example, about 200 Å to about 600 Å. When the thickness of the emission layer is within these ranges, excellent light-emission characteristics may be obtained without a substantial increase in driving voltage.

In an embodiment, the condensed polycyclic compound described above may be included in the emission layer 15. The emission layer 15 may have a feature described in the first and second embodiments.

The emission layer 15 may further include a host as described above in addition to the condensed polycyclic compound, sensitizer, and emitter described above.

### [Hole transport region 12]

The hole transport region 12 may be located between the first electrode 11 and the emission layer 15 of the organic light-emitting device 10.

The hole transport region 12 may have a single-layered structure or a multi-layered structure.

For example, the hole transport region 12 may have a hole injection layer, a hole transport layer, a hole injection layer/hole transport layer structure, a hole injection layer/first hole transport layer/second hole transport layer structure, a hole injection layer/first hole transport layer/second hole transport layer/electron-blocking layer structure, a hole transport layer/organic layer structure, a hole injection layer/hole transport layer/organic layer structure, a hole transport layer/electron-blocking layer structure, or a hole injection layer/hole transport layer/electron-blocking layer structure.

The hole transport region 12 may include any compound having hole-transporting properties.

For example, the hole transport region 12 may include an amine-based compound.

In an embodiment, the hole transport region 12 may include, for example, m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), one of a compound represented by Formula 201 to a compound represented by Formula 205, or any combination thereof: 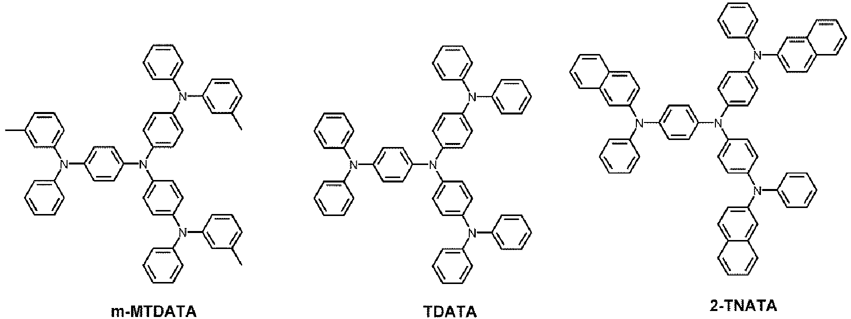 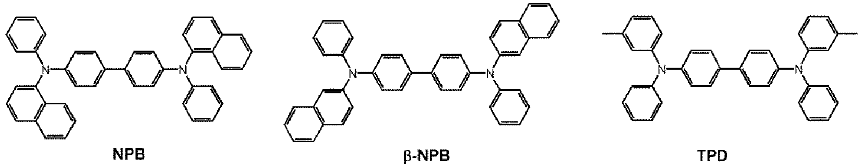 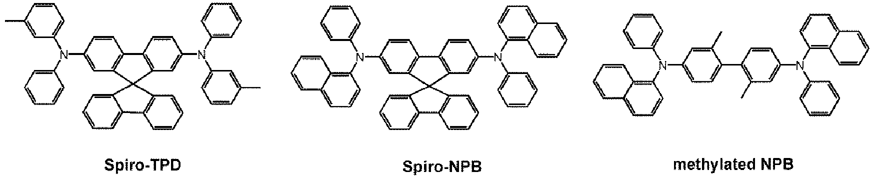 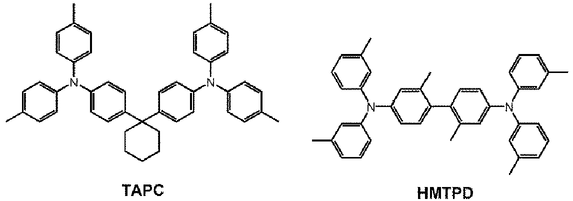 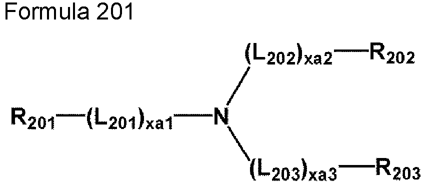 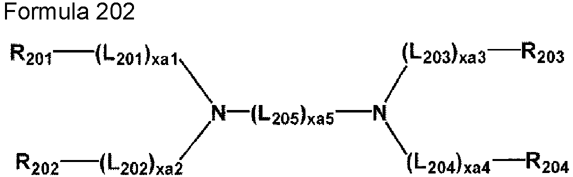 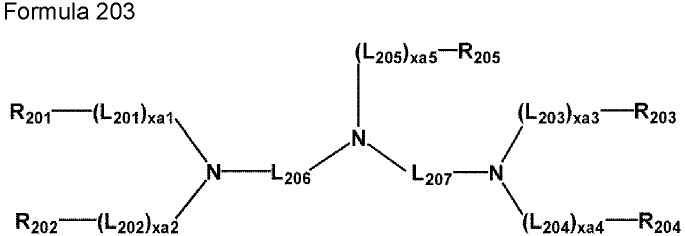 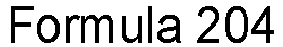 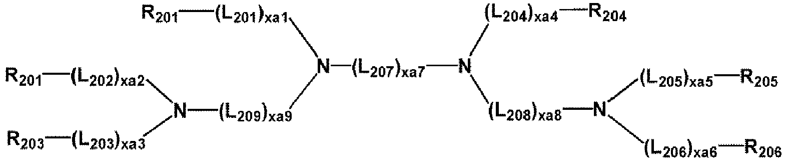 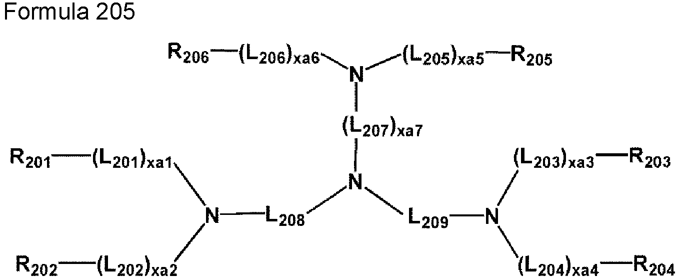 wherein, in Formulae 201 to 205,
L₂₀₁ to L₂₀₉ may each independently be *- O-*', *-S-*', a substituted or unsubstituted C₅-C₆₀ carbocyclic group, or a substituted or unsubstituted C₁-C₆₀ heterocyclic group,
xa1 to xa9 may each independently be an integer from 0 to 5, and
R₂₀₁ to R₂₀₆ may each independently be a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, wherein neighboring two groups of R₂₀₁ to R₂₀₆ may optionally be linked to each other via a single bond, a dimethyl-methylene group, or a diphenyl-methylene group.

For example,
L₂₀₁ to L₂₀₉ may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, or a triindolobenzene group, each unsubstituted or substituted with deuterium, a C₁-C₁₀ alkyl group, a C₁-C₁₀ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, a quarterphenyl group, -Si(Q₁₁)(Q₁₂)(Q₁₃), or any combination thereof,
xa1 to xa9 may each independently be 0, 1, or 2,
R₂₀₁ to R₂₀₆ may each independently be a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an indenocarbazolyl group, an indolocarbazolyl group, a benzofurocarbazolyl group, or a benzothienocarbazolyl group, each unsubstituted or substituted with deuterium, -F, -Cl, -Br, -I, a hydroxyl group, a cyano group, a nitro group, an amidino group, a hydrazine group, a hydrazone group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), -N(Q₃₁)(Q₃₂), or any combination thereof, and
Q₁₁ to Q₁₃ and Q₃₁ to Q₃₃ may each independently be a C₁-C₁₀ alkyl group, a C₁-C₁₀ alkoxy group, a phenyl group, a biphenyl group, a terphenyl group, or a naphthyl group.

In one or more embodiments, the hole transport region 12 may include a carbazole-containing amine-based compound.

In an embodiment, the hole transport region 12 may include a carbazole-containing amine-based compound and a carbazole-free amine-based compound.

The carbazole-containing amine-based compound may include, for example, compounds represented by Formula 201 including a carbazole group and further including at least one of a dibenzofuran group, a dibenzothiophene group, a fluorene group, a spiro-bifluorene group, an indenocarbazole group, an indolocarbazole group, a benzofurocarbazole group, and a benzothienocarbazole group.

The carbazole-free amine-based compound may include, for example, compounds represented by Formula 201 not including a carbazole group and including at least one of a dibenzofuran group, a dibenzothiophene group, a fluorene group, a spiro-bifluorene group, an indenocarbazole group, an indolocarbazole group, a benzofurocarbazole group, and a benzothienocarbazole group.

In one or more embodiments, the hole transport region 12 may include a compound represented by Formula 201, a compound represented by Formula 202, or any combination thereof.

In an embodiment, the hole transport region 12 may include a compound represented by Formula 201-1, 202-1, or 201-2, or any combination thereof: 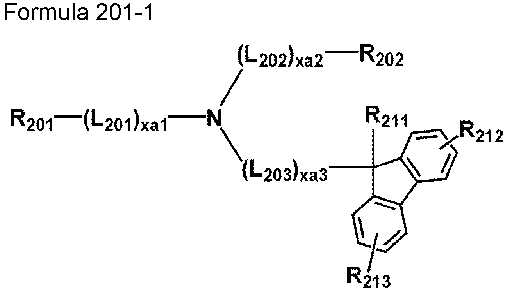 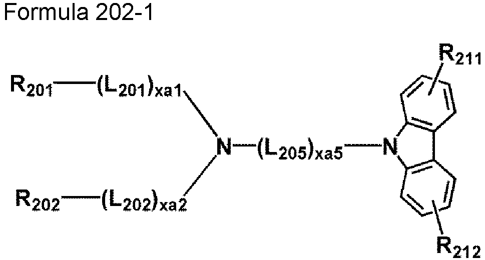 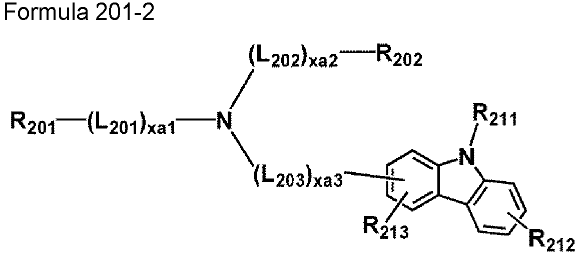 wherein, in Formulae 201-1, 202-1, and 201-2, L₂₀₁ to L₂₀₃, L₂₀₅, xa1 to xa3, xa5, R₂₀₁ and R₂₀₂ are each the same as described herein, and R₂₁₁ to R₂₁₃ may each independently be hydrogen, deuterium, -F, -Cl, -Br, -I, a hydroxyl group, a cyano group, a nitro group, an amidino group, a hydrazine group, a hydrazone group, a C₁-C₂₀ alkyl group, a C₁-C₂₀ alkoxy group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a dimethylfluorenyl group, a diphenylfluorenyl group, a triphenylenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, or a pyridinyl group.

In an embodiment, the hole transport region 12 may include one of Compounds HT1 to HT39 or any combination thereof:

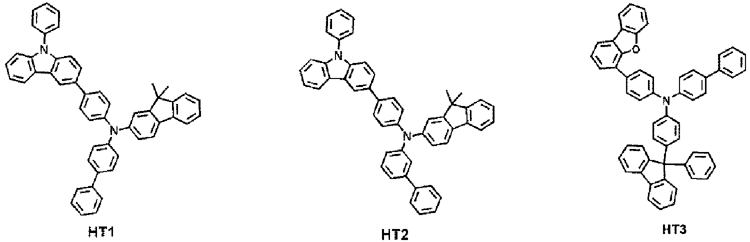

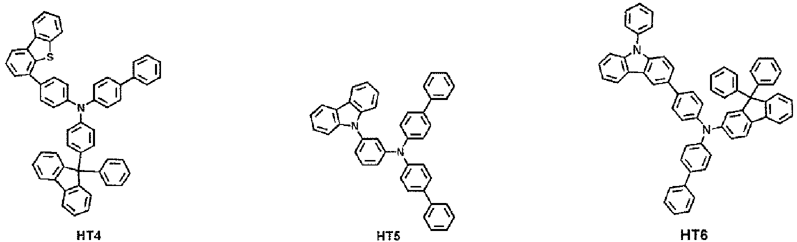

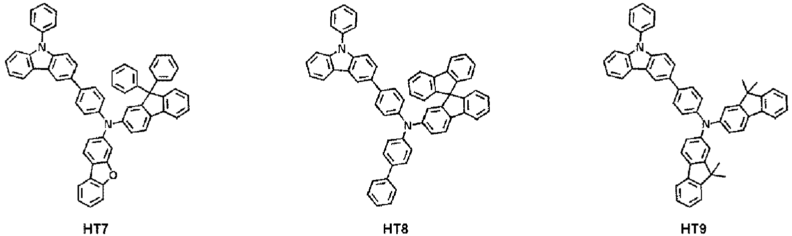

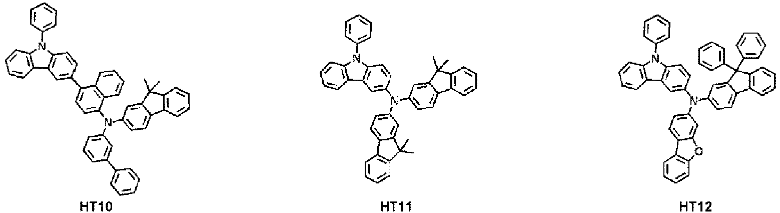

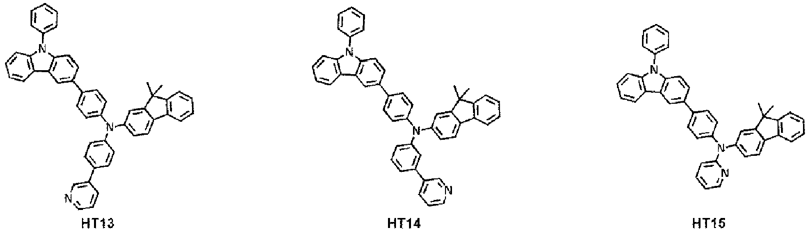

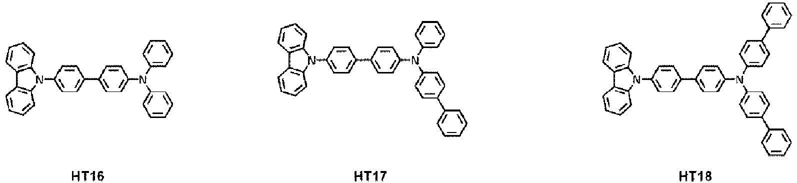

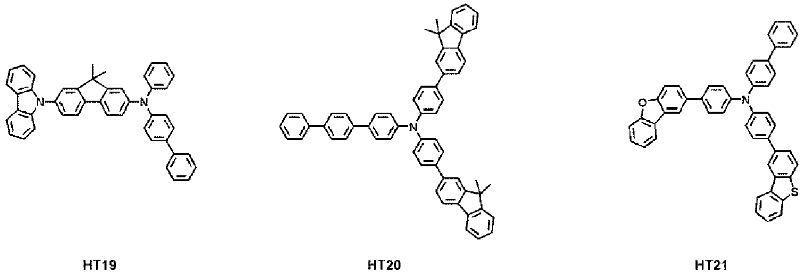

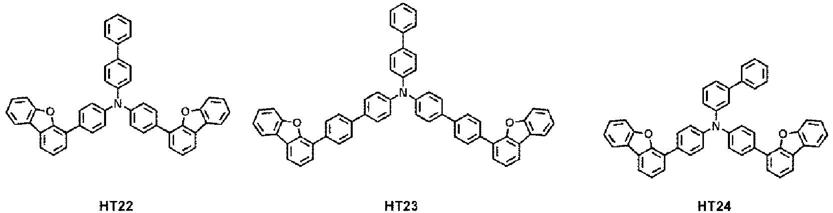

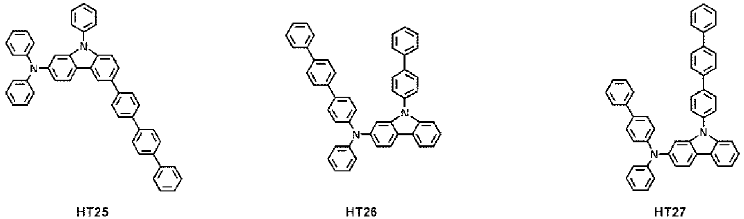

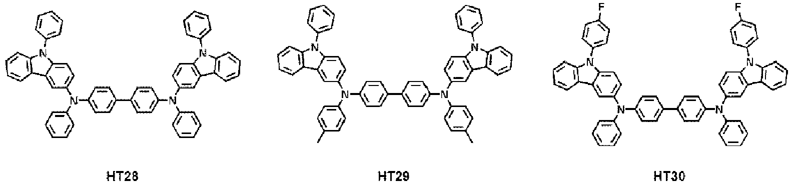

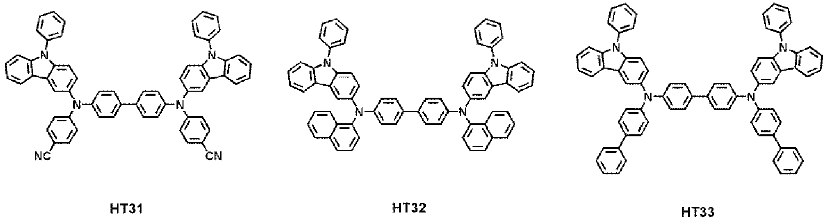

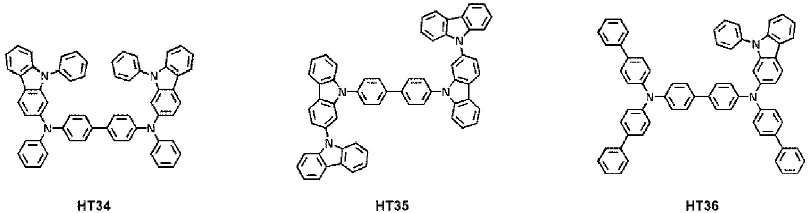

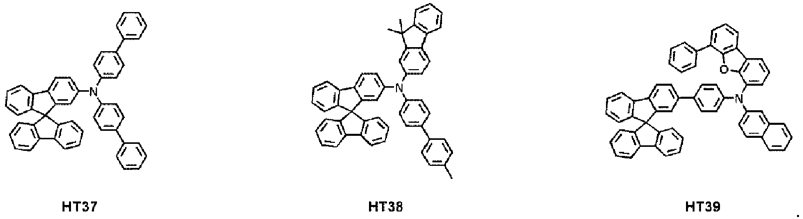

In one or more embodiments, the hole transport region 12 of the organic light-emitting device 10 may further include a p-dopant. When the hole transport region 12 further includes a p-dopant, the hole transport region 12 may have a matrix (for example, at least one of compounds represented by Formulae 201 to 205) and a p-dopant included in the matrix. The p-dopant may be uniformly or non-uniformly doped in the hole transport region 12.

In an embodiment, the LUMO energy level of the p-dopant may be -3.5 eV or less.

The p-dopant may include a quinone derivative, a metal oxide, a cyano group-containing compound, or any combination thereof.

In an embodiment, the p-dopant may include:
a quinone derivative, such as tetracyanoquinodimethane (TCNQ), 2,3,5,6-tetrafluoro-7,7,8,8-tetracyanoquinodimethane (F4-TCNQ), and F6-TCNNQ;
a metal oxide, such as tungsten oxide or molybdenum oxide;
1,4,5,8,9,12-hexaazatriphenylene-hexacarbonitrile (HAT-CN);
a compound represented by Formula 221; or
any combination thereof: 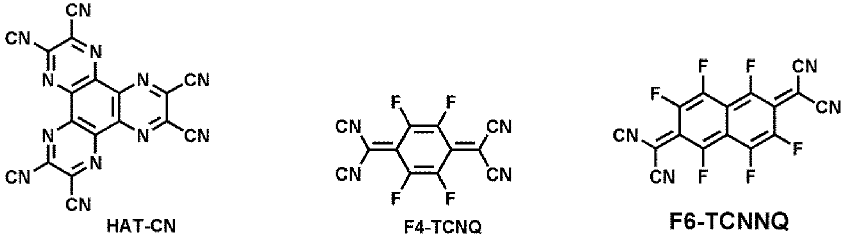 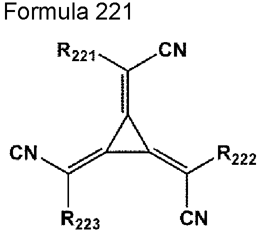
wherein, in Formula 221,
R₂₂₁ to R₂₂₃ may each independently be a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, wherein at least one substituent of R₂₂₁ to R₂₂₃ may be: a cyano group; -F; -Cl; -Br; -I; a C₁-C₂₀ alkyl group substituted with -F; a C₁-C₂₀ alkyl group substituted with -Cl; a C₁-C₂₀ alkyl group substituted with -Br; a C₁-C₂₀ alkyl group substituted with -I; or any combination thereof.

The compound represented by Formula 221 may include, for example, Compound HT-D2:

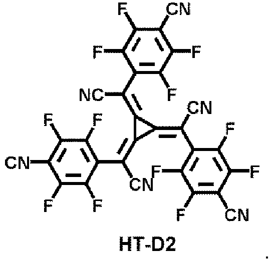

The hole transport region 12 may have a thickness of about 100 Å to about 10,000 Å, for example, about 400 Å to about 2000 Å, and the emission layer 15 may have a thickness of about 100 Å to about 3,000 Å, for example, about 300 Å to about 1,000 Å. When the thickness of each of the hole transport region 12 and the emission layer 15 is within these ranges described above, satisfactory hole transportation characteristics and/or luminescent characteristics may be obtained without a substantial increase in driving voltage.

The hole transport region 12 may further include a buffer layer.

Also, the buffer layer may compensate for an optical resonance distance according to a wavelength of light emitted from the emission layer, and thus, efficiency of a formed organic light-emitting device may be improved.

The hole transport region 12 may further include an electron-blocking layer. The electron-blocking layer may include a known material, for example, mCP or DBFPO:

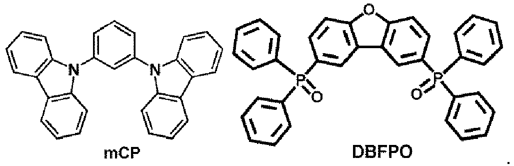

### [Electron transport region 17]

The electron transport region 17 is placed between the emission layer 15 and the second electrode 19 of the organic light-emitting device 10.

The electron transport region 17 may have a single-layered structure or a multi-layered structure.

For example, the electron transport region 17 may have an electron transport layer, an electron transport layer/electron injection layer structure, a buffer layer/electron transport layer structure, hole-blocking layer/electron transport layer structure, a buffer layer/electron transport layer/electron injection layer structure, or a hole-blocking layer/electron transport layer/electron injection layer structure. The electron transport region 17 may further include an electron control layer.

The electron transport region 17 may include known electron-transporting materials.

The electron transport region 17 (for example, a buffer layer, a hole-blocking layer, an electron control layer, or an electron transport layer in the electron transport region) may include a metal-free compound containing at least one π electron-depleted nitrogen-containing C₁-C₆₀ cyclic group. The π electron-depleted nitrogen-containing C₁-C₆₀ cyclic group is the same as described above.

For example, the electron transport region 17 may include a compound represented by Formula 601:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₅-C₆₀ carbocyclic group unsubstituted or substituted with at least one R₆₀₁ₐ or a C₁-C₆₀ heterocyclic group unsubstituted or substituted with at least one R₆₀₁ₐ,
xe11 may be 1, 2, or 3,
xe1 may be an integer from 0 to 5,
R₆₀₁ₐ and R₆₀₁ may each independently be a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer from 1 to 5.

In an embodiment, at least one of Ar₆₀₁ in the number of xe11 and R₆₀₁ in the number of xe21 may include the π electron-depleted nitrogen-containing C₁-C₆₀ cyclic group.

In an embodiment, Ar₆₀₁ and L₆₀₁ in Formula 601 may each independently be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, a benzoisothiazole group, a benzoxazole group, a benzoisoxazole group, a triazole group, a tetrazole group, an oxadiazole group, a triazine group, a thiadiazole group, an imidazopyridine group, an imidazopyrimidine group, or an azacarbazole group, each unsubstituted or substituted with deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), -P(=O)(Q₃₁)(Q₃₂), or any combination thereof,
Q₃₁ to Q₃₃ may each independently be a C₁-C₁₀ alkyl group, a C₁-C₁₀ alkoxy group, a phenyl group, a biphenyl group, a terphenyl group, or a naphthyl group.

When xe11 in Formula 601 is 2 or more, two or more of Ar₆₀₁ may be linked to each other via a single bond.

In one or more embodiments, Ar₆₀₁ in Formula 601 may be an anthracene group.

In one or more embodiments, the compound represented by Formula 601 may be represented by Formula 601-1: 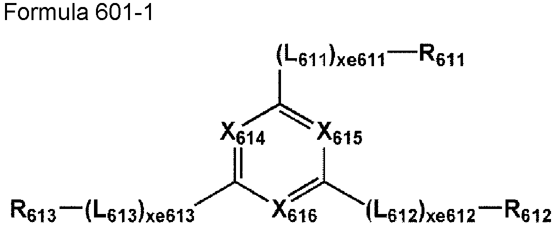 wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each independently be the same as described in connection with L₆₀₁,
xe611 to xe613 may each independently be the same as described in connection with xe1,
R₆₁₁ to R₆₁₃ may each independently be the same as described in connection with R₆₀₁, and
R₆₁₄ to R₆₁₆ may each independently be hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, or a naphthyl group.

In one or more embodiments, xe1 and xe611 to xe613 in Formulae 601 and 601-1 may each independently be 0, 1, or 2.

In one or more embodiments, R₆₀₁ and R₆₁₁ to R₆₁₃ in Formulae 601 and 601-1 may each independently be: a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzoisothiazolyl group, a benzoxazolyl group, a benzoisoxazolyl group, a triazolyl group, a tetrazolyl group, an imidazopyridinyl group, an imidazopyrimidinyl group, or an azacarbazolyl group, each unsubstituted or substituted with deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzoisothiazolyl group, a benzoxazolyl group, a benzoisoxazolyl group, a triazolyl group, a tetrazolyl group, an imidazopyridinyl group, an imidazopyrimidinyl group, an azacarbazolyl group, or any combination thereof; or
-S(=O)₂(Q₆₀₁), or -P(=O)(Q₆₀₁)(Q₆₀₂), and
Q₆₀₁ and Q₆₀₂ are the same as described above.

The electron transport region 17 may include one of Compounds ET1 to ET36 or any combination thereof:

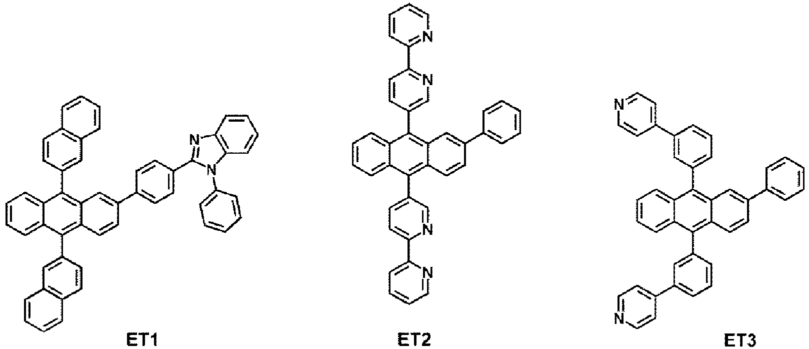

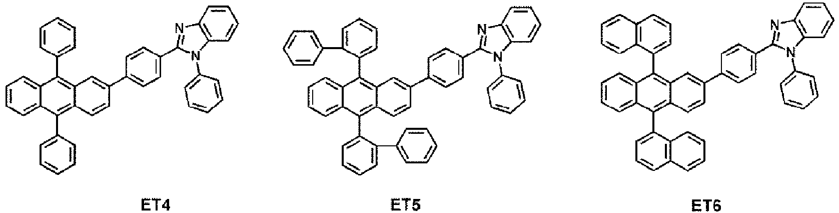

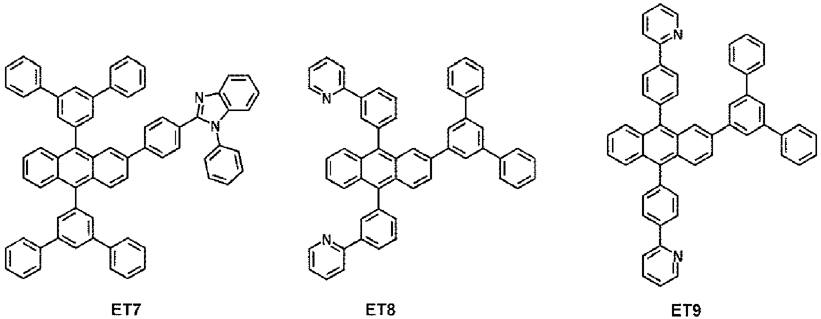

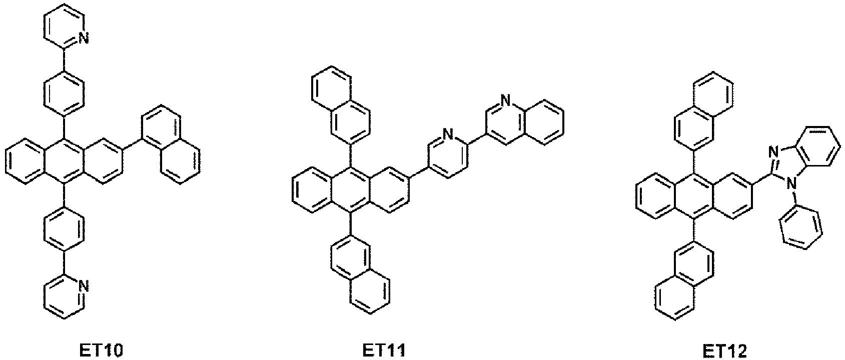

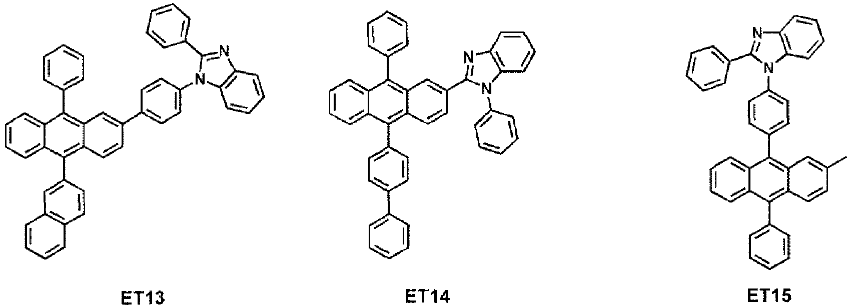

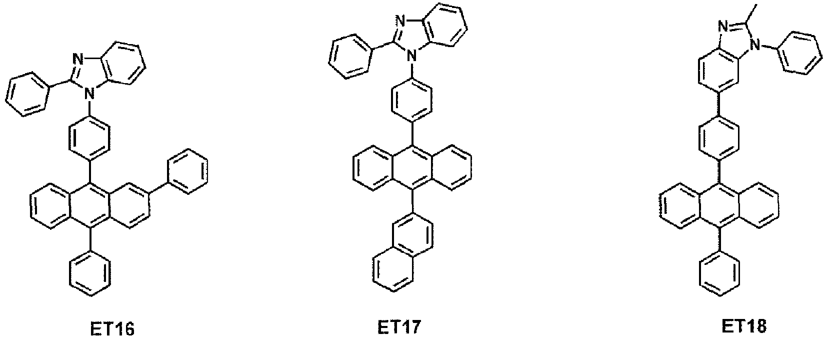

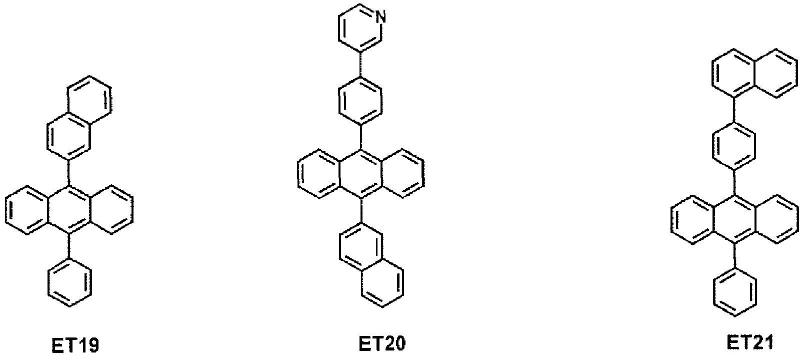

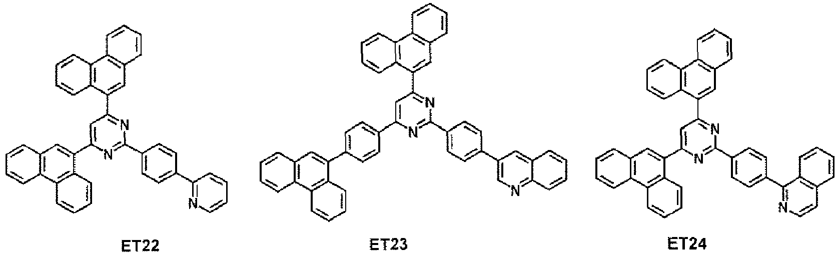

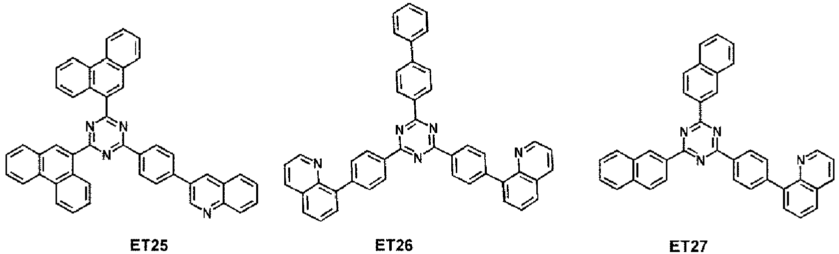

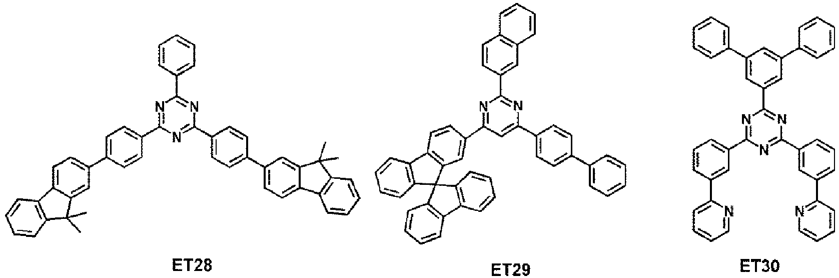

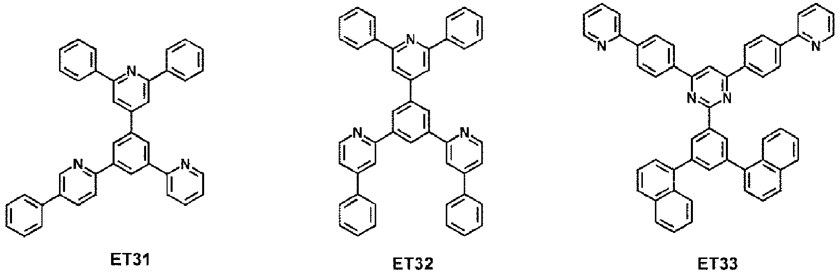

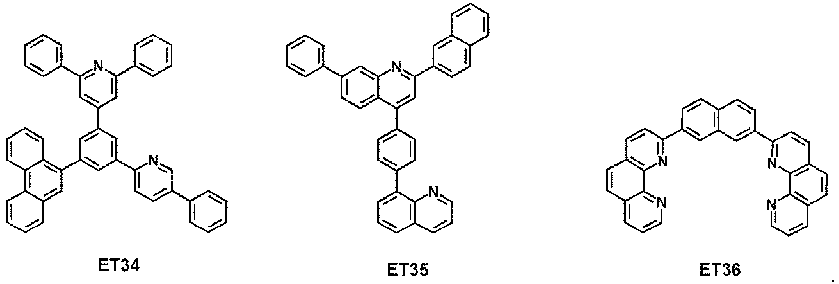

In one or more embodiments, the electron transport region 17 may include 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-tert-butylphenyl)-4-phenyl-4H-1,2,4-triazole (TAZ), NTAZ, DBFPO, or any combination thereof. For example, when the electron transport region 17 includes a hole-blocking layer, the hole-blocking layer may include BCP or Bphen:

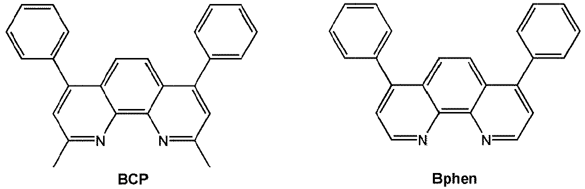

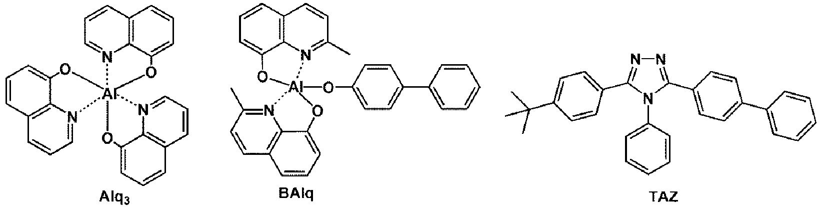

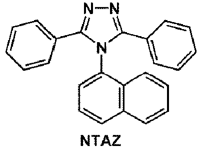

Thicknesses of the buffer layer, the hole-blocking layer, and the electron control layer may each independently be in the range of about 20 Å to about 1,000 Å, for example, about 30 Å to about 300 Å. When the thicknesses of the buffer layer, the hole-blocking layer, and the electron control layer are within these ranges, excellent hole blocking characteristics or excellent electron control characteristics may be obtained without a substantial increase in driving voltage.

A thickness of the electron transport layer may be in the range of about 100 Å to about 1,000 Å, for example, about 150 Å to about 500 Å. When the thickness of the electron transport layer is within the range described above, the electron transport layer may have satisfactory electron-transporting characteristics without a substantial increase in driving voltage.

The electron transport region 17 (for example, the electron transport layer in the electron transport region 17) may further include, in addition to the materials described above, a metal-containing material.

The metal-containing material may include an alkali metal complex, an alkaline earth metal complex, or any combination thereof. A metal ion of the alkali metal complex may include a Li ion, a Na ion, a K ion, a Rb ion, a Cs ion, or any combination thereof, and a metal ion of the alkaline earth metal complex may include a Be ion, a Mg ion, a Ca ion, a Sr ion, a Ba ion, or any combination thereof. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxydiphenyloxadiazole, a hydroxydiphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In an embodiment, the metal-containing material may include a Li complex. The Li complex may include, for example, Compound ET-D1 (LiQ) or ET-D2:

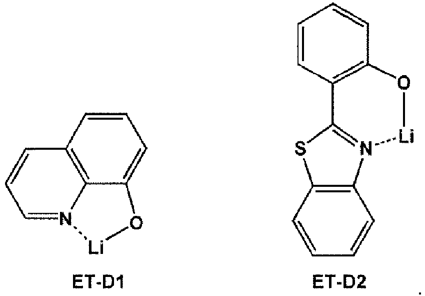

The electron transport region 17 may include an electron injection layer that facilitates the injection of electrons from the second electrode 19. The electron injection layer may directly contact the second electrode 19.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof.

The alkali metal may include Li, Na, K, Rb, Cs, or any combination thereof. In an embodiment, the alkali metal may be Li, Na, or Cs. In one or more embodiments, the alkali metal may be Li or Cs.

The alkaline earth metal may include Mg, Ca, Sr, Ba, or any combination thereof.

The rare earth metal may include Sc, Y, Ce, Tb, Yb, Gd, or any combination thereof.

The alkali metal compound, the alkaline earth metal compound, and the rare earth metal compound may include oxides and halides (for example, fluorides, chlorides, bromides, or iodides) of the alkali metal, the alkaline earth metal, and the rare earth metal, or any combination thereof.

The alkali metal compound may include: one of alkali metal oxides such as Li₂O, Cs₂O, or K₂O; one of alkali metal halides such as LiF, NaF, CsF, KF, Lil, Nal, Csl, or Kl; or any combination thereof. In an embodiment, the alkali metal compound may include LiF, Li₂O, NaF, Lil, Nal, Csl, Kl, or any combination thereof.

The alkaline earth-metal compound may include one of alkaline earth-metal compounds, such as BaO, SrO, CaO, BaₓSr₁₋ₓO (wherein 0<x<1), or BaₓCa₁₋ₓO (wherein 0<x<1), or any combination thereof. In an embodiment, the alkaline earth metal compound may include BaO, SrO, CaO, or any combination thereof.

The rare earth metal compound may include YbF₃, ScF₃, ScO₃, Y₂O₃, Ce₂O₃, GdF₃, TbF₃, or any combination thereof. In an embodiment, the rare earth metal compound may include YbF₃, ScF₃, TbF₃, YbI₃, ScI₃, TbI₃, or any combination thereof.

The alkali metal complex, the alkaline earth metal complex, and the rare earth metal complex may include an ion of alkali metal, alkaline earth metal, and rare earth metal as described above, and a ligand coordinated with a metal ion of the alkali metal complex, the alkaline earth metal complex, or the rare earth metal complex may include hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, cyclopentadiene, or any combination thereof.

The electron injection layer may further include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof, as described above. In one or more embodiments, the electron injection layer may further include an organic material. When the electron injection layer further includes an organic material, an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof may be homogeneously or non-homogeneously dispersed in a matrix including the organic material.

A thickness of the electron injection layer may be in a range of about 1 Å to about 100 Å, and, for example, about 3 Å to about 90 Å. When the thickness of the electron injection layer is within the ranges described above, satisfactory electron injection characteristics may be obtained without a substantial increase in driving voltage.

### [Second electrode 19]

The second electrode 19 is arranged on the aforementioned interlayer 10A. The second electrode 19 may be a cathode which is an electron injection electrode, and in this regard, a material for forming the second electrode 19 may be selected from a metal, an alloy, an electrically conductive compound, and a combination thereof, which have a relatively low work function.

The second electrode 19 may include lithium (Li), silver (Ag), magnesium (Mg), aluminum (Al), aluminum-lithium (Al-Li), calcium (Ca), magnesium-indium (Mg-In), magnesium-silver (Mg-Ag), ITO, IZO, or any combination thereof. The second electrode 19 may be a transmissive electrode, a semi-transmissive electrode, or a reflective electrode.

The second electrode 19 may have a single-layered structure having a single layer or a multi-layered structure including two or more layers.

### Explanation of terms

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or any combination thereof.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, a propoxy group, a butoxy group, and a pentoxy group.

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof include an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the term "C₃-C₁₀ cycloalkylene group" as used herein refers to a divalent group having the same structure as the C₃-C₁₀ cycloalkyl group.

Examples of the C₃-C₁₀ cycloalkyl group are a cyclopropyl group, a cyclobutyl group, a cyclopentyl, cyclohexyl group, a cycloheptyl group, a cyclooctyl group, an adamantanyl group, a norbornanyl group (a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monovalent monocyclic group that includes at least one heteroatom selected from N, O, P, Si, S, Se, Ge, and B as a ring-forming atom and 1 to 10 carbon atoms, and the term "the C₁-C₁₀ heterocycloalkylene group" as used herein refers to a divalent group having the same structure as the C₁-C₁₀ heterocycloalkyl group.

Examples of the C₁-C₁₀ heterocycloalkyl group are a silolanyl group, a silinanyl group, tetrahydrofuranyl group, a tetrahydro-2H-pyranyl group, and a tetrahydrothiophenyl group.

The term "C₃-C₁₀ cycloalkenyl group" as used herein refers to a monovalent cyclic group that includes 3 to 10 carbon atoms and at least one carbon-carbon double bond in the ring thereof and has no aromaticity, and examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, S, Se, Ge, and B as a ring-forming atom, 1 to 10 carbon atoms, and at least one carbon-carbon double bond in its ring. Examples of the C₁-C₁₀ heterocycloalkenyl group are a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₁-C₆₀ heteroaryl group" as used herein refers to a monovalent group that includes a heterocyclic aromatic system having at least one heteroatom selected from N, O, P, Si, S, Se, Ge, and B as a ring-forming atom and 1 to 60 carbon atoms as a ring-forming atoms, and the term "C₁-C₆₀ heteroarylene group" as used herein refers to a divalent group that includes a heterocyclic aromatic system having at least one heteroatom selected from N, O, P, Si, S, Se, Ge, and B as a ring-forming atom and 1 to 60 carbon atoms as a ring-forming atom. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

The term "C₆-C₆₀ aryloxy group" as used herein indicates -OA₁₀₂ (wherein A₁₀₂ is the C₆-C₆₀ aryl group), and the term "C₆-C₆₀ arylthio group" as used herein indicates -SA₁₀₃ (wherein A₁₀₃ is the C₆-C₆₀ aryl group).

The term "monovalent non-aromatic condensed polycyclic group" as used herein refers to a monovalent group having two or more rings condensed and only carbon atoms (for example, the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group having two or more rings condensed with each other, a heteroatom selected from N, O, P, Si, S, Se, Ge, and B, other than carbon atoms (for example, having 1 to 60 carbon atoms), as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group described above.

The term "π electron-depleted nitrogen-containing C₁-C₆₀ cyclic group" as used herein refers to a cyclic group having 1 to 60 carbon atoms and including at least one *-N=*' (wherein * and *' each indicate a binding site to an adjacent atom) as a ring-forming moiety. For example, the π electron-depleted nitrogen-containing C₁-C₆₀ cyclic group may be a) a first ring, b) a condensed ring in which at least two first rings are condensed, or c) a condensed ring in which at least one first ring and at least one second ring are condensed.

The term "π electron-rich C₃-C₆₀ cyclic group" as used herein refers to a cyclic group having 3 to 60 carbon atoms and not including at least one *-N=*' (wherein * and *' each indicate a binding site to an adjacent atom) as a ring-forming moiety. For example, the π electron-rich C₃-C₆₀ cyclic group may be a) a second ring or b) a condensed ring in which at least two second rings are condensed.

The term "C₅-C₆₀ carbocyclic group" and "C₅-C₃₀ carbocyclic group" as used herein refers to a monocyclic or polycyclic group only having 5 to 60 or 5 to 30 carbon atoms as a ring-forming atom, respectively, and may be, for example, a) a third ring or b) a condensed ring in which two or more third rings are condensed with each other.

The term "C₁-C₆₀ heterocyclic group" and "C₁-C₃₀ heterocyclic group" as used herein refers to a monocyclic or polycyclic group that has 1 to 60 or or 1 to 30 carbon atoms and at least one heteroatom selected from N, O, P, Si, S, Se, Ge, and B as a ring-forming atom, respectively, and may be, for example, a) a fourth ring, b) a condensed ring in which two or more fourth rings are condensed with each other, or c) a condensed ring in which at least one third ring is condensed with at least one fourth ring.

The "first ring" as used herein may be an imidazole group, a pyrazole group, a thiazole group, an isothiazole group, an oxazole group, an isoxazole group, a pyridine group, a pyrazine group, a pyridazine group, a pyrimidine group, a triazole group, a tetrazole group, an oxadiazole group, a triazine group, or a thiadiazole group.

The "second ring" as used herein may be a benzene group, a cyclopentadiene group, a pyrrole group, a furan group, a thiophene group, or a silole group.

The "third ring" as used herein may be a cyclopentane group, a cyclopentadiene group, an indene group, an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclohexane group, a cyclohexene group, or a benzene group.

The "fourth ring" as used herein may be a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, a triazasilole group, a pyridine group, a pyrimidine group, a pyrazine group, a pyridazine group, or a triazine group.

In some embodiments, the π electron-depleted nitrogen-containing C₁-C₆₀ cyclic group may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, a benzoisothiazole group, a benzoxazole group, a benzoisoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, an acridine group, or a pyridopyrazine group.

In some embodiments, the π electron-rich C₃-C₆₀ cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, an indene group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a carbazole group, a dibenzosilole group, an indenocarbazole group, an indolocarbazole group, a benzofurocarbazole group, a benzothienocarbazole group, a benzosilolocarbazole group, a triindolobenzene group, a pyrrolophenanthrene group, a furanophenanthrene group, a thienophenanthrene group, a benzonaphthofuran group, a benzonapthothiophene group, an indolophenanthrene group, a benzofuranophenanthrene group, or a benzothienophenanthrene group.

For example, the C₅-C₆₀ carbocyclic group or the C₅-C₃₀ carbocyclic group may be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, an indene group, a fluorene group, a 5,6,7,8-tetrahydroisoquinoline group, a 5,6,7,8-tetrahydroquinoline group, an adamantane group, a norbornane group, or a norbornene group.

For example, the C₁-C₆₀ heterocyclic group or the C₁-C₃₀ heterocyclic group may be a thiophene group, a furan group, a pyrrole group, a cyclopentadiene group, a silole group, a borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group.

The terms "a π electron-depleted nitrogen-containing C₁-C₆₀ cyclic group, a π electron-rich C₃-C₆₀ cyclic group, a C₅-C₆₀ carbocyclic group, a C₅-C₃₀ carbocyclic group, a C₁-C₆₀ heterocyclic group, and a C₁-C₃₀ heterocyclic group" as used herein each refer to a part of a condensed ring or a monovalent, a divalent, a trivalent, a tetravalent, a pentavalent, or a hexavalent group, depending on the formula structure.

Substituents of the substituted π electron-depleted nitrogen-containing C₁-C₆₀ cyclic group, the substituted π electron-rich C₃-C₆₀ cyclic group, the substituted C₅-C₆₀ carbocyclic group, the substituted C₅-C₃₀ carbocyclic group, the substituted C₁-C₆₀ heterocyclic group, the substituted C₁-C₃₀ heterocyclic group, the substituted C₁-C₆₀ alkylene group, the substituted C₂-C₆₀ alkenylene group, the substituted C₂-C₆₀ alkynylene group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, the substituted divalent non-aromatic condensed heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may each independently be:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkylheteroaryl group, a monovalent non-aromatic condensed polycyclic group, a monovalent non-aromatic condensed heteropolycyclic group, -N(Q₁₁)(Q₁₂),-Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkylheteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkylheteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
any combination thereof.
Q₁ to Q₉, Q₁₁ to Q₁₉, Q₂₁ to Q₂₉, and Q₃₁ to Q₃₉ used herein may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₈₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

For example, Q₁ to Q₉, Q₁₁ to Q₁₉, Q₂₁ to Q₂₉ and Q₃₁ to Q₃₉ described herein may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

The term "room temperature" used herein refers to a temperature of about 25 °C.

The terms "a biphenyl group, a terphenyl group, and a quaterphenyl group" used herein respectively refer to monovalent groups in which two, three, or four phenyl groups which are linked together via a single bond.

Hereinafter, a compound and a light-emitting device according to embodiments are described in detail with reference to Synthesis Examples and Examples. However, the compound and the light-emitting device are not limited thereto. The wording '"B' was used instead of 'A"' used in describing Synthesis Examples means that an amount of 'A' used was identical to an amount of 'B' used, in terms of a molar equivalent.

### [Examples]

### Synthesis Example 1 (Compound 1)

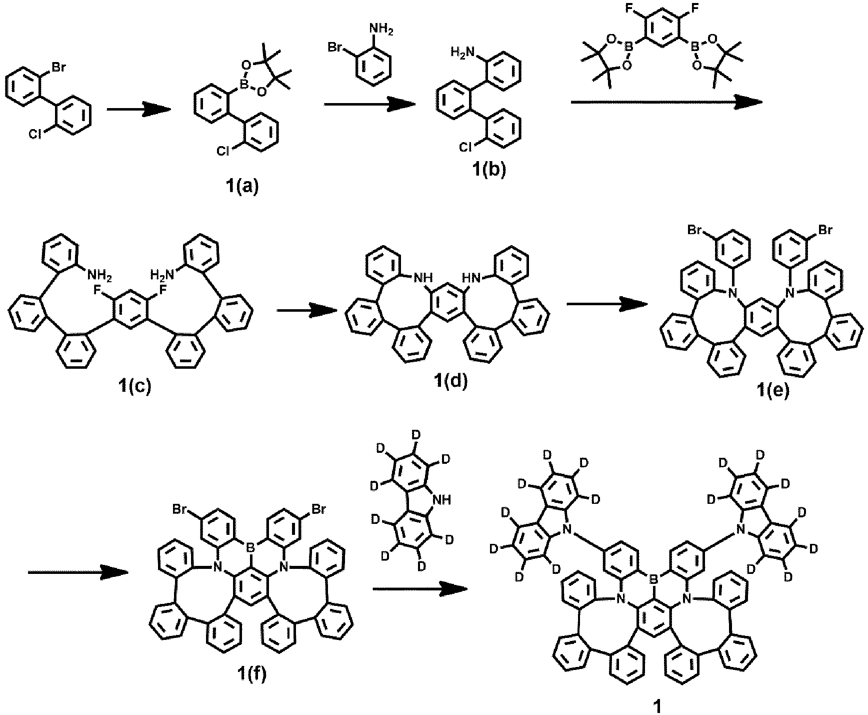

### Synthesis of Intermediate 1(a)

2-bromo-2'-chloro-1,1'-biphenyl (40.0 g, 149.50 mmol), bis(pinacolato)diboron (B₂pin₂) (58.236 g, 229.33 mmol), [1,1'-bis(diphenylphosphino)ferrocene]dichloropalladium(II) (PdCl₂(dppf)) (5.593 g, 7.64 mmol), potassium acetate (KOAc) (37.514 g, 382.21 mmol), and 300 ml of 1,4-dioxane were added into a round bottom flask, and the mixture was stirred while refluxing at 120 °C in a nitrogen atmosphere. After the reaction was completed, an organic solvent layer was concentrated and then purified by column chromatography to obtain Intermediate 1(a) (47 g, yield: 100 %).

LC-MS (calculated: 314.12 g/mol, found: 315.12 (M+1))

### Synthesis of Intermediate 1(b)

580 ml of a mixture of toluene and ethanol was added to Intermediate 1(a) (40.42 g, 128.68 mmol), 2-bromoaniline (20.0 g, 116.98 mmol), tetrakis(triphenylphosphine)palladium(0) (Pd(PPh₃)₄) (6.776 g, 5.85 mmol), and sodium carbonate (24.79 g, 233.96 mmol, 2.0eq) and then stirred at 80 °C. After the reaction was completed, a resultant product was cooled to room temperature and then subjected to an extraction process using distilled water and dichloromethane. Residual water was removed therefrom by using anhydrous magnesium sulfate, and the resultant product was filtered under reduced pressure. An organic layer thus obtained was concentrated under reduced pressure, and a solid obtained therefrom was separated and purified by column chromatography to obtain Intermediate 1(b) (14.22 g, yield: 44 %).

LC-MS (calculated: 279.08 g/mol, found: 280.08 (M+1))

### Synthesis of Intermediate 1(c)

Intermediate 1(c) (24.2 g, yield: 80 %) was synthesized in the same manner as in the synthesis of Intermediate 1(b) of Synthesis Example 1, except that Intermediate 1(b) (14.0 g, 50.16 mmol) and 2,2'-(4,6-difluoro-1,3-phenylene)bis(4,4,5,5-tetramethyl-1,3,2-dioxaborolane) (9.18 g, 25.08 mmol) were respectively used instead of 2-bromoaniline and Intermediate 1(a).

LC-MS (calculatd: 600.24 g/mol, found: 601.24 (M+1))

### Synthesis of Intermediate 1(d)

Intermediate1(c) (22.0 g, 36.65 mmol), potassium carbonate (10.131 g, 73.30 mmol), and N,N-dimethylformamide (0.1 M) were mixed and stirred at 110 °C. After the reaction was completed, the resultant product was cooled to room temperature, methanol was added thereto, and the mixture was filtered by using silica gel. After an organic layer thus obtained was concentrated and dissolved again in toluene, the organic layer was filtered by using silica gel and then concentrated. A resultant product obtained therefrom was recrystallized by using toluene to thereby obtain Intermediate 1(d) as a yellow solid (18.3 g, yield: 89 %).

LC- MS (calculated: 560.23 g/mol, found: 561.2 g/mol (M+1))

### Synthesis of Intermediate 1(e)

Intermediate 1(d) (8.00 g, 14.28 mmol), 1-bromo-3-iodobenzene (80.79 g, 285.6 mmol), cuprous iodide (5.44 g, 28.56 mmol), and 75 ml of tetraethoxysilane (TEOS) (0.2 M) were mixed and stirred at 155 °C for 18 hours. After the reaction was completed, and the resultant product was cooled to room temperature, dichlromethane was added thereto, and the mixture was filtered by using silica gel. An organic layer thus obtained was concentrated under reduced pressure, and a solid obtained therefrom was separated and purified by column chromatography to obtain Intermediate 1(e) (11.6 g, yield: 94 %).

LC-MS (calculated: 870.11 g/mol, found: 871.11 (M+1))

### Synthesis of Intermediate 1(f)

Intermediate 1(e) (3.0 g, 3.46 mmol), boron triiodide (Bl₃) (8.118 g, 20.73 mmol), and 20 ml of dichlorobenzene (0.2 M) were mixed and stirred at 155 °C for 5 hours. After the reaction was completed, the resultant product was quenched by using methanol and then filtered. An organic layer obtained through an extraction process using dichloromethane was concentrated under reduced pressure. A solid obtained therefrom was separated and purified by column chromatography to obtain Intermediate 1(f) (0.57 g, yield: 19 %).

LC-MS (calculated: 876.09 g/mol, found: 877.09 (M+1))

### Synthesis of Compound 1

Intermediate 1(f) (1.50 g, 1.71 mmol), carbazole-d8 (0.69 g, 3.94 mmol), tris(dibenzylideneacetone)dipalladium (Pd₂(dba)₃) (0.157 g, 0.17 mmol), sodium tertbutoxide (0.494 g, 5.14 mmol), S-phos (0.141 g, 0.34 mmol), and 10 ml of xylene (0.2 M) were mixed and stirred at 125 °C for 1 hour. After the reaction was completed, dichloromethane was added to the resultant product which was cooled to room temperature, and an organic layer obtained by filtration using silica gel was concentrated under reduced pressure. A solid obtained therefrom was separated and purified by column chromatography to obtain Compound 1 (1.2 g, yield: 66 %).

LC-MS (calculated: 1066.49 g/mol, found: 1067.49 (M+1))

### Synthesis Example 2 (Compound 2)

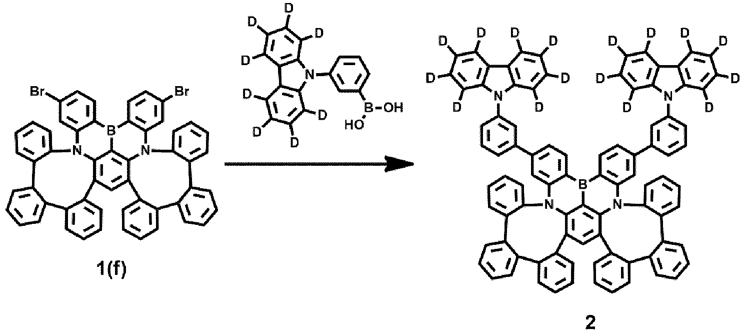

Compound 2 (1.67 g, yield: 80 %) was synthesized in the same manner as in the synthesis of Compound 1 of Synthesis Example 1, except that (3-(9H-carbazol-9-yl-d8)phenyl)boronic acid) (available from HANCHEM Co. Ltd) (1.162 g, 3.94 mmol) was used instead of carbazole-d8.

LC-MS (calculated: 1218.55 g/mol, found: 1219.55 (M+1))

### Synthesis Example 3 (Compound 3)

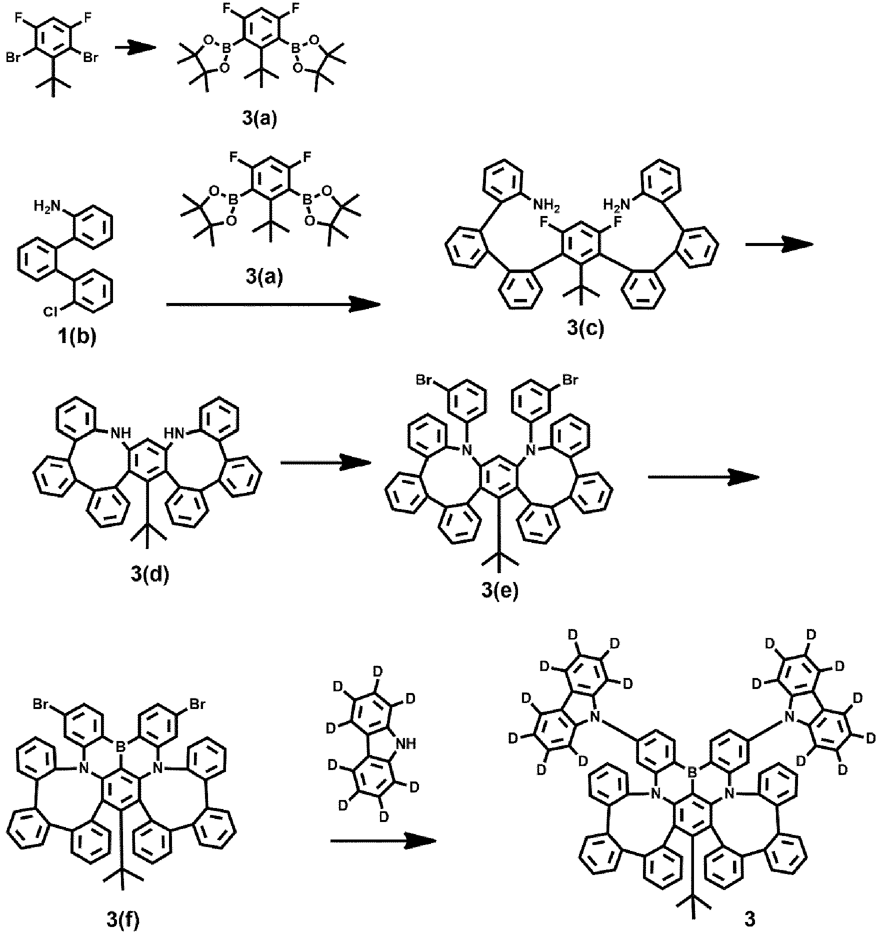

### Synthesis of Intermediate 3(a)

Intermediate 3(a) (32.1 g, yield: 99 %) was synthesized in the same manner as in the synthesis of Intermediate 1(a) of Synthesis Example 1, except that 2,4-dibromo-3-(tert-butyl)-1,5-difluorobenzene (25.0 g, 76.71 mmol) was used instead of 2-bromo-2'-chloro-1,1'-biphenyl.

LC-MS (calculated: 422.26 g/mol, found: 423.26 (M+1))

### Synthesis of Intermediate 3(c)

Intermediate 3(c) (24.2 g, yield: 74 %) was synthesized in the same manner as in the synthesis of Compound 1(c) of Synthesis Example 1, except that Intermediate 3(a) (21.183 g, 50.16 mmol) was used instead of 2,2'-(4,6-difluoro-1,3-phenylene)bis(4,4,5,5-tetramethyl-1,3,2-dioxaborolane).

LC-MS (calculated: 656.30 g/mol, found: 657.30 (M+1))

### Synthesis of Intermediate 3(d)

Intermediate 3(d) (7.4 g, yield: 79 %) was synthesized in the same manner as in the synthesis of Compound 1(d) of Synthesis Example 1, except that Intermediate 3(c) (10.0 g, 15.24 mmol) was used instead of Intermediate 1(c).

LC-MS (calculated: 616.29 g/mol, found: 617.29 (M+1))

### Synthesis of Intermediate 3(e)

Intermediate 3(e) (8.4 g, yield: 80 %) was synthesized in the same manner as in the synthesis of Compound 1(e) of Synthesis Example 1, except that Intermediate 3(d) (7.0 g, 11.36 mmol) was used instead of Intermediate 1(d).

LC-MS (calculated: 924.17 g/mol, found: 925.17 (M+1))

### Synthesis of Intermediate 3(f)

Intermediate 3(f) (0.34 g, yield: 17 %) was synthesized in the same manner as in the synthesis of Compound 1(f) of Synthesis Example 1, except that Intermediate 3(e) (2.0 g, 2.16 mmol) was used instead of Intermediate 1(e).

LC-MS (calculated: 932.16 g/mol, found: 933.16 (M+1))

### Synthesis of Compound 3

Compound 3 (0.96 g, yield: 80 %) was synthesized in the same manner as in the synthesis of Compound 1 of Synthesis Example 1, except that Intermediate 3(f) (1.0 g, 1.07 mmol) was used instead of Intermediate 1(f).

LC-MS (calculated: 1122.55 g/mol, found: 1123.55 (M+1))

### Synthesis Example 4 (Compound 4)

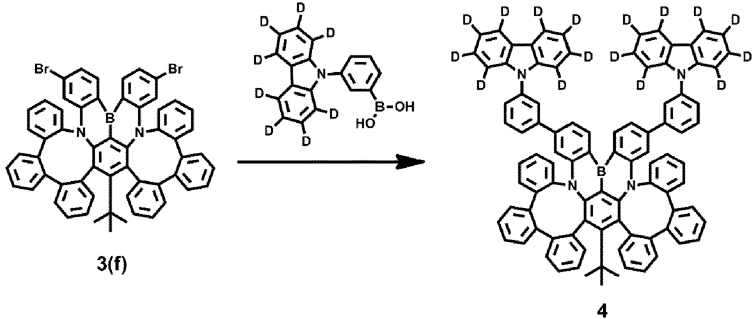

Compound 4 (0.78 g, yield: 57 %) was synthesized in the same manner as in the synthesis of Compound 2 of Synthesis Example 2, except that Intermediate 3(f) (1.0 g, 1.07 mmol) was used instead of Intermediate 1(f).

LC-MS (calculated: 1274.62 g/mol, found: 1275.62 (M+1))

### Synthesis Example 5 (Compound 5)

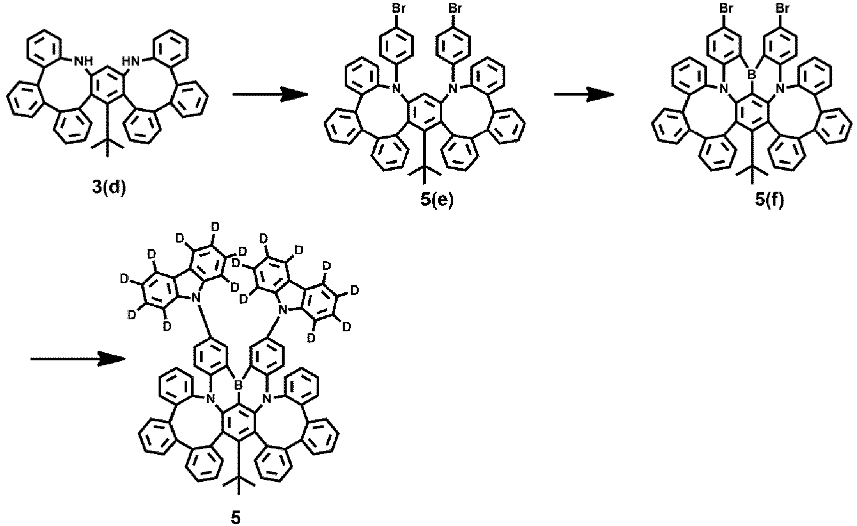

### Synthesis of Intermediate 5(e)

Intermediate 5(e) (9.2 g, yield: 88 %) was synthesized in the same manner as in the synthesis of Intermediate 3(e) of Synthesis Example 3, except that 1-bromo-4-iodobenzene (64.267 g, 227.17 mmol) was used instead of 1-bromo-3-iodobenzene.

LC-MS (calculated: 924.17 g/mol, found: 925.17 (M+1))

### Synthesis of Intermediate 5(f)

Intermediate 5(f) (0.18 g, yield: 20 %) was synthesized in the same manner as in the synthesis of Intermediate 1(f) of Synthesis Example 1, except that Intermediate 5(e) (0.90 g, 0.97 mmol) was used instead of Intermediate 1(e).

LC-MS (calculated: 932.16 g/mol, found: 933.16 (M+1))

### Synthesis of Compound 5

Compound 5 (0.45 g, yield: 52 %) was synthesized in the same manner as in the synthesis of Compound 1 of Synthesis Example 1, except that Intermediate 5(f) (0.72 g, 0.77 mmol) was used instead of Intermediate 1(f).

LC-MS (calculated: 1122.55 g/mol, found: 1123.55 (M+1))

### Synthesis Example 6 (Compound 6)

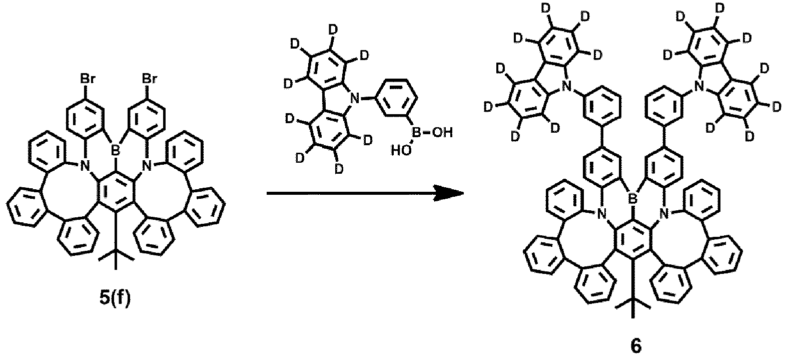

Compound 6 (0.85 g, yield: 62 %) was synthesized in the same manner as in the synthesis of Compound 2 of Synthesis Example 2, except that Intermediate 5(f) (1.0 g, 1.07 mmol) was used instead of Intermediate 1(f).

LC-MS (calculated: 1274.61 g/mol, found: 1275.61 (M+1))

### Synthesis Example 7 (Compound 7)

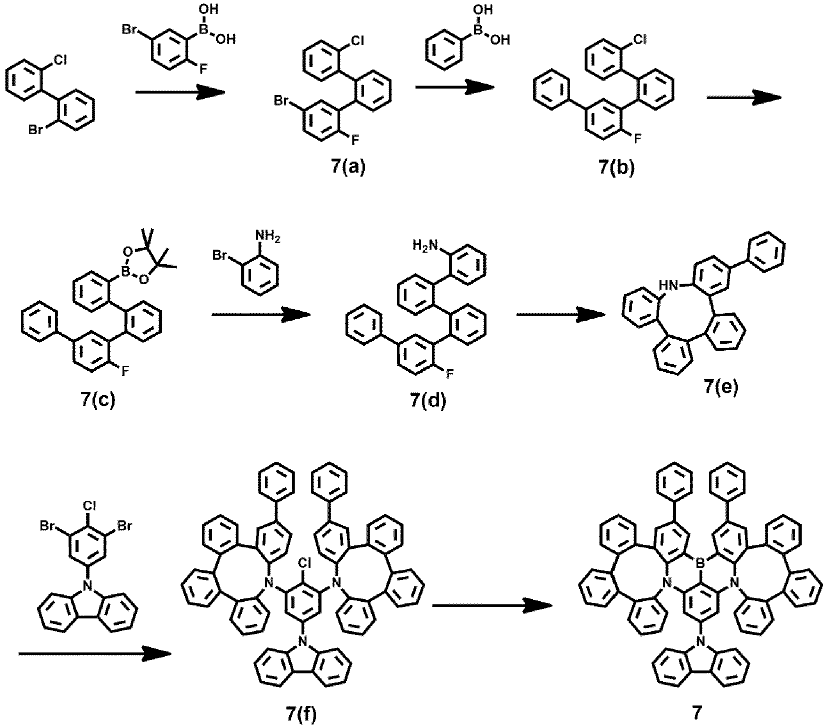

### Synthesis of Intermediate 7(a)

Intermediate 7(a) (17.8 g, yield: 88 %) was synthesized in the same manner as in the synthesis of Intermediate 1(b) of Synthesis Example 1, except that (5-bromo-2-fluorophenyl)boronic acid (13.52 g, 62.04 mmol) and 2-bromo-2'-chloro-1,1'-biphenyl (15.0 g, 56.40 mmol) were used instead of Intermediate 1(a) and 2-bromoaniline, respectively.

LC-MS (calculated: 359.97 g/mol, found: 360.97 (M+1))

### Synthesis of Intermediate 7(b)

Intermediate 7(b) (15.4 g, yield: 91 %) was synthesized in the same manner as in the synthesis of Intermediate 1(a) of Synthesis Example 1, except that Intermediate 7(a) and phenylboronic acid (6.340 g, 51.95 mmol) were used instead of 2-bromo-2'-chloro-1,1'-biphenyl and bis(pinacolato)diboron, respectively.

LC-MS (calculated: 358.09 g/mol, found: 359.09 (M+1))

### Synthesis of Intermediate 7(c)

Intermediate 7(c) (21 g, yield: 95 %) was synthesized in the same manner as in the synthesis of Intermediate 1(a) of Synthesis Example 1, except that Intermediate 7(b) (17.5 g, 48.87 mmol) was used instead of 2-bromo-2'-chloro-1,1'-biphenyl.

LC-MS (calculated: 450.22 g/mol, found: 451.22 (M+1))

### Synthesis of Intermediate 7(d)

Intermediate 7(d) (15.40 g, yield: 91 %) was synthesized in the same manner as in the synthesis of Intermediate 1(b) of Synthesis Example 1, except that Intermediate 7(c) (20.277 g, 45.04 mmol) was used instead of Intermediate 1(a).

LC-MS (calculated: 415.17 g/mol, found: 416.17 (M+1))

### Synthesis of Intermediate 7(e)

Intermediate 7(e) (12.2 g, yield: 85 %) was synthesized in the same manner as in the synthesis of Intermediate 1(d) of Synthesis Example 1, except that Intermediate 7(d) (15.0 g, 36.13 mmol) was used instead of Intermediate 1(c).

LC-MS (calculated: 395.17 g/mol, found: 396.17 (M+1))

### Synthesis of Intermediate 7(f)

Intermediate 7(e) (5.47 g, 1.74 mmol), 9-(3,5-dibromo-4-chlorophenyl)-9H-carbazole (available from HANCHEM Co.Ltd) (3.0 g, 6.93 mmol), Pd₂(dba)₃ (0.635 g, 0.69 mmol), SPhos (0.57 g, 1.39 mmol), and NaOtBu (1.998 g, 20.79 mmol) were mixed with toluene (35 ml), and the mixture was heated and stirred in a nitrogen atmosphere at 120 °C for 2 hours. A solvent of a reactant obtained therefrom was removed by using a rotary evaporator, and 200 ml of dichloromethane was added thereto to dissolve the reactant, followed by washing twice with water (200 ml). Next, water was removed therefrom by using MgSO₄ anhydride, and then the solvent was removed therefrom by using a rotary evaporator. A purification process through column chromatography was performed thereon to synthesize Intermediate 7(f) (4.3 g, yield: 58 %).

LC-MS (calculated: 1063.37 g/mol, found: 1064.37 (M+1))

### Synthesis of Compound 7

Intermediate 7(f) (4.00 g, 3.76 mmol) and t-butyla benzene(100 ml) were mixed, and 1.6 M of tert-BuLi pentane solution (9.40 mmol) was added thereto in a nitrogen atmosphere at -78 °C. Then, the temperature was raised to 60 °C, and the mixture was heated and stirred for 1 hour. After the reaction was completed, the mixture was cooled to -40 °C, and BBr₃ (1.885 g, 7.52 mmol) was added thereto. Then, the mixture was stirred at room temperature for 1 hour and cooled again to -40 °C. Next, N,N-diisopropylethylamine (0.972 g, 7.52 mmol) was added thereto, and the mixture was heated and stirred at 120 °C for 4 hours. After the mixture was cooled to room temperature, a NaOAc sat.aq. solution and 200 ml of ethylacetate (EA) was added thereto, followed by washing using water (300 ml). The moisture was removed therefrom by using MgSO₄ anhydride, and a solvent was removed therefrom by using a rotary evaporator. A purification process through column chromatography was performed thereon to synthesize Compound 7 (1.32 g, yield: 34 %).

LC-MS (calculated: 1037.39 g/mol, found: 1038.39 (M+1))

### Synthesis Example 8 (Compound 8)

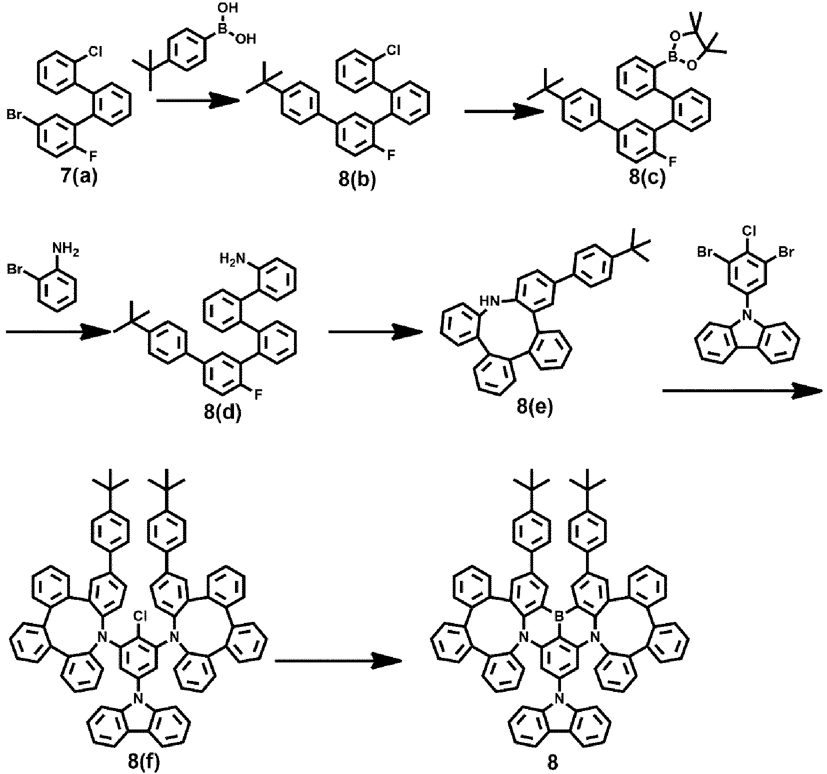

### Synthesis of Intermediate 8(b)

Intermediate 8(b) (7.23 g, yield: 90 %) was synthesized in the same manner as in the synthesis of Intermediate 7(b) of Synthesis Example 7, except that (4-(tert-butyl)phenyl)boronic acid (4.503 g, 25.28 mmol) was used instead of phenylboronic acid.

LC-MS (calculated: 414.16 g/mol, found: 415.17 (M+1))

### Synthesis of Intermediate 8(c)

Intermediate 8(c) (8.5 g, yield: 97 %) was synthesized in the same manner as in the synthesis of Intermediate 7(c) of Synthesis Example 7, except that Intermediate 8(b) (7.2 g, 17.38 mmol) was used instead of Intermediate 7(b).

LC-MS (calculated: 506.28 g/mol, found: 507.28 (M+1))

### Synthesis of Intermediate 8(d)

Intermediate 8(d) (4.13 g, yield: 68 %) was synthesized in the same manner as in the synthesis of Intermediate 7(d) of Synthesis Example 7, except that Intermediate 8(c) (8.5 g, 16.73 mmol) was used instead of Intermediate 7(c).

LC-MS (calculated: 471.24 g/mol, found: 472.24 (M+1))

### Synthesis of Intermediate 8(e)

Intermediate 8(e) (3.8 g, yield: 85 %) was synthesized in the same manner as in the synthesis of Intermediate 7(e) of Synthesis Example 7, except that Intermediate 8(d) (4.1 g, 9.88 mmol) was used instead of Intermediate 7(d).

LC-MS (calculated: 451.23 g/mol, found: 452.23 (M+1))

### Synthesis of Intermediate 8(f)

Intermediate 8(f) (2.98 g, yield: 61 %) was synthesized in the same manner as in the synthesis of Intermediate 7(f) of Synthesis Example 7, except that Intermediate 8(e) (3.753 g, 8.32 mmol) was used instead of Intermediate 7(e).

LC-MS (calculated: 1175.49 g/mol, found: 1176.49 (M+1))

### Synthesis of Compound 8

Compound 8 (1.12 g, yield: 39 %) was synthesized in the same manner as in the synthesis of Compound 7 of Synthesis Example 7, except that Intermediate 8(f) (2.9 g, 2.47 mmol) was used instead of Intermediate 7(f).

LC-MS (calculated: 1149.52 g/mol, found: 1150.52 (M+1))

### Synthesis Example 9 (Compound 9)

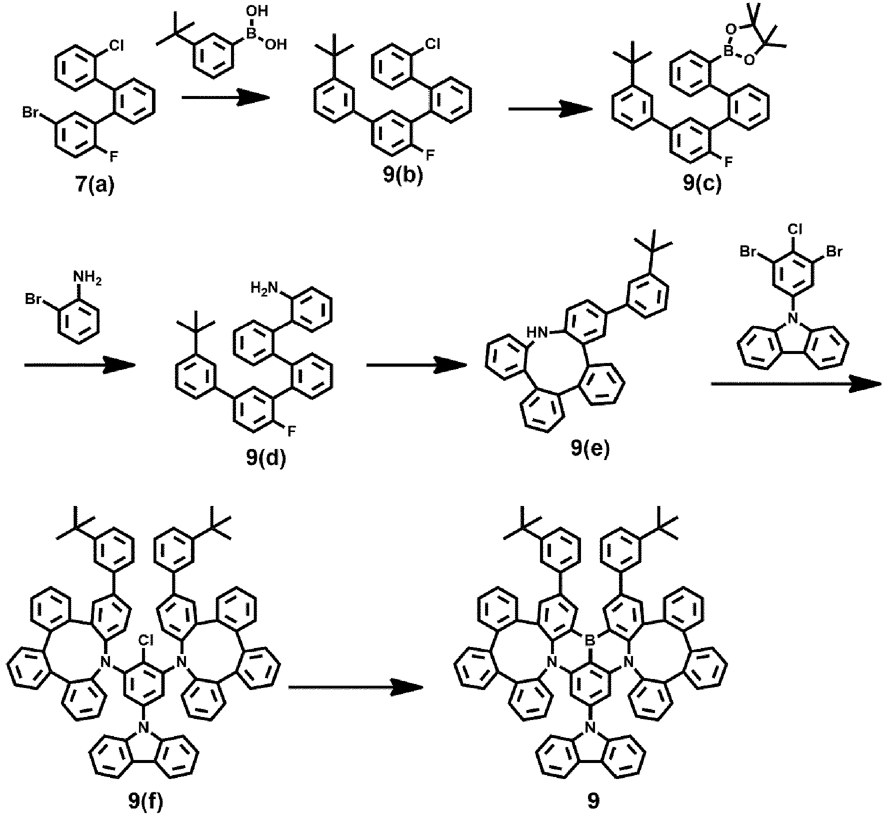

### Synthesis of Intermediate 9(b)

Intermediate 9(b) (21.2 g, yield: 92 %) was synthesized in the same manner as in the synthesis of Intermediate 7(b) of Synthesis Example 7, except that (3-(tert-butyl)phenyl)boronic acid (12.86 g, 72.23 mmol) was used instead of phenylboronic acid.

LC-MS (calculated: 414.16 g/mol, found: 415.17 (M+1))

### Synthesis of Intermediate 9(c)

Intermediate 9(c) (20.4 g, yield: 79 %) was synthesized in the same manner as in the synthesis of Intermediate 7(c) of Synthesis Example 7, except that Intermediate 9(b) (21.0 g, 50.71 mmol) was used instead of Intermediate 7(b).

LC-MS (calculated: 506.28 g/mol, found: 507.28 (M+1))

### Synthesis of Intermediate 9(d)

Intermediate 9(d) (11.1 g, yield: 81 %) was synthesized in the same manner as in the synthesis of Intermediate 7(d) of Synthesis Example 7, except that Intermediate 9(c) (19.25 g, 38.02 mmol) was used instead of Intermediate 7(c).

LC-MS (calculated: 471.24 g/mol, found: 472.24 (M+1))

### Synthesis of Intermediate 9(e)

Intermediate 9(e) (3.98 g, yield: 83 %) was synthesized in the same manner as in the synthesis of Intermediate 7(e) of Synthesis Example 7, except that Intermediate 9(d) (5.0 g, 10.61 mmol) was used instead of Intermediate 7(d).

LC-MS (calculated: 451.23 g/mol, found: 452.23 (M+1))

### Synthesis of Intermediate 9(f)

Intermediate 9(f) (2.98 g, yield: 58 %) was synthesized in the same manner as in the synthesis of Intermediate 7(f) of Synthesis Example 7, except that Intermediate 9(e) (3.96 g, 8.78 mmol) was used instead of Intermediate 7(e).

LC-MS (calculated: 1175.49 g/mol, found: 1176.49 (M+1))

### Synthesis of Compound 9

Compound 9 (0.9 g, yield: 32 %) was synthesized in the same manner as in the synthesis of Compound 7 of Synthesis Example 7, except that Intermediate 9(f) (2.9 g, 2.47 mmol) was used instead of Intermediate 7(f).

LC-MS (calculated: 1149.52 g/mol, found: 1150.52 (M+1))

### Synthesis Example 10 (Compound 10)

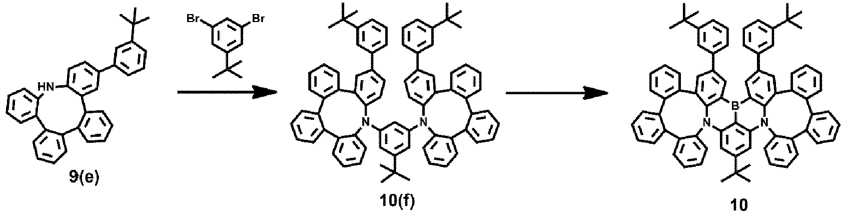

### Synthesis of Intermediate 10(f)

Intermediate 10(f) (5.66 g, yield: 80 %) was synthesized in the same manner as in the synthesis of Intermediate 9(f) of Synthesis Example 9, except that 1,3-dibromo-5-(tert-butyl)benzene (2.0 g, 6.85 mmol) was used instead of 9-(3,5-dibromo-4-chlorophenyl)-9H-carbazole.

LC-MS (calculated: 1032.54 g/mol, found: 1033.54 (M+1))

### Synthesis of Compound 10

Compound 10 (1.1 g, yield: 22 %) was synthesized in the same manner as in the synthesis of Intermediate 1(f) of Synthesis Example 1, except that Intermediate 10(f) (5.0 g, 4.84 mmol) was used instead of Intermediate 1(e).

LC-MS (calculated: 1040.52 g/mol, found: 1041.52 (M+1))

### Synthesis Example 11 (Compound 11)

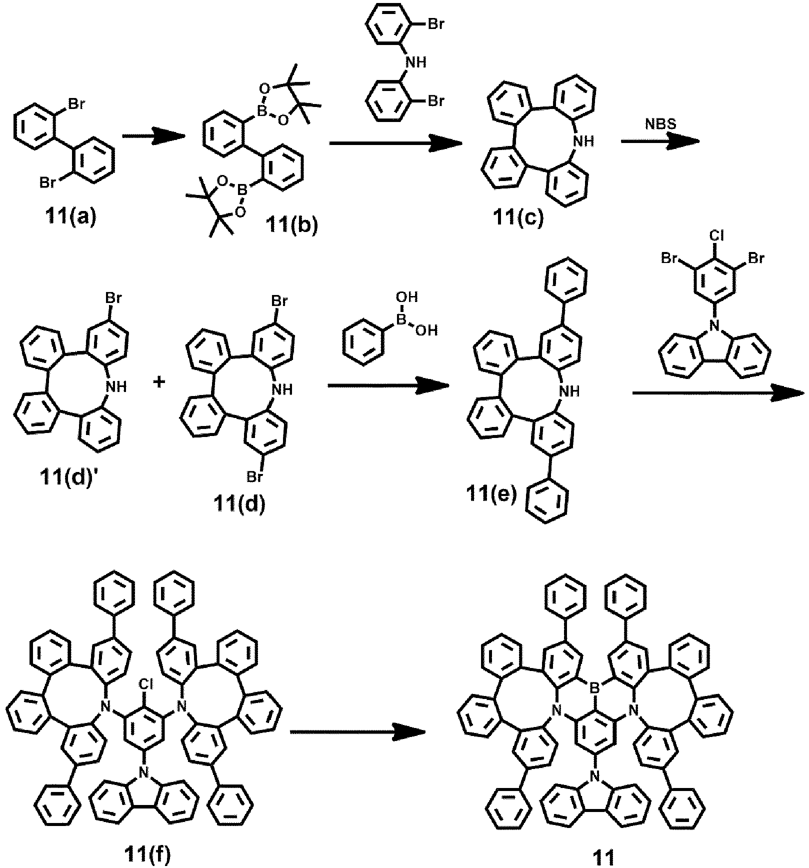

### Synthesis of Intermediate 11(b)

Intermediate 11(b) (36.2 g, yield: 92 %) was synthesized in the same manner as in the synthesis of Intermediate 1(a) of Synthesis Example 1, except that Intermediate 11(a) (30.0 g, 96.81 mmol) was used instead of 2-bromo-2'-chloro-1,1'-biphenyl.

LC-MS (calculated: 406.25 g/mol, found: 407.25 (M+1))

### Synthesis of Intermediate 11(c)

Intermediate 11(c) (14.2 g, yield: 72 %) was synthesized in the same manner as in the synthesis of Intermediate 1(b) of Synthesis Example 1, except that Intermediate 11(b) (32.5 g, 80.02 mmol) and bis(2-bromophenyl)amine were used instead of Intermediate 1(a) and 2-bromoaniline.

LC-MS (calculated: 319.14 g/mol, found: 320.14 (M+1))

### Synthesis of Intermediates 11(d)' and 11(d)

Intermediate 11(c) (2.9 g, 9.09 mmol) was dissolved in 40 ml of N,N-dimethylformamide (DMF) in a round flask and then cooled and stirred at 0 °C. N-bromosuccinimide (3.56 g, 20.0 mmol) dissolved in 20 ml of DMF was slowly added dropwise thereto, followed by stirring at room temperature for reaction. After the reaction was completed, a sodium thiosulfate solution of 2 mol concentration was added thereto, and an organic layer obtained through an extraction process performed by adding dichloromethane thereto was concentrated under reduced pressure. The obtained product was separated by column chromatography to obtain Intermediate 11(d)' (2.3 g, yield: 64 %) and Intermediate 11(d) (1.6 g, yield: 36 %) as white solids.
11(d)': LC-MS (calculated: 397.05 g/mol, found: 398.05 (M+1))
11(d): LC-MS (calculated: 474.96 g/mol, found: 475.96 (M+1))

### Synthesis of Intermediate 11(e)

Intermediate 11(e) (2.45 g, yield: 82 %) was synthesized in the same manner as in the synthesis of Intermediate 1(a) of Synthesis Example 1, except that Intermediate 11(d) (3.0 g, 6.32 mmol) and phenylboronic acid (1.0 g, 8.21 mmol) were used instead of 2-bromo-2'-chloro-1,1'-biphenyl and bis(pinacolato)diboron, respectively.

LC-MS (calculated: 471.2 g/mol, found: 472.2 (M+1)

### Synthesis of Intermediate 11(f)

Intermediate 11(f) (1.35 g, yield: 44 %) was synthesized in the same manner as in the synthesis of Intermediate 7(f) of Synthesis Example 7, except that Intermediate 11(e) (2.4 g, 5.08 mmol) was used instead of Intermediate 7(e).

LC-MS (calculated: 1215.43 g/mol, found: 1216.43 (M+1))

### Synthesis of Compound 11

Compound 11 (0.23 g, yield: 18 %) was synthesized in the same manner as in the synthesis of Compound 7 of Synthesis Example 7, except that Intermediate 11(f) (1.3 g, 1.07 mmol) was used instead of Intermediate 7(f).

LC-MS (calculated: 1189.46 g/mol, found: 1189.46 (M+1))

### Synthesis Example 12 (Compound 12)

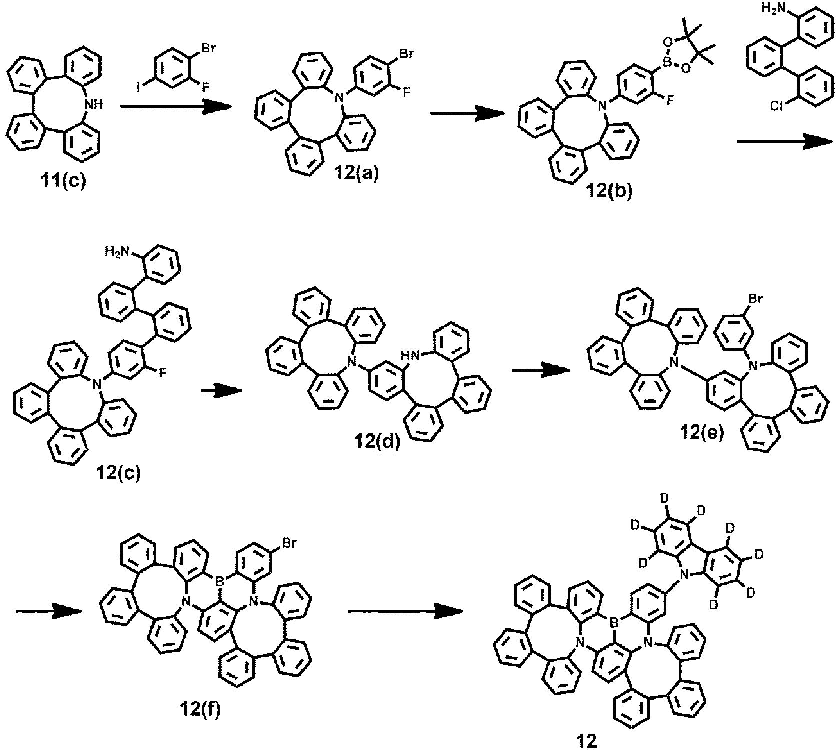

### Synthesis of Intermediate 12(a)

Intermediate 12(a) (17.23 g, yield: 70 %) was synthesized in the same manner as in the synthesis of Intermediate 7(f) of Synthesis Example 7, except that Intermediate 11(c) (15.0 g, 50.03 mmol) and 1-bromo-2-fluoro-4-iodobenzene (17.56 g, 55.03 mmol) were used instead of Intermediate 7(e) and 9-(3,5-dibromo-4-chlorophenyl)-9H-carbazole, respectively.

LC-MS (calculated: 491.07 g/mol, found: 492.07 (M+1))

### Synthesis of Intermediate 12(b)

Intermediate 12(b) (14.3 g, yield: 77 %) was synthesized in the same manner as in the synthesis of Intermediate 1(a) of Synthesis Example 1, except that Intermediate 12(a) (17.0 g, 34.62 mmol) was used instead of 2-bromo-2'-chloro-1,1'-biphenyl.

LC-MS (calculated: 539.24 g/mol, found: 540.24 (M+1))

### Synthesis of Intermediate 12(c)

Intermediate 12(c) (8.8 g, yield: 62 %) was synthesized in the same manner as in the synthesis of Intermediate 1(c) of Synthesis Example 1, except that Intermediate 12(b) (15.07 g, 27.95 mmol) and Intermediate 1(b) (6.0 g, 21.50 mmol) were used instead of 2,2'-(4,6-difluoro-1,3-phenylene)bis(4,4,5,5-tetramethyl-1,3,2-dioxoborolane) and Intermediate 1(b), respectively.

LC-MS (calculated: 656.26 g/mol, found: 657.26 (M+1))

### Synthesis of Intermediate 12(d)

Intermediate 12(d) (4.3 g, yield: 74 %) was synthesized in the same manner as in the synthesis of Intermediate 1(d) of Synthesis Example 1, except that Intermediate 12(c) (6.0 g, 9.14 mmol) was used instead of Intermediate 1(c).

LC-MS (calculated: 636.26 g/mol, found: 637.26 (M+1))

### Synthesis of Intermediate 12(e)

Intermediate 12(e) (3.56 g, yield: 72 %) was synthesized in the same manner as in the synthesis of Intermediate 1(e) of Synthesis Example 1, except that Intermediate 12(d) (4.0 g, 6.29 mmol) was used instead of Intermediate 1(d).

LC-MS (calculated: 790.20 g/mol, found: 791.20 (M+1))

### Synthesis of Intermediate 12(f)

Intermediate 12(f) (0.55 g, yield: 16 %) was synthesized in the same manner as in the synthesis of Intermediate 1(f) of Synthesis Example 1, except that Intermediate 12(e) (3.5 g, 4.43 mmol) was used instead of Intermediate 1(e).

LC-MS (calculated: 798.18 g/mol, found: 799.20 g/mol (M+1))

### Synthesis of Compound 12

Compound 12 (14.6 g, yield: 22 %) was synthesized in the same manner as in the synthesis of Compound 1 of Synthesis Example 1, except that Intermediate 12(f) (0.55 g, 1.74 mmol) was used instead of Intermediate 1(f).

LC-MS (calculated: 893.38 g/mol, found: 894.38 (M+1))

### Synthesis Example 13 (Compound 13)

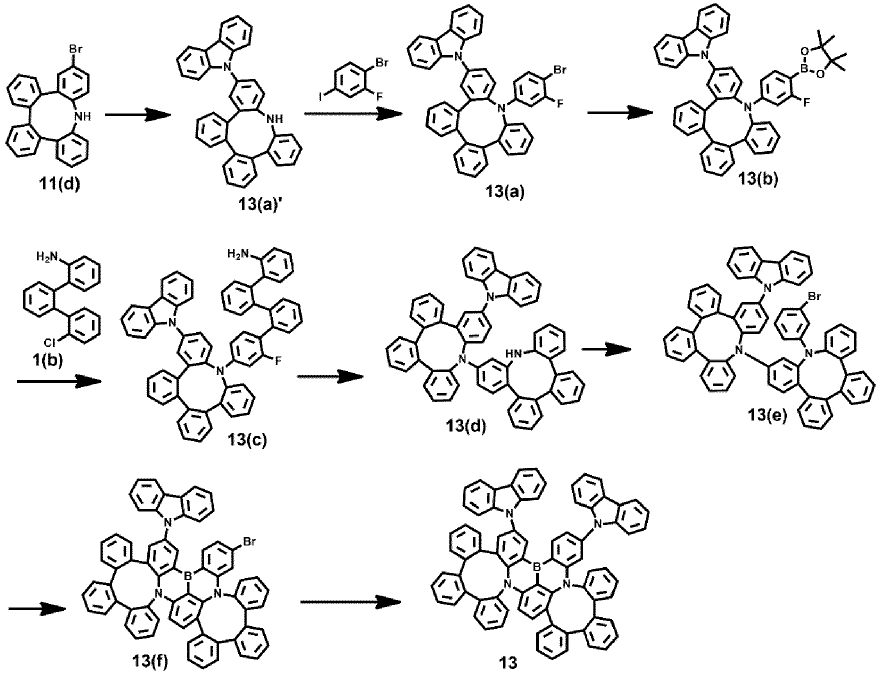

### Synthesis of Intermediate 13(a)'

Intermediate 13(a)' (9.76 g, yield: 80 %) was synthesized in the same manner as in the synthesis of Intermediate 7(f) of Synthesis Example 7, except that carbazole and Intermediate 11(d) (10.0 g, 25.19 mmol) were used instead of Intermediate 7(e) and 9-(3,5-dibromo-4-chlorophenyl)-9H-carbazole, respectively.

LC-MS (calculated: 484.19 g/mol, found: 485.19 (M+1))

### Synthesis of Intermediate 13(a)

Intermediate 13(a) (8.8 g, yield: 68 %) was synthesized in the same manner as in the synthesis of Intermediate 7(f) of Synthesis Example 7, except that Intermediate 13(a)' (9.5 g, 19.62 mmol) and 1-bromo-2-fluoro-4-iodobenzene were used instead of Intermediate 7(e) and 9-(3,5-dibromo-4-chlorophenyl)-9H-carbazole, respectively.

LC-MS (calculated: 656.13 g/mol, found: 657.13 (M+1))

### Synthesis of Intermediate 13(b)

Intermediate 13(b) (9.1 g, yield: 99 %) was synthesized in the same manner as in the synthesis of Intermediate 1(a) of Synthesis Example 1, except that Intermediate 13(a) (8.5 g, 12.95 mmol) was used instead of 2-bromo-2'-chloro-1,1'-biphenyl.

LC-MS (calculated: 704.30 g/mol, found: 705.30 (M+1))

### Synthesis of Intermediate 13(c)

Intermediate 13(c) (6.6 g, yield: 83 %) was synthesized in the same manner as in the synthesis of Intermediate 1(b) of Synthesis Example 1, except that Intermediate 13(b) (8.858 g, 12.58 mmol) and Intermediate 1(b) were used instead of Intermediate 1(a) and 2-bromoaniline.

LC-MS (calculated: 821.32 g/mol, found: 822.32 (M+1))

### Synthesis of Intermediate 13(d)

Intermediate 13(d) (4.3 g, yield: 68 %) was synthesized in the same manner as in the synthesis of Intermediate 1(d) of Synthesis Example 1, except that Intermediate 13(c) (6.5 g, 7.91 mmol) was used instead of Intermediate 1(c).

LC-MS (calculated: 801.31 g/mol, found: 802.31 (M+1))

### Synthesis of Intermediate 13(e)

Intermediate 13(e) (5.34 g, yield: 89 %) was synthesized in the same manner as in the synthesis of Intermediate 1(e) of Synthesis Example 1, except that Intermediate 13(d) (4.0 g, 6.29 mmol) was used instead of Intermediate 1(d).

LC-MS (calculated: 955.26 g/mol, found: 956.26 g/mol (M+1))

### Synthesis of Intermediate 13(f)

Intermediate 13(f) (0.88 g, yield: 17 %) was synthesized in the same manner as in the synthesis of Intermediate 1(f) of Synthesis Example 1, except that Intermediate 13(e) (5.0 g, 5.23 mmol) was used instead of Intermediate 1(e).

LC-MS (calculated: 963.24 g/mol, found: 963.24 g/mol (M+1))

### Synthesis of Compound 13

Compound 13 (0.15 g, yield: 53 %) was synthesized in the same manner as in the synthesis of Compound 1 of Synthesis Example 1, except that Intermediate 13(e) (0.88 g, 0.91 mmol) and carbazole were used instead of Intermediate 1(f) and carbazole-d8, respectively.

LC-MS (calculated: 1050.39 g/mol, found: 1051.39 (M+1))

### Synthesis Example 14 (Compound 14)

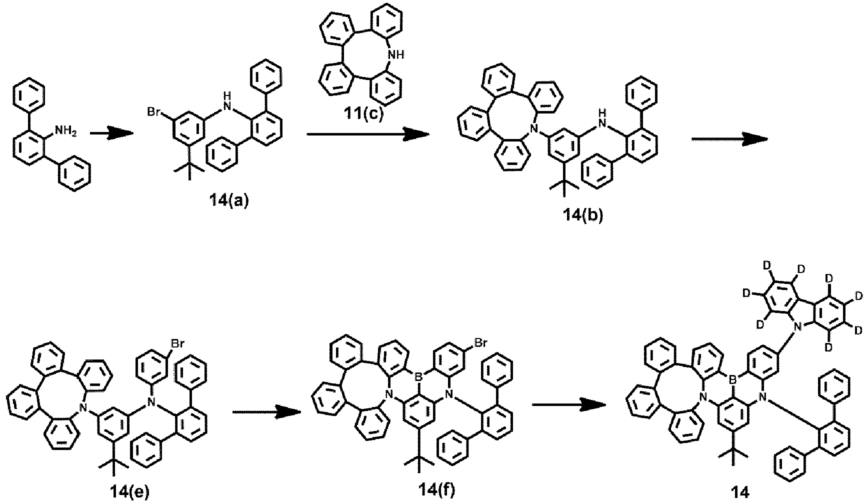

### Synthesis of Intermediate 14(a)

Intermediate 14(a) (14.3 g, yield: 61 %) was synthesized in the same manner as in the synthesis of Intermediate 7(f) of Synthesis Example 7, except that [1,1':3',1"-terphenyl]-2'-amine (15.0 g, 51.37 mmol) and 1,3-dibromo-5-(tert-butyl)benzene (13.85 g, 56.50 mmol) were used instead of Intermediate 7(e) and 9-(3,5-dibromo-4-chlorophenyl)-9H-carbazole, respectively.

LC-MS (calculated: 455.12 g/mol, found: 456.12 g/mol (M+1))

### Synthesis of Intermediate 14(b)

Intermediate 14(b) (17.09 g, yield: 80 %) was synthesized in the same manner as in the synthesis of Intermediate 7(f) of Synthesis Example 7, except that Intermediate 11(c) (10.79 g, 33.84 mmol) and Intermediate 14(a) (14.0 g, 30.76 mmol) were used instead of Intermediate 7(e) and 9-(3,5-dibromo-4-chlorophenyl)-9H-carbazole, respectively.

LC-MS (calculated: 694.33 g/mol, found: 695.33 g/mol (M+1))

### Synthesis of Intermediate 14(e)

Intermediate 14(e) (16.6 g, yield: 80 %) was synthesized in the same manner as in the synthesis of Intermediate 1(e) of Synthesis Example 1, except that Intermediate 14(b) (17.0 g, 24.48 mmol) was used instead of Intermediate 1(d).

LC-MS (calculated: 848.28 g/mol, found: 849.28 g/mol (M+1))

### Synthesis of Intermediate 14(f)

Intermediate 14(f) (1.8 g, yield: 12 %) was synthesized in the same manner as in the synthesis of Intermediate 1(f) of Synthesis Example 1, except that Intermediate 14(e) (15.0 g, 17.68 mmol) was used instead of Intermediate 1(e).

LC-MS (calculated: 856.26 g/mol, found: 857.26 g/mol (M+1))

### Synthesis of Compound 14

Compound 14 (1.12 g, yield: 56 %) was synthesized in the same manner as in the synthesis of Compound 1 of Synthesis Example 1, except that Intermediate 14(f) (1.8 g, 2.1 mmol) was used instead of Intermediate 1(f).

LC-MS (calculated: 951.46 g/mol, found: 952.46 (M+1))

### Synthesis Example 15 (Compound 15)

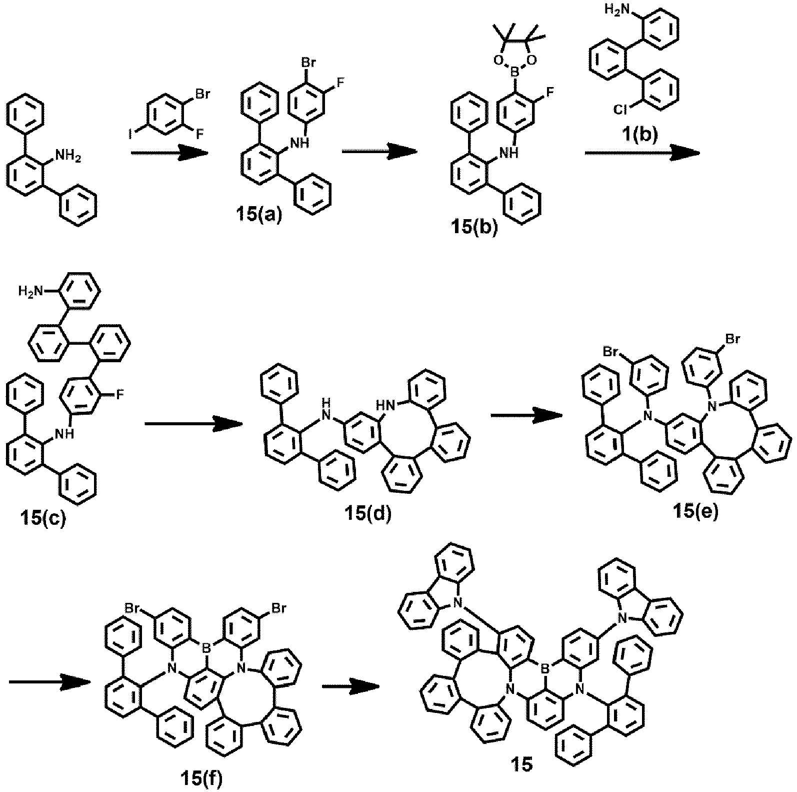

### Synthesis of Intermediate 15(a)

Intermediate 15(a) (13.7 g, yield: 66 %) was synthesized in the same manner as in the synthesis of Intermediate 7(f) of Synthesis Example 7, except that [1,1':3',1"-terphenyl]-2'-amine (13.49 g, 55.03 mmol) and 1-bromo-2-fluoro-4-iodobenzene (15.0 g, 50.03 mmol) were used instead of Intermediate 7(e) and 9-(3,5-dibromo-4-chlorophenyl)-9H-carbazole, respectively.

LC-MS (calculated: 417.05 g/mol, found: 418.05 g/mol (M+1))

### Synthesis of Intermediate 15(b)

Intermediate 15(b) (13.3 g, yield: 97 %) was synthesized in the same manner as in the synthesis of Intermediate 1(a) of Synthesis Example 1, except that Intermediate 15(a) (12.3 g, 29.49 mmol) was used instead of 2-bromo-2'-chloro-1,1'-biphenyl.

LC-MS (calculated: 465.23 g/mol, found: 466.23 g/mol (M+1))

### Synthesis of Intermediate 15(c)

Intermediate 15(c) (10.1 g, yield: 81 %) was synthesized in the same manner as in the synthesis of Intermediate 1(b) of Synthesis Example 1, except that Intermediate 15(b) (13.0 g, 27.95 mmol) and Intermediate 1(b) were used instead of Intermediate 1(a) and 2-bromoaniline, respectively.

LC-MS (calculated: 582.25 g/mol, found: 583.25 g/mol (M+1))

### Synthesis of Intermediate 15(d)

Intermediate 15(d) (8.8 g, yield: 91 %) was synthesized in the same manner as in the synthesis of Intermediate 1(d) of Synthesis Example 1, except that Intermediate 15(c) (10.0 g, 17.17 mmol) was used instead of Intermediate 1(c).

LC-MS (calculated: 562.24 g/mol, found: 563.24 g/mol (M+1))

### Synthesis of Intermediate 15(e)

Intermediate 15(e) (9.64 g, yield: 73 %) was synthesized in the same manner as in the synthesis of Intermediate 1(e) of Synthesis Example 1, except that Intermediate 15(d) (8.5 g, 15.12 mmol) was used instead of Intermediate 1(d).

LC-MS (calculated: 870.12 g/mol, found: 871.12 g/mol (M+1))

### Synthesis of Intermediate 15(f)

Intermediate 15(f) (2.08 g, yield: 22 %) was synthesized in the same manner as in the synthesis of Intermediate 1(f) of Synthesis Example 1, except that Intermediate 15(e) (9.5 g, 10.92 mmol) was used instead of Intermediate 1(e).

LC-MS (calculated: 878.12 g/mol, found: 880.12 g/mol (M+1))

### Synthesis of Compound 15

Compound 15 (1.79 g, yield: 75 %) was synthesized in the same manner as in the synthesis of Compound 1 of Synthesis Example 1, except that Intermediate 15(f) (2.0 g, 2.28 mmol) and carbazole were used instead of Intermediate 1(f) and carbazole-d8, respectively.

LC-MS (calculated: 1052.41 g/mol, found: 1053.46 (M+1))

### Synthesis Example 16 (Compound 94)

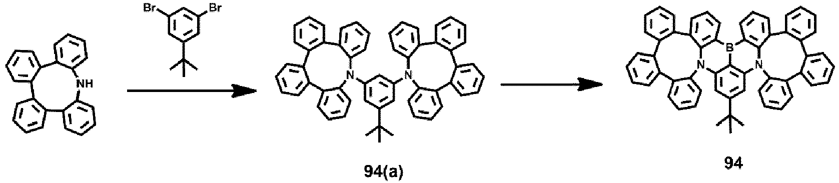

### Synthesis of Intermediate 94(a)

1,3-Dibromo-5-(tert-butyl)benzene (0.2g, 0.68 mmol), 9H-tetrabenzo[b,d,f,h]azonine (0.481 g, 1.51 mmol), Pd₂(dba)₃ (0.157 g, 0.17 mmol), SPhos (0.155 g, 0.38 mmol) and LHMDS (0.344 g, 2.05 mmol) were mixed with xylene (10 ml), and the mixture was heated and stirred in a nitrogen atmosphere at 120 °C for 3 hours. A solvent of a reactant obtained therefrom was removed by using a rotary evaporator, and 200 ml of dichloromethane was added thereto to dissolve the reactant, followed by washing twice with water (200 ml). Next, water was removed therefrom by using MgSO₄ anhydride, and then the solvent was removed therefrom by using a rotary evaporator. A purification process through column chromatography was performed thereon to synthesize Intermediate 94(a) (0.11 g, yield: 40 %).

LC-MS (calculated: 769.00 g/mol, found: 770.0 (M+1))

### Synthesis of Compound 94

Compound 94 (0.02 mg, yield: 18 %) was synthesized in the same manner as in the synthesis of Intermediate 1(f) of Synthesis Example 1, except that Intermediate 94(a) (0.11 g, 0.14 mmol) was used instead of Intermediate 1(e).

LC-MS (calculated: 776.79 g/mol, found: 777.8 (M+1))

### Evaluation Example 1

A peak wavelength of a peak having the maximum emission intensity in a photoluminescence (PL) spectrum (PLₘₐₓ), a full width at half maxium (FWHM) of the peak having the maximum emission intensity in the PL spectrum and a triplet (T₁) energy level of each compound in Table 2 were evaluated according to the methods indicated in Table 1, and the results thereof are shown in Table 2.

**Table 1**

| | |
|---|---|
| PLₘₐₓ and FWHM evaluation method | Each compound was diluted at a concentration of 1x10⁻⁴ M in toluene, the photoluminescence (PL) spectrum of each compound was measured at room temperature by using ISC PC1 spectrofluorometer having a Xenon lamp mounted thereon, and PLₘₐₓ and FWHM of each compound were evaluated from the PL spectrum. |
| T₁ energy level evaluation method | A mixture of toluene and each compound (each compound was dissolved in 3 mL of toluene so as to have a concentration of 1x10⁻⁴ M) was loaded into a quartz cell, and then, the resultant quartz cell was loaded into liquid nitrogen (77 Kelvin, K). A photoluminescence (PL) spectrum thereof was measured by using a photoluminescence measurement device, the obtained spectrum was compared with a PL spectrum measured at room temperature, and the peaks observed only at low temperature were analyzed to calculate an T₁ energy level. |

**Table 2**

| Compound No. | PLₘₐₓ (nm) | FWHM (nm) | T₁ (eV) |
|---|---|---|---|
| 1 | 461 | 22 | 2.56 |
| 2 | 460 | 22 | 2.56 |
| 3 | 455 | 18 | 2.61 |
| 4 | 460 | 22 | 2.56 |
| 5 | 455 | 18 | 2.6 |
| 6 | 460 | 22 | 2.56 |
| 7 | 460 | 20 | 2.60 |
| 8 | 461 | 24 | 2.57 |
| 9 | 462 | 23 | 2.57 |
| 10 | 457 | 21 | 2.59 |
| 11 | 463 | 19 | 2.54 |
| 12 | 455 | 21 | 2.6 |
| 13 | 464 | 21 | 2.55 |
| 14 | 460 | 22 | 2.57 |
| 15 | 455 | 18 | 2.62 |
| 94 | 455 | 23 | 2.61 |

### Example 1

A glass substrate with an ITO electrode having a thickness of 1,500 Å formed thereon was cut to a size of 50 mm x 50 mm x 0.5 mm, sonicated in acetone isopropyl alcohol and pure water, each for 15 minutes, and then washed by exposure to UV ozone for 30 minutes.
m-MTDATA was deposited on the ITO electrode (anode) on the glass substrate to form a hole injection layer having a thickness of 600 Å, and α-NPD was deposited on the hole injection layer to form a hole transport layer having a thickness of 250 Å.

Compound 1 (emitter) and mCP (host) were co-deposited at a weight ratio of 10:90 on the hole transport layer to form an emission layer having a thickness of 400 Å.

BAlq was deposited on the emission layer to form a hole-blocking layer having a thickness of 50 Å, Alq₃ was deposited on the hole-blocking layer to form an electron transport layer having a thickness of 300 Å, LiF was deposited on the electron transport layer to form an electron injection layer having a thickness of 10 Å, and then, Al was vacuum deposited on the electron injection layer to form a second electrode (cathode) having a thickness of 1,200 Å, thereby completing the manufacture of a light-emitting device having a structure of ITO / m-MTDATA (600 Å) / α-NPD (250 Å) / mCP + Compound 1 (10 wt%) (400 Å) / BAlq (50 Å) / Alq₃ (300 Å) / LiF (10 Å) / Al (1,200 Å).

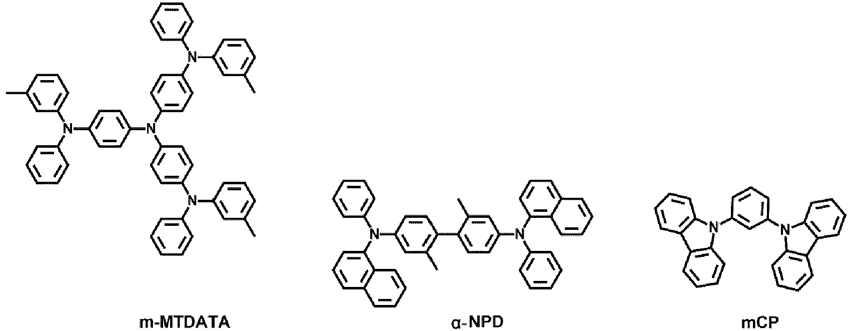

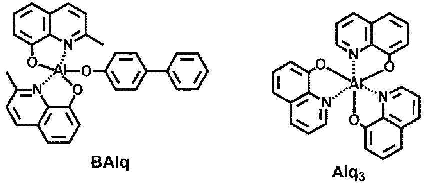

### Example 2 and Comparative Examples A and B

Light-emitting devices were manufactured in the same manner as in Example 1, except that the compounds shown in Table 3 were used instead of Compound 1 as an emitter when forming an emission layer.

### Evaluation Example 2

For each of the light-emitting devices manufactured according to Examples 1 and 2 and Comparative Examples A and B, the emission peak wavelength (maximum emission peak wavelength) of the electroluminescence (EL) spectrum, driving voltage, and external quantum efficiency (EQE) were evaluated, and the results thereof are shown in Table 3. For each of the light-emitting devices,
the emission peak wavelength of the EL spectrum was evaluated from the EL spectrum (at 1,000 cd/m²) measured by using a luminance meter (Minolta Cs-1000A). The driving voltage and the EQE were evaluated by using a current-voltmeter (Keithley 2400) and a luminance meter (Minolta Cs-1000A). The driving voltage and EQE values of the organic light-emitting devices according to Examples 1 and 2 and Comparative Examples A and B shown in Table 3 are provided in relative values based on Comparative Example A (%).

**Table 3**

| | Emitter Compound No. | Emission peak wavelength (nm) | Driving voltage (Relative value, %) | External quantum efficiency (EQE) (at 1000 cd/m²) (Relative value, %) |
|---|---|---|---|---|
| Example 1 | 1 | 461 | 92.8 | 120 |
| Example 2 | 7 | 460 | 97.6 | 115 |
| Comparative Example A | A | 464 | 100 | 100 |
| Comparative Example B | B | 462 | 99.7 | 99 |

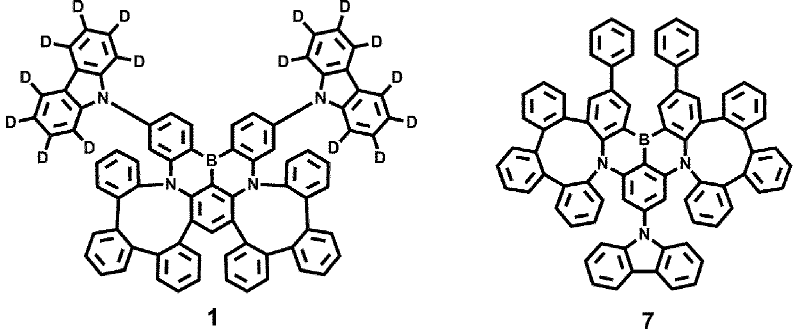

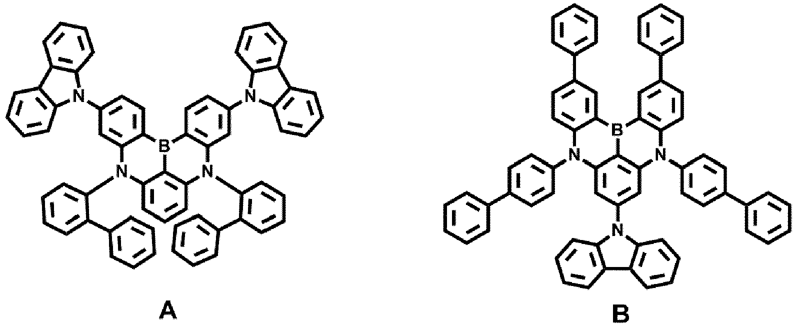

From Table 3, it was confirmed that Examples 1 and 2 show improved driving voltage and EQE, compared to Comparative Examples A and B.

Accordingly, as the condensed polycyclic compound has excellent thermal and electric stability according to the shielding effect, exhibits relatively less steric hindrance effect, and emits blue light having a relatively small FWHM and shifted to a short wavelength, an electronic device employing the condensed polycyclic compound, for example, a light-emitting device may have an improved driving voltage, higher EQE, increased luminescence efficiency, and/or longer lifespan characteristics.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

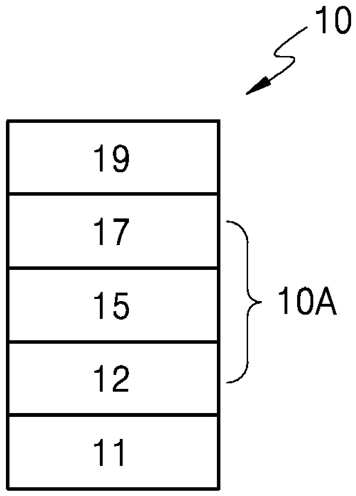

## Claims

1. A condensed polycyclic compound, which does not comprise a metal and comprises a condensed ring,
wherein the condensed ring comprises a 9-membered ring comprising nitrogen and carbon as ring-forming atoms and a 6-membered ring comprising nitrogen, carbon, and boron as ring-forming atoms, wherein the 9-membered ring and the 6-membered ring are condensed with each other while sharing a nitrogen and a carbon.

2. The condensed polycyclic compound of claim 1, wherein the condensed ring comprises a moiety represented by Formula 1(1): 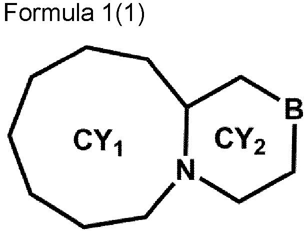 wherein, in Formula 1(1),
ring CY₁ is a 9-membered ring comprising nitrogen and carbon, and
ring CY₂ is a 6-membered ring comprising nitrogen, carbon, and boron.

3. The condensed polycyclic compound of claim 2, wherein a number of the moiety represented by Formula 1(1) of the condensed polycyclic compound is 1, 2, 3, or 4; and/or
wherein the condensed polycyclic compound is a multiple resonance thermally activated delayed fluorescence material.

4. The condensed polycyclic compound of any of claims 1-3, wherein the condensed polycyclic compound is represented by Formula 1, 2, or 3: 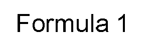 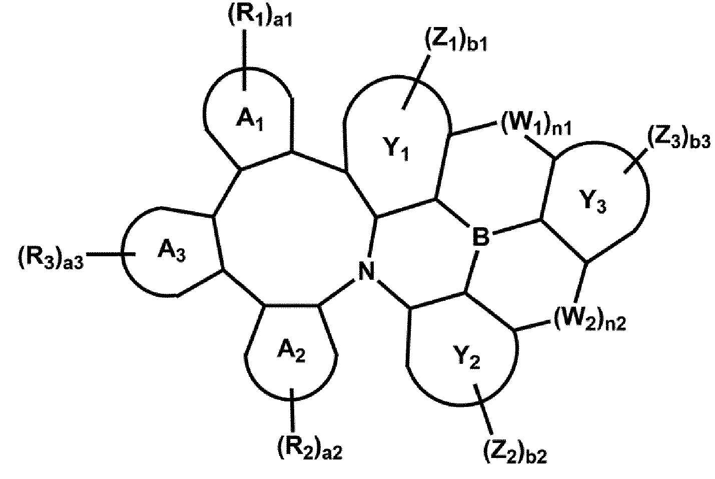 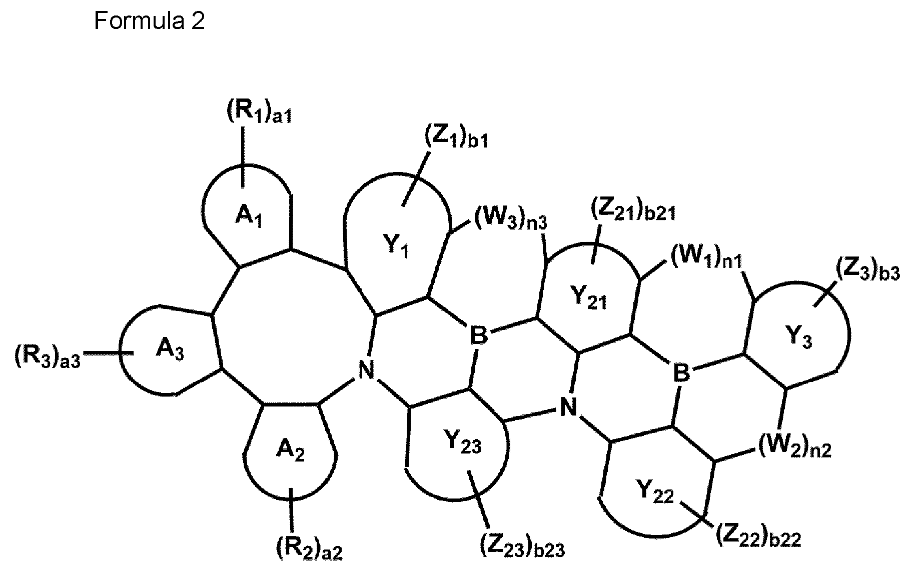 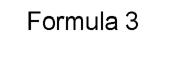 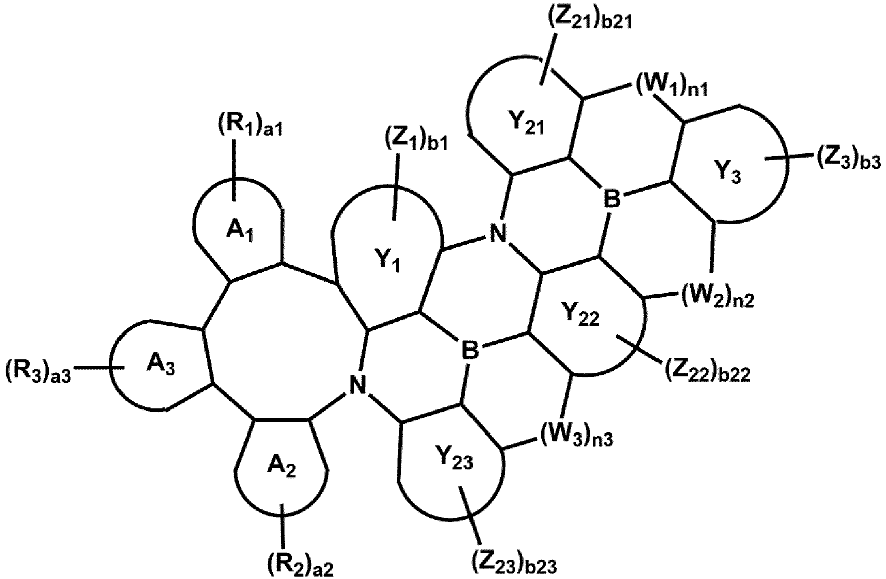 wherein, in Formulae 1, 2, and 3,
ring A₁ to ring A₃, ring Y₁ to ring Y₃, and ring Y₂₁ to ring Y₂₃ are each independently a C₅-C₆₀ carbocyclic group or a C₃-C₆₀ heterocyclic group,
W₁ is a single bond, O, S, N(T₁₁), C(T₁₁)(T₁₂), or Si(T₁₁)(T₁₂),
W₂ is a single bond, O, S, N(T₂₁), C(T₂₁)(T₂₂), or Si(T₂₁)(T₂₂),
W₃ is a single bond, O, S, N(T₃₁), C(T₃₁)(T₃₂), or Si(T₃₁)(T₃₂),
n1, n2, and n3 are each independently 0 or 1,
when n1 is 0, *-(W₁)ₙ₁-*' is not present,
when n2 is 0, *-(W₂)ₙ₂-*' is not present,
when n3 is 0, *-(W₃)ₙ₃-*' is not present,
the sum of n1 and n2 in Formula 1 is 1 or more and the sum of n1, n2 and n3 in Formulae 2 and 3 is 1 or more,
R₁ to R₃, Z₁ to Z₃, and Z₂₁ to Z₂₃ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
a1 to a3, b1 to b3, and b21 to b23 are each independently an integer from 0 to 10,
T₁₁, T₁₂, T₂₁, T₂₂, T₃₁, and T₃₂ are each i) as defined in connection with Z₁, or ii) linked to a neighboring substituent to form a condensed ring with a neighboring ring,
two or more of R₁, R₂, R₃, Z₁, Z₂, Z₃, Z₂₁, Z₂₂, Z₂₃, T₁₁, T₁₂, T₂₁, T₂₂, T₃₁, and T₃₂ are optionally linked to each other to form a substituted or unsubstituted C₅-C₃₀ carbocyclic group or a substituted or unsubstituted C₁-C₃₀ heterocyclic group,
a substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), - P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
any combination thereof, and
Q₁ to Q₉, Q₁₁ to Q₁₉, Q₂₁ to Q₂₉, and Q₃₁ to Q₃₉ are each independently: hydrogen; deuterium; -F; -Cl; -Br; -I; a hydroxyl group; a cyano group; a nitro group; an amino group; an amidino group; a hydrazine group; a hydrazone group; a carboxylic acid group or a salt thereof; a sulfonic acid group or a salt thereof; a phosphoric acid group or a salt thereof; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, a C₁-C₆₀ alkyl group, a C₆-C₆₀ aryl group, or any combination thereof.

5. The condensed polycyclic compound of claim 4, wherein ring A₁ to ring A₃, ring Y₁ to ring Y₃, and ring Y₂₁ to ring Y₂₃ are each independently a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, or an azadibenzosilole group.

6. The condensed polycyclic compound of claims 4 or 5, wherein in Formula 1, n1 is 1, W₁ is N(T₁₁), and Condition 1A or 1B is satisfied:
Condition 1A
one of Z₁ in the number of b1 and T₁₁ are linked to each other to form a condensed ring with a neighboring ring; and
Condition 1B
one of Z₃ in the number of b3 and T₁₁ are linked to each other to form a condensed ring with a neighboring ring; and/or
wherein in Formula 1, n2 is 1, W₂ is N(T₂₁), and Condition 1C or 1D is satisfied:
Condition 1C
one of Z₂ in the number of b2 and T₂₁ are linked to each other to form a condensed ring with a neighboring ring; and
Condition 1D
one of Z₃ in the number of b3 and T₂₁ are linked to each other to form a condensed ring with a neighboring ring.

7. The condensed polycyclic compound of any of claims 4-6, wherein Formula 1 satisfies at least one of Conditions 1E**,** 1F, and 1G:
Condition 1E
ring Y₁ is a C₃-C₆₀ heteropolycyclic group comprising at least one boron as a ring-forming atom,
wherein the C₃-C₆₀ heteropolycyclic group is a heteropolycyclic group comprising
i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
ii) at least one boron-containing 6-membered ring,
wherein i) and ii) are condensed with each other;
Condition 1F
ring Y₂ is a C₃-C₆₀ heteropolycyclic group comprising at least one boron as a ring-forming atom,
wherein the C₃-C₆₀ heteropolycyclic group is a heteropolycyclic group comprising
i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
ii) at least one boron-containing 6-membered ring,
wherein i) and ii) are condensed with each other; and
Condition 1G
ring Y₃ is a C₃-C₆₀ heteropolycyclic group comprising at least one boron as a ring-forming atom,
wherein the C₃-C₆₀ heteropolycyclic group is a heteropolycyclic group comprising
i) a benzene group, a naphthalene group, a phenanthrene group, a pyridine group, a pyrimidine group, a pyridazine group, a pyrazine group, a quinoline group, an isoquinoline group, a dibenzofuran group, a dibenzothiophene group, a carbazole group, a fluorene group, a dibenzosilole group, an azadibenzofuran group, an azadibenzothiophene group, an azacarbazole group, an azafluorene group, an azadibenzosilole group, or any combination thereof, and
ii) at least one boron-containing 6-membered ring,
wherein i) and ii) are condensed with each other.

8. The condensed polycyclic compound of any of claims 4-7, wherein R₁ to R₃, Z₁ to Z₃, Z₂₁ to Z₂₃, T₁₁, T₁₂, T₂₁, T₂₂, T₃₁, and T₃₂ are each independently:
hydrogen or deuterium;
a C₁-C₂₀ alkyl group, a phenyl group, a biphenyl group, or a carbazolyl group, each unsubstituted or substituted with deuterium, a C₁-C₂₀ alkyl group, a phenyl group, a biphenyl group, a carbazolyl group, or any combination thereof; or
-N(Q₁)(Q₂), and
Q₁ and Q₂ are each independently a phenyl group, a biphenyl group, or a carbazolyl group, each unsubstituted or substituted with deuterium, a C₁-C₂₀ alkyl group, a phenyl group, a biphenyl group, a carbazolyl group, or any combination thereof.

9. The condensed polycyclic compound of any of claims 4-8, wherein a moiety represented by 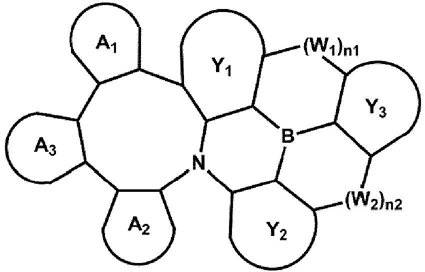 in Formula 1 is represented by one of Formulae 1A-1 to 1A-3, 1B-1 to 1B-2, 1C-1 to 1C-5, 1D-1 to 1D-5, and 1E-1 to 1E-5: 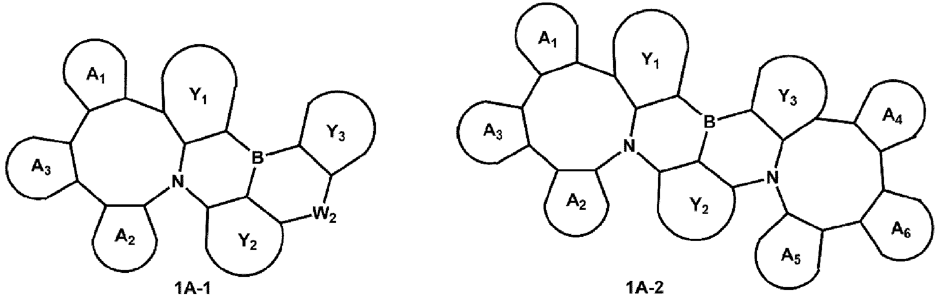 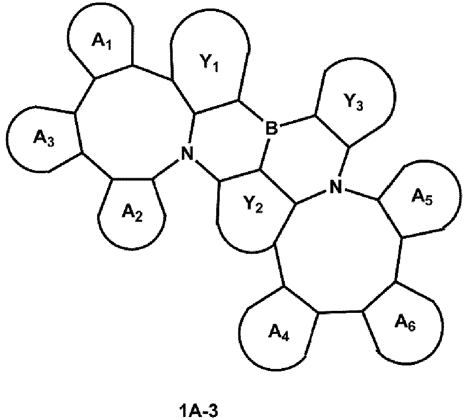 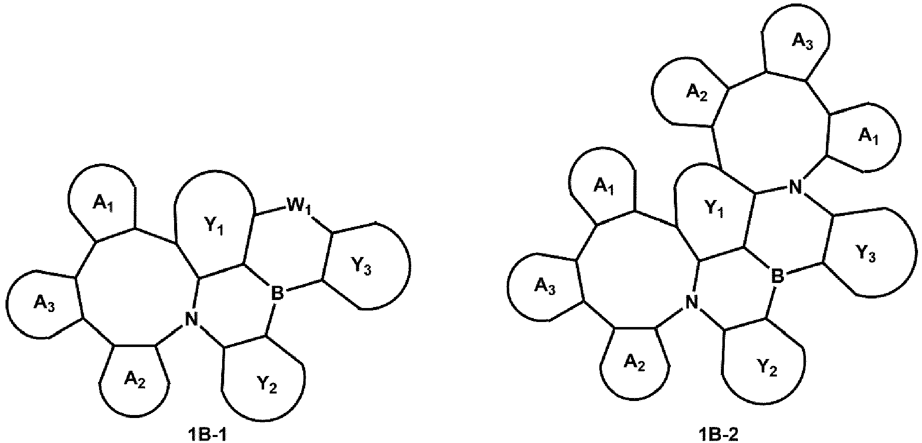 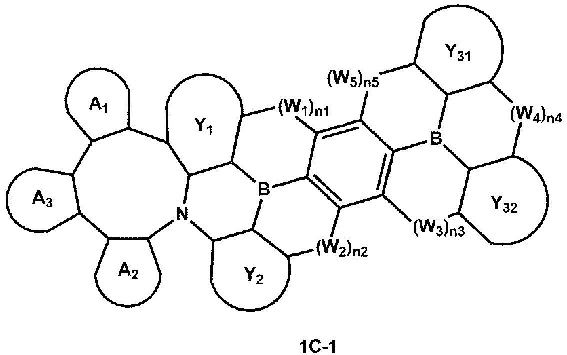 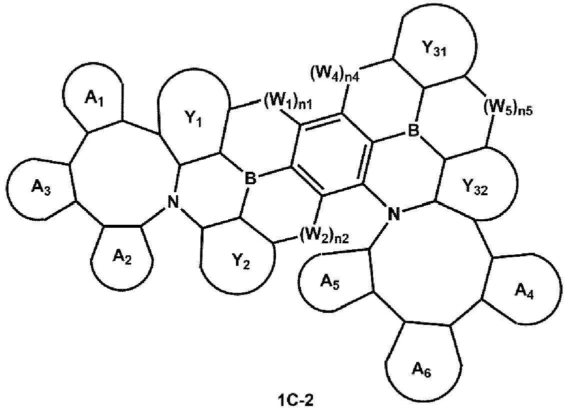 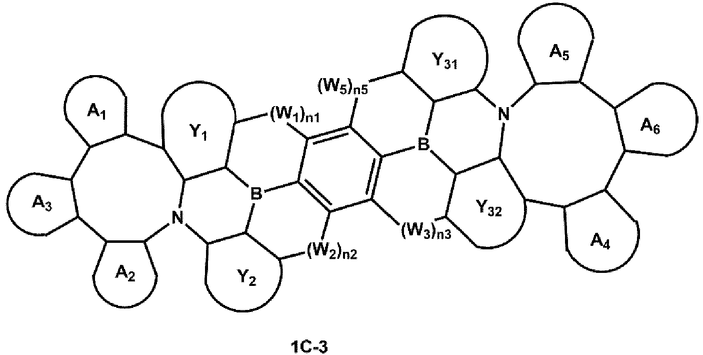 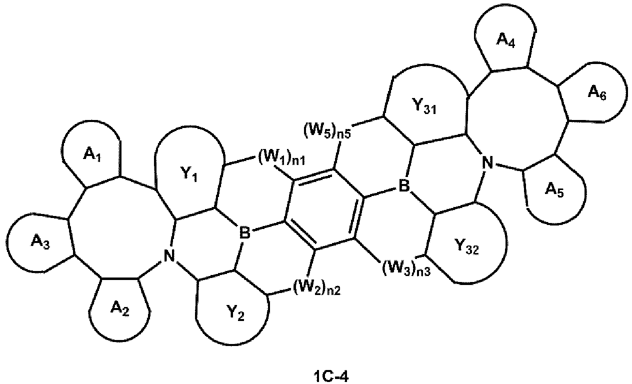 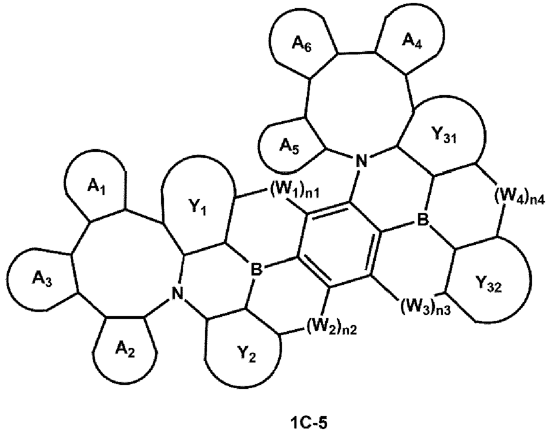 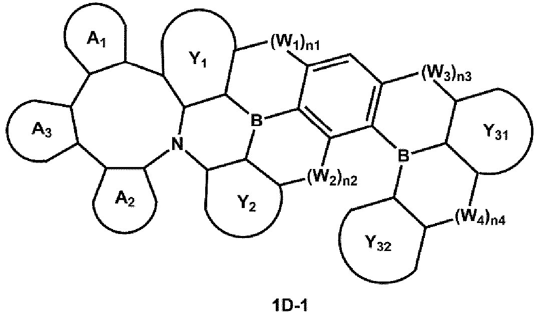 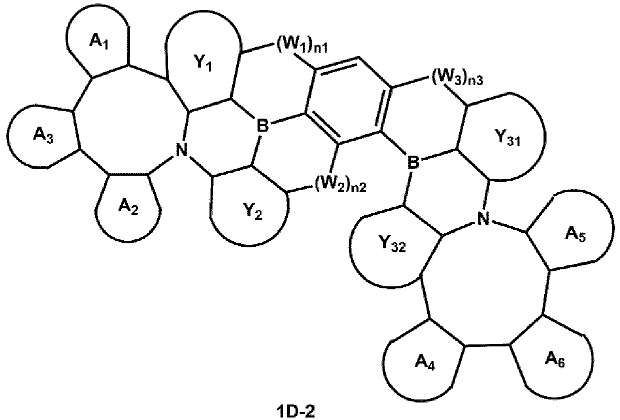 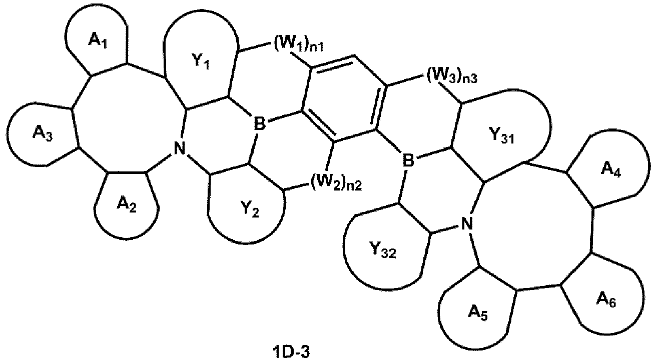 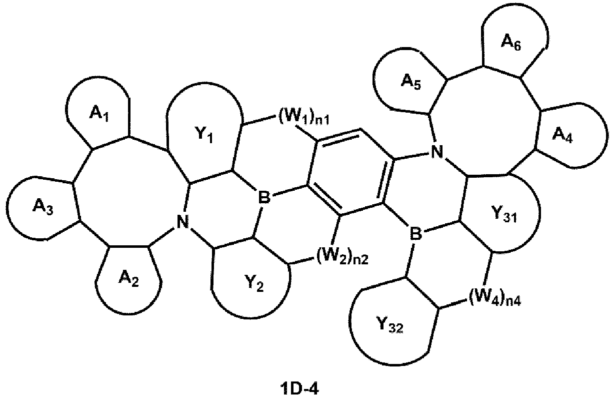 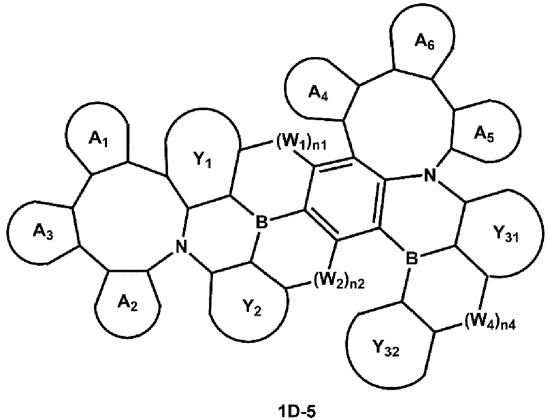 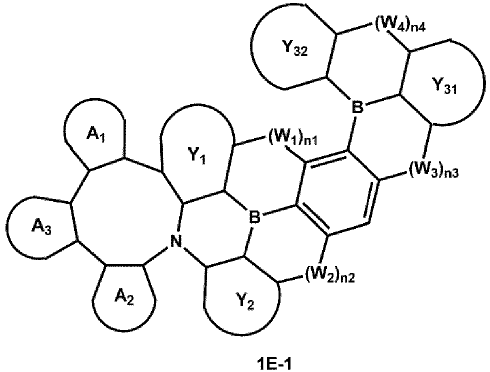 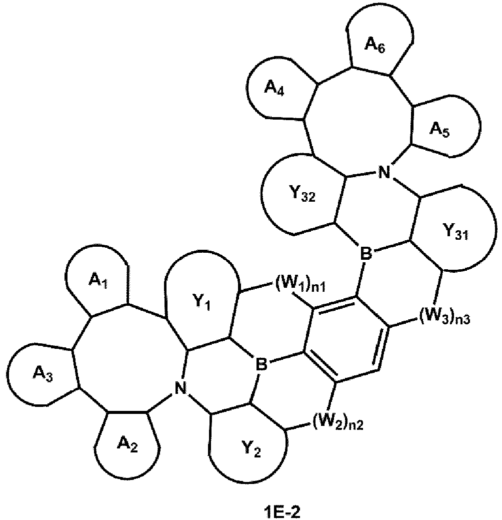 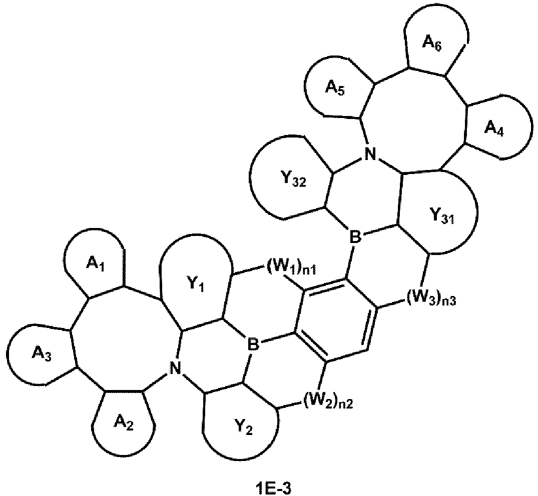 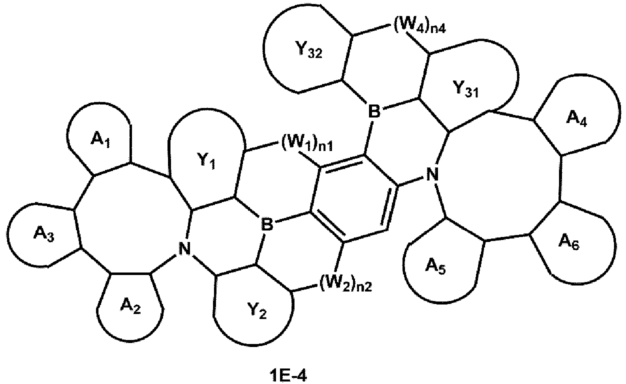 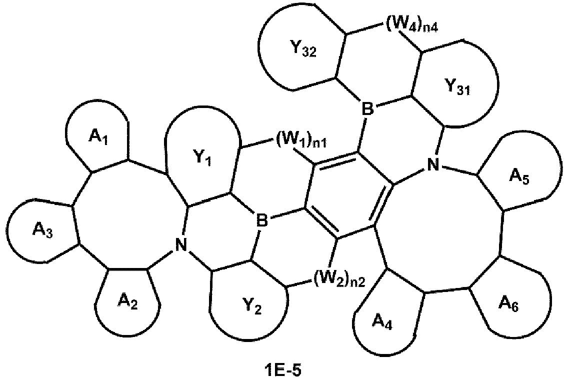
wherein, in Formulae 1A-1 to 1A-3, 1B-1 to 1B-2, 1C-1 to 1C-5, 1D-1 to 1D-5, and 1E-1 to 1E-5,
ring A₁ to ring A₃, ring Y₁ to ring Y₃, W₁, W₂, n1, and n2 are each as defined in claim 5,
ring A₄ to ring A₆ are each as defined in connection with ring A₁,
ring Y₃₁ and ring Y₃₂ are each as defined in connection with ring Y₃,
W₃ is a single bond, O, S, N(T₃₁), C(T₃₁)(T₃₂), or Si(T₃₁)(T₃₂),
W₄ is a single bond, O, S, N(T₄₁), C(T₄₁)(T₄₂), or Si(T₄₁)(T₄₂),
W₅ is a single bond, O, S, N(T₅₁), C(T₅₁)(T₅₂), or Si(T₅₁)(T₅₂),
T₃₁, T₃₂, T₄₁, T₄₂, T₅₁, and T₅₂ are each i) as defined in connection with Z₁, or ii) linked to a neighboring substituent to form another condensed ring with a neighboring ring,
n3 to n5 are each independently 0 or 1,
when n3 is 0, *-(W₃)ₙ₃-*' is not present,
when n4 is 0, *-(W₄)ₙ₄-*' is not present,
when n5 is 0, *-(W₅)ₙ₅-*' is not present,
in Formula 1C-1, the sum of n3, n4, and n5 is 1 or more,
in Formula 1C-2, the sum of n4 and n5 is 1 or more,
in Formulae 1C-3 and 1C-4, the sum of n3 and n5 is 1 or more,
in Formulae 1C-5, 1D-1, and 1E-1, the sum of n3 and n4 is 1 or more,
in Formulae 1D-2, 1D-3, 1E-2, and 1E-3, n3 is 1, and
in Formulae 1D-4, 1D-5, 1E-4, and 1E-5, n4 is 1.

10. A light-emitting device comprising:
a first electrode;
a second electrode; and
an interlayer arranged between the first electrode and the second electrode and comprising an emission layer,
wherein the interlayer comprises the condensed polycyclic compound of any of claims 1-9.

11. The light-emitting device of claim 10, wherein the emission layer comprises the condensed polycyclic compound;
preferably wherein an emission peak wavelength of light emitted from the emission layer is 440 nm to 470 nm.

12. The light-emitting device of claim 11, wherein the condensed polycyclic compound included in the emission layer is an emitter.

13. The light-emitting device of claims 11 or 12, wherein the emission layer further comprises a sensitizer, and the sensitizer is different from the condensed polycyclic compound;
preferably wherein the sensitizer is an organometallic compound, a delayed fluorescence material, a prompt fluorescence material, or any combination thereof;
preferably
wherein the organometallic compound comprises a transition metal and a tetradentate ligand bonded to the transition metal,
the transition metal is platinum or palladium, and
the tetradentate ligand comprises a carbene moiety bonded to the transition metal.

14. The light-emitting device of claim 11, wherein the condensed polycyclic compound included in the emission layer is a sensitizer.

15. An electronic apparatus comprising the light-emitting device of any of claims 10-14.

## Patentansprüche

1. Kondensierte polycyclische Verbindung, die kein Metall umfasst und einen kondensierten Ring umfasst,
wobei der kondensierte Ring einen 9-gliedrigen Ring, der Stickstoff und Kohlenstoff als ringbildende Atome umfasst, und einen 6-gliedrigen Ring, der Stickstoff, Kohlenstoff und Bor als ringbildende Atome umfasst, umfasst, wobei der 9-gliedrige Ring und der 6-gliedrige Ring miteinander kondensiert sind, während sie sich einen Stickstoff und einen Kohlenstoff teilen.

2. Kondensierte polycyclische Verbindung nach Anspruch 1, wobei der kondensierte Ring eine Moietät umfasst, die dargestellt ist durch Formel 1(1): 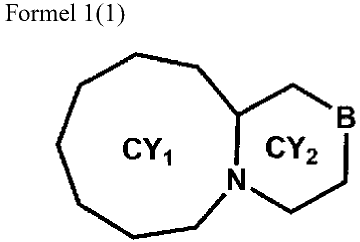 wobei, in Formel 1(1),
Ring CY₁ ein 9-gliedriger Ring ist, der Stickstoff und Kohlenstoff umfasst, und
Ring CY₂ ein 6-gliedriger Ring ist, der Stickstoff, Kohlenstoff und Bor umfasst.

3. Kondensierte polycyclische Verbindung nach Anspruch 2, wobei eine Anzahl der Moietät, die dargestellt ist durch Formel 1(1) der kondensierten polycyclischen Verbindung, 1, 2, 3 oder 4 beträgt; und/oder
wobei die kondensierte polycyclische Verbindung ein mehrfach resonantes thermisch aktiviertes, verzögert fluoreszierendes Material ist.

4. Kondensierte polycyclische Verbindung nach einem der Ansprüche 1-3, wobei die kondensierte polycyclische Verbindung dargestellt ist durch Formel 1, 2 oder 3: 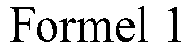 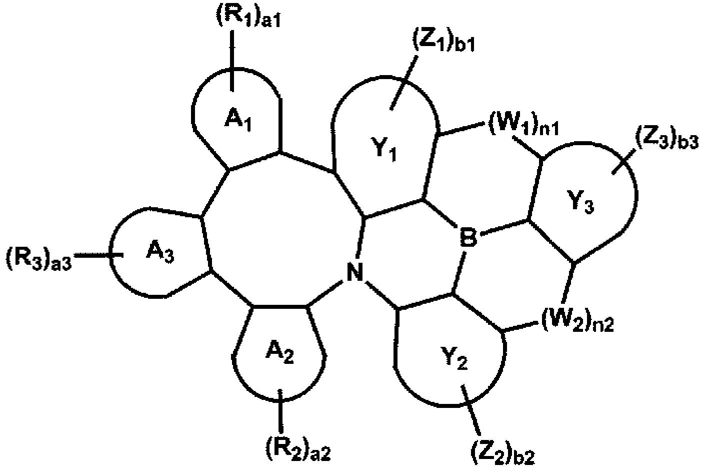 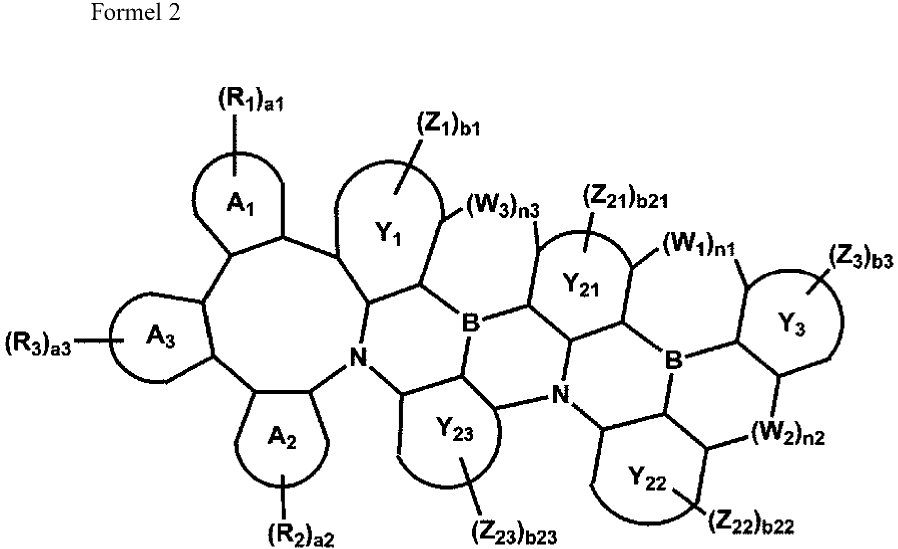 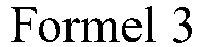 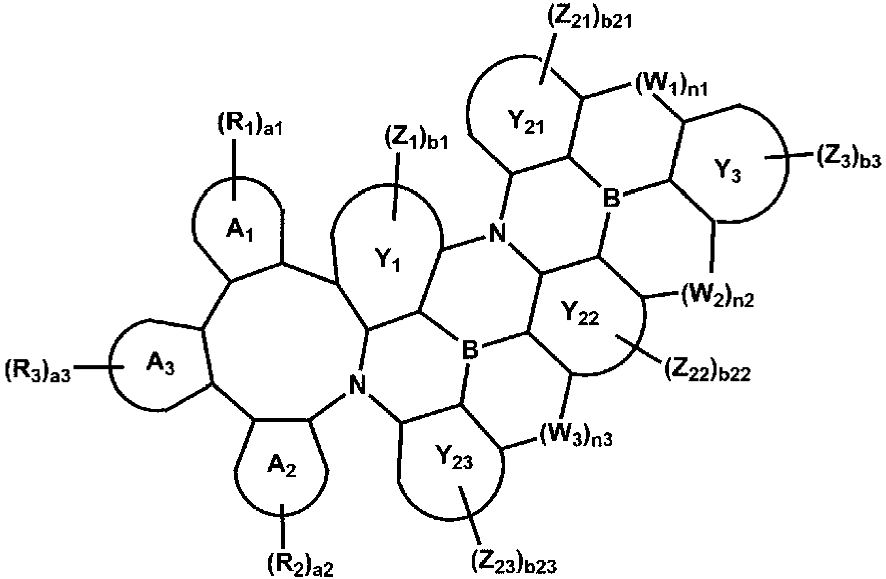 wobei, in Formel 1, 2 und 3,
Ring A₁ bis Ring A₃, Ring Y₁ bis Ring Y₃ und Ring Y₂₁ bis Ring Y₂₃ jeweils unabhängig eine carbocyclische C₅-C₆₀-Gruppe oder eine heterocyclische C₃-C₆₀-Gruppe sind,
W₁ eine Einfachbindung, O, S, N(T₁₁), C(T₁₁)(T₁₂) oder Si(T₁₁)(T₁₂) ist,
W₂ eine Einfachbindung, O, S, N(T₂₁), C(T₂₁)(T₂₂) oder Si(T₂₁)(T₂₂) ist,
W₃ eine Einfachbindung, O, S, N(T₃₁), C(T₃₁)(T₃₂) oder Si(T₃₁)(T₃₂) ist,
n1, n2 und n3 jeweils unabhängig 0 oder 1 sind,
wenn n1 0 ist, *-(W₁)ₙ₁-*' nicht vorhanden ist,
wenn n2 0 ist, *-(W₂)ₙ₂-*' nicht vorhanden ist,
wenn n3 0 ist, *-(W₃)ₙ₃-*' nicht vorhanden ist,
die Summe von n1 und n2, in Formel 1, 1 oder mehr ist und die Summe von n1, n2 und n3, in Formel 2 und 3, 1 oder mehr ist,
R₁ bis R₃, Z₁ bis Z₃ und Z₂₁ bis Z₂₃ jeweils unabhängig Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte einwertige nichtaromatische kondensierte polycyclische Gruppe, eine substituierte oder unsubstituierte einwertige nichtaromatische kondensierte heteropolycyclische Gruppe, -N(Q₁)(Q₂), - Si(Q₃)(Q₄)(Q₅), -Ge(Q₃)(Q₄)(Q₅), -B(Q₆)(Q₇), -P(=O)(Q₈)(Q₉) oder -P(Q₈)(Q₉) sind,
a1 bis a3, b1 bis b3 und b21 bis b23 jeweils unabhängig eine ganze Zahl von 0 bis 10 sind,
T₁₁, T₁₂, T₂₁, T₂₂, T₃₁ und T₃₂ jeweils i) wie in Verbindung mit Z₁ definiert sind oder ii) an einen benachbarten Substituenten gebunden sind, um einen kondensierten Ring mit einem benachbarten Ring zu bilden,
zwei oder mehr von R₁, R₂, R₃, Z₁, Z₂, Z₃, Z₂₁, Z₂₂, Z₂₃, T₁₁, T₁₂, T₂₁, T₂₂, T₃₁ und T₃₂ optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
ein Substituent der substituierten carbocyclischen C₅-C₃₀-Gruppe, der substituierten heterocyclischen C₁-C₃₀-Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten einwertigen nichtaromatischen kondensierten polycyclischen Gruppe und der substituierten einwertigen nichtaromatischen kondensierten heteropolycyclischen Gruppe Folgendes ist:
Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe;
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils substituiert mit Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine einwertige nichtaromatische kondensierte polycyclischen Gruppe, eine einwertige nichtaromatische kondensierte heteropolycyclische Gruppe, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), - P(Q₁₈)(Q₁₉) oder eine beliebige Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine einwertige nichtaromatische kondensierte polycyclische Gruppe, eine einwertige nichtaromatische kondensierte heteropolycyclische Gruppe, jeweils unsubstituiert oder substituiert mit Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe, eine C₁-C₆₀-Alkylthiogruppe, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine einwertige nichtaromatische kondensierte polycyclische Gruppe, eine einwertige nichtaromatische kondensierte heteropolycyclische Gruppe, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), -P(Q₂₈)(Q₂₉) oder eine beliebige Kombination davon;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉) oder -P(Q₃₈)(Q₃₉); oder
eine beliebige Kombination davon, und
Q₁ bis Q₉, Q₁₁ bis Q₁₉, Q₂₁ bis Q₂₉ und Q₃₁ bis Q₃₉ jeweils unabhängig Folgendes sind: Wasserstoff; Deuterium; -F; -Cl; -Br; -I; eine Hydroxygruppe; eine Cyanogruppe; eine Nitrogruppe; eine Aminogruppe; eine Amidinogruppe; eine Hydrazingruppe; eine Hydrazongruppe; eine Carboxylsäuregruppe oder ein Salz davon; eine Sulfonsäuregruppe oder ein Salz davon; eine Phosphorsäuregruppe oder ein Salz davon; oder eine C₁-C₆₀-Alkylgruppe, eine C₂-C₆₀-Alkenylgruppe, eine C₂-C₆₀-Alkinylgruppe, eine C₁-C₆₀-Alkoxygruppe, eine C₁-C₆₀-Alkylthiogruppe, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine einwertige nichtaromatische kondensierte polycyclische Gruppe oder eine einwertige nichtaromatische kondensierte heteropolycyclische Gruppe, jeweils unsubstituiert oder substituiert mit Deuterium, -F, -Cl, -Br, -I, eine C₁-C₆₀-Alkylgruppe, eine C₆-C₆₀-Arylgruppe oder eine beliebige Kombination davon.

5. Kondensierte polycyclische Verbindung nach Anspruch 4, wobei Ring A₁ bis Ring A₃, Ring Y₁ bis Ring Y₃ und Ring Y₂₁ bis Ring Y₂₃ jeweils unabhängig eine Benzolgruppe, eine Naphthalengruppe, eine Phenanthrengruppe, eine Pyridingruppe, eine Pyrimidingruppe, eine Pyridazingruppe, eine Pyrazingruppe, eine Chinolingruppe, eine Isochinolingruppe, eine Dibenzofurangruppe, eine Dibenzothiophengruppe, eine Carbazolgruppe, eine Fluorengruppe, eine Dibenzosilolgruppe, eine Azadibenzofurangruppe, eine Azadibenzothiophengruppe, eine Azacarbazolgruppe, eine Azafluorengruppe oder eine Azadibenzosilolgruppe sind.

6. Kondensierte polycyclische Verbindung nach Anspruch 4 oder 5, wobei, in Formel 1, n1 1 ist, W₁ N (T₁₁) ist und die Bedingung 1A oder 1B erfüllt ist:
Bedingung 1A
eines von Z₁ in der Anzahl von b1 und T₁₁ sind miteinander verknüpft, um einen kondensierten Ring mit einem benachbarten Ring zu bilden; und
Bedingung 1B
eines von Z₃ in der Anzahl von b3 und T₁₁ sind miteinander verknüpft, um einen kondensierten Ring mit einem benachbarten Ring zu bilden; und/oder
wobei, in Formel 1, n2 1 ist, W₂ N (T₂₁) ist und die Bedingung 1C oder 1D erfüllt ist:
Bedingung 1C
eines von Z₂ in der Anzahl von b2 und T₂₁ sind miteinander verknüpft, um einen kondensierten Ring mit einem benachbarten Ring zu bilden; und
Bedingung 1D
eines von Z₃ in der Anzahl von b3 und T₂₁ sind miteinander verknüpft, um einen kondensierten Ring mit einem benachbarten Ring zu bilden.

7. Kondensierte polycyclische Verbindung nach einem der Ansprüche 4-6, wobei Formel 1 mindestens eine der Bedingungen 1E, 1F und 1G erfüllt:
Bedingung 1E
Ring Y₁ ist eine heteropolycyclische C₃-C₆₀-Gruppe, die mindestens ein Bor als ringbildendes Atom umfasst,
wobei die heteropolycyclische C₃-C₆₀-Gruppe eine heteropolycyclische Gruppe ist, die Folgendes umfasst
i) eine Benzolgruppe, eine Naphthalengruppe, eine Phenanthrengruppe, eine Pyridingruppe, eine Pyrimidingruppe, eine Pyridazingruppe, eine Pyrazingruppe, eine Chinolingruppe, eine Isochinolingruppe, eine Dibenzofurangruppe, eine Dibenzothiophengruppe, eine Carbazolgruppe, eine Fluorengruppe, eine Dibenzosilolgruppe, eine Azadibenzofurangruppe, eine Azadibenzothiophengruppe, eine Azacarbazolgruppe, eine Azafluorengruppe, eine Azadibenzosilolgruppe oder eine beliebige Kombination davon und
ii) mindestens einen borhaltigen 6-gliedrigen Ring,
wobei i) und ii) miteinander kondensiert sind;
Bedingung 1F
Ring Y₂ ist eine heteropolycyclische C₃-C₆₀-Gruppe, die mindestens ein Bor als ringbildendes Atom umfasst,
wobei die heteropolycyclische C₃-C₆₀-Gruppe eine heteropolycyclische Gruppe ist, die Folgendes umfasst
i) eine Benzolgruppe, eine Naphthalengruppe, eine Phenanthrengruppe, eine Pyridingruppe, eine Pyrimidingruppe, eine Pyridazingruppe, eine Pyrazingruppe, eine Chinolingruppe, eine Isochinolingruppe, eine Dibenzofurangruppe, eine Dibenzothiophengruppe, eine Carbazolgruppe, eine Fluorengruppe, eine Dibenzosilolgruppe, eine Azadibenzofurangruppe, eine Azadibenzothiophengruppe, eine Azacarbazolgruppe, eine Azafluorengruppe, eine Azadibenzosilolgruppe oder eine beliebige Kombination davon und
ii) mindestens einen borhaltigen 6-gliedrigen Ring,
wobei i) und ii) miteinander kondensiert sind; und
Bedingung 1G
Ring Y₃ ist eine heteropolycyclische C₃-C₆₀-Gruppe, die mindestens ein Bor als ringbildendes Atom umfasst,
wobei die heteropolycyclische C₃-C₆₀-Gruppe eine heteropolycyclische Gruppe ist, die Folgendes umfasst
i) eine Benzolgruppe, eine Naphthalengruppe, eine Phenanthrengruppe, eine Pyridingruppe, eine Pyrimidingruppe, eine Pyridazingruppe, eine Pyrazingruppe, eine Chinolingruppe, eine Isochinolingruppe, eine Dibenzofurangruppe, eine Dibenzothiophengruppe, eine Carbazolgruppe, eine Fluorengruppe, eine Dibenzosilolgruppe, eine Azadibenzofurangruppe, eine Azadibenzothiophengruppe, eine Azacarbazolgruppe, eine Azafluorengruppe, eine Azadibenzosilolgruppe oder eine beliebige Kombination davon und
ii) mindestens einen borhaltigen 6-gliedrigen Ring,
wobei i) und ii) miteinander kondensiert sind.

8. Kondensierte polycyclische Verbindung nach einem der Ansprüche 4-7, wobei R₁ bis R₃, Z₁ bis Z₃, Z₂₁ bis Z₂₃, T₁₁, T₁₂, T₂₁, T₂₂, T₃₁ und T₃₂ jeweils unabhängig Folgendes sind:
Wasserstoff oder Deuterium;
eine C₁-C₂₀-Alkylgruppe, eine Phenylgruppe, eine Biphenylgruppe oder eine Carbazolylgruppe, jeweils unsubstituiert oder substituiert mit Deuterium, eine C₁-C₂₀-Alkylgruppe, eine Phenylgruppe, eine Biphenylgruppe, eine Carbazolylgruppe oder eine beliebige Kombination davon; oder
-N(Q₁)(Q₂) und
Q₁ und Q₂ jeweils unabhängig eine Phenylgruppe, eine Biphenylgruppe oder eine Carbazolylgruppe, jeweils unsubstituiert oder substituiert mit Deuterium, eine C₁-C₂₀-Alkylgruppe, eine Phenylgruppe, eine Biphenylgruppe, eine Carbazolylgruppe oder eine beliebige Kombination davon sind.

9. Kondensierte polycyclische Verbindung nach einem der Ansprüche 4-8, wobei eine Moietät, die dargestellt ist durch 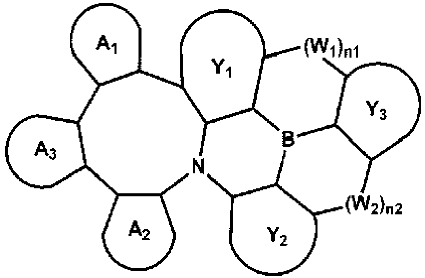 in Formel 1, durch eine der Formeln 1A-1 bis 1A-3, 1B-1 bis 1B-2, 1C-1 bis 1C-5, 1D-1 bis 1D-5 und 1E-1 bis 1E-5 dargestellt ist: 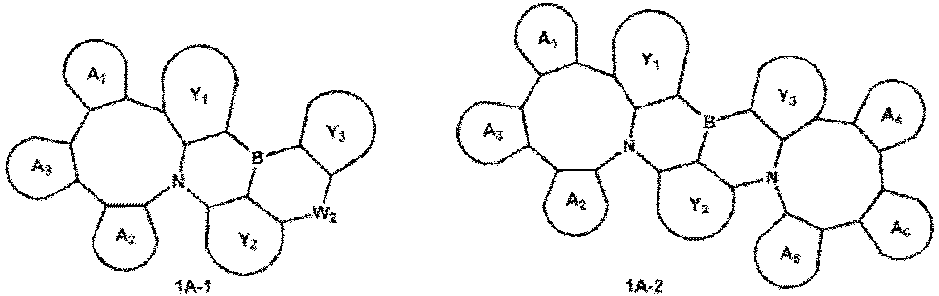 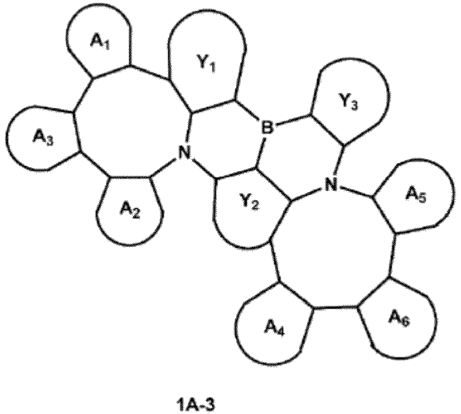 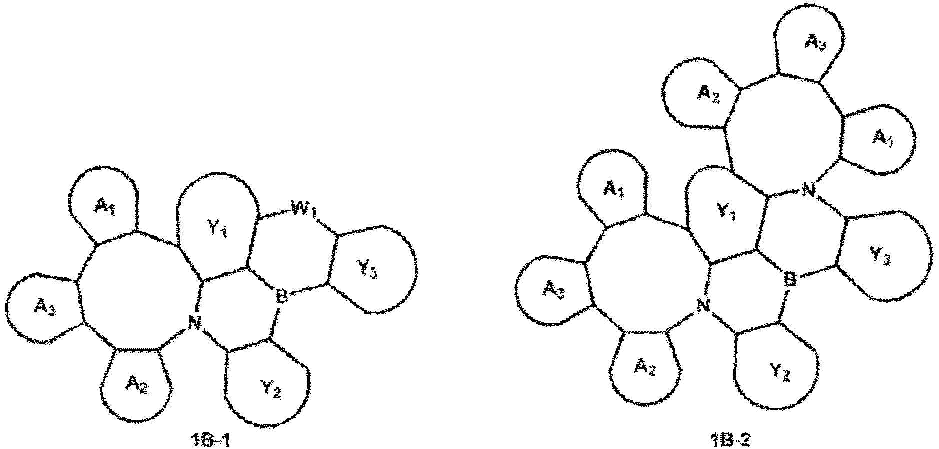 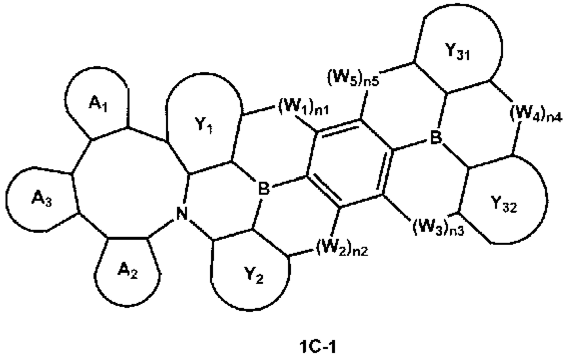 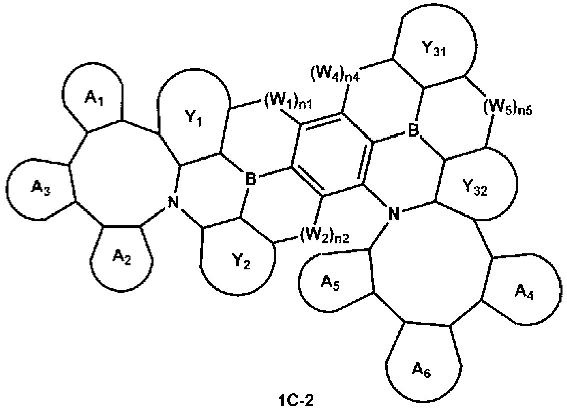 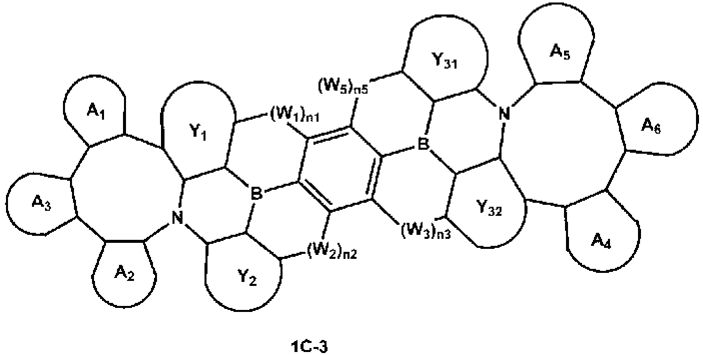 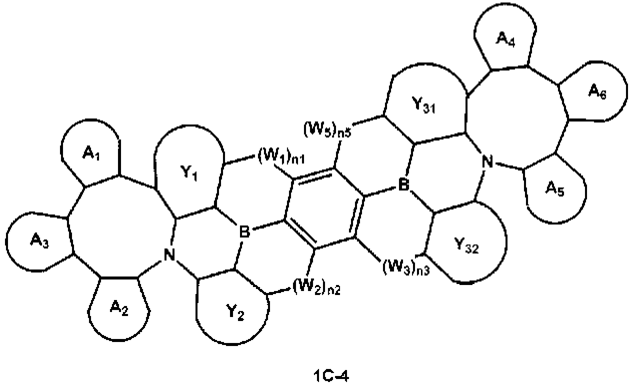 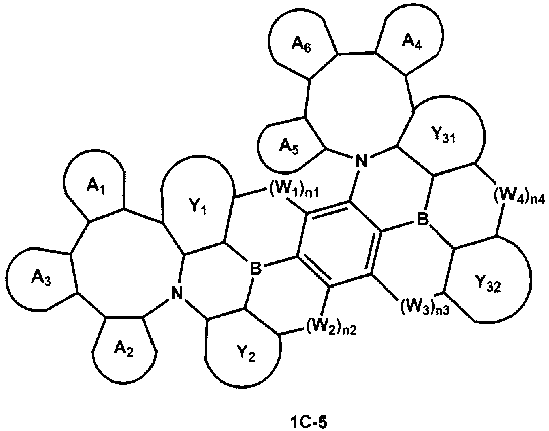 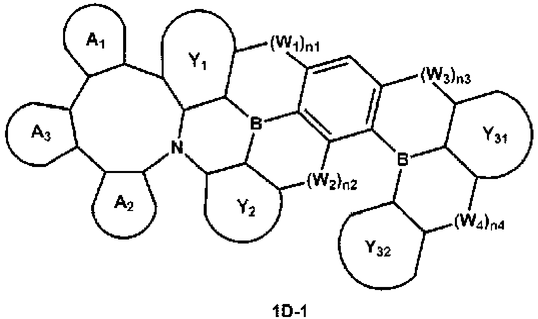 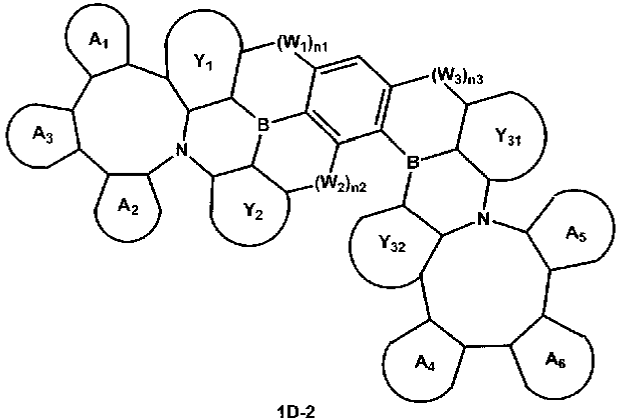 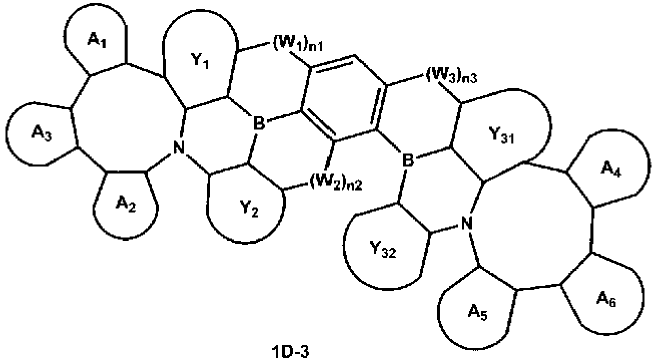 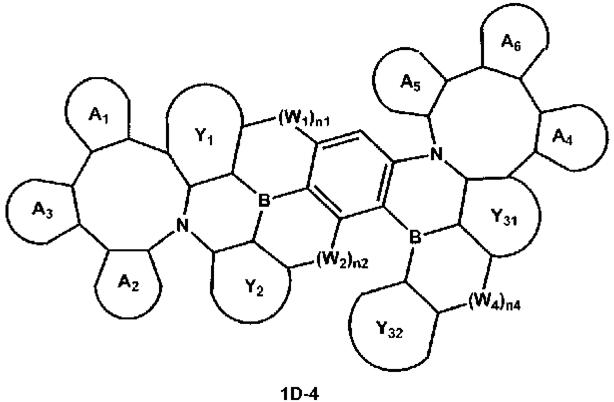 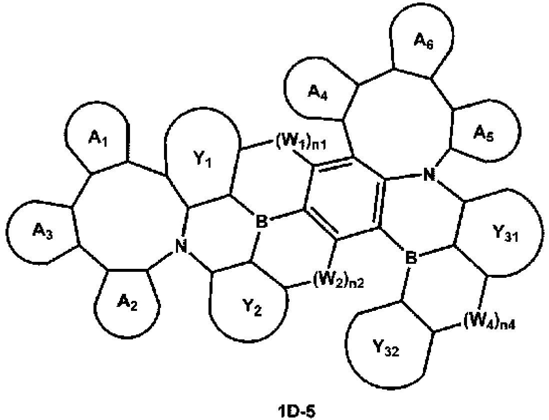 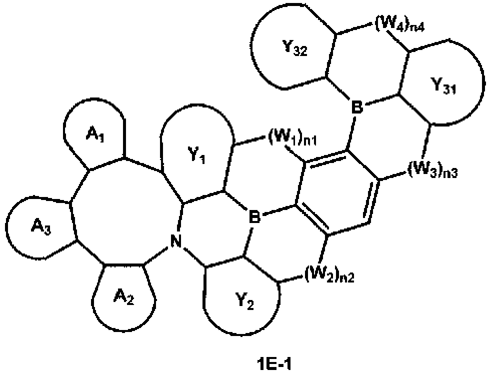 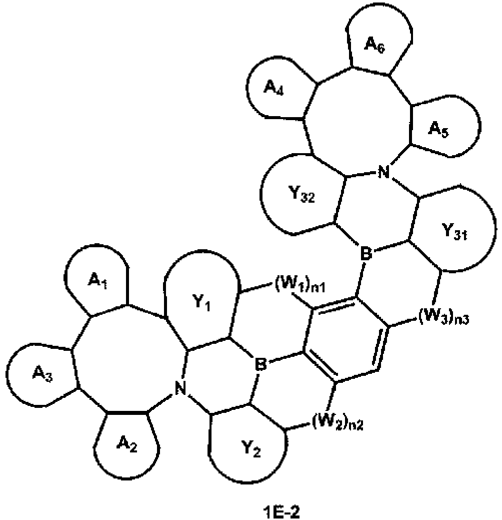 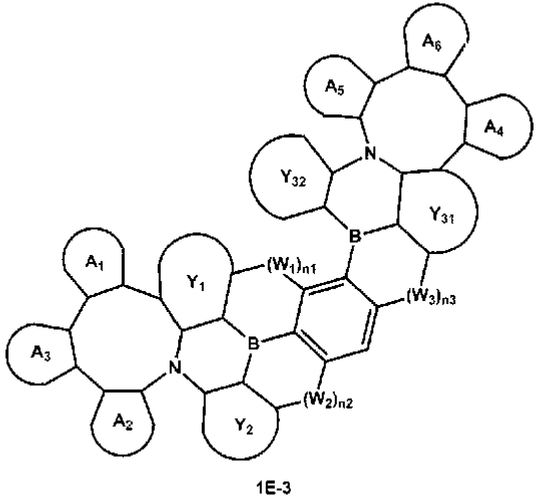 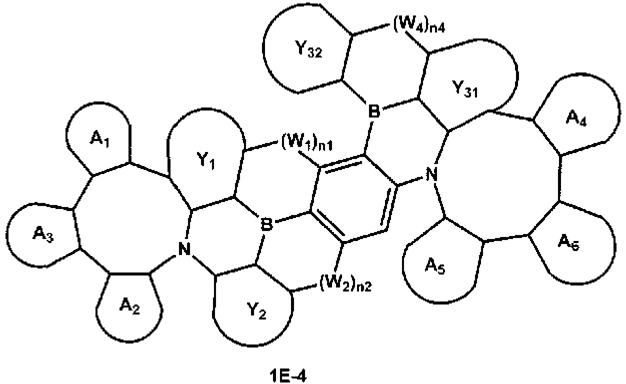 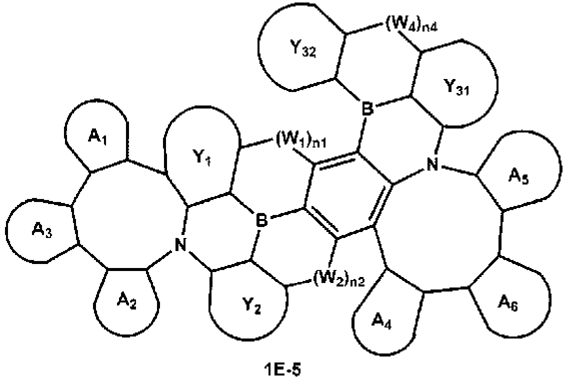
wobei, in Formel 1A-1 bis 1A-3, 1B-1 bis 1B-2, 1C-1 bis 1C-5, 1D-1 bis 1D-5 und 1E-1 bis 1E-5,
Ring A₁ bis Ring A₃, Ring Y₁ bis Ring Y₃, W₁, W₂, n1 und n2 jeweils wie in Anspruch 5 definiert sind,
Ring A₄ bis Ring A₆ jeweils wie in Verbindung mit Ring A₁ definiert sind,
Ring Y₃₁ und Ring Y₃₂ jeweils wie in Verbindung mit Ring Y₃ definiert sind,
W₃ eine Einzelbindung, O, S, N(T₃₁), C(T₃₁)(T₃₂) oder Si(T₃₁)(T₃₂) ist,
W₄ eine Einzelbindung, O, S, N(T₄₁), C(T₄₁)(T₄₂) oder Si(T₄₁)(T₄₂) ist,
W₅ eine Einzelbindung, O, S, N(T₅₁), C(T₅₁)(T₅₂) oder Si(T₅₁)(T₅₂) ist,
T₃₁, T₃₂, T₄₁, T₄₂, T₅₁ und T₅₂ jeweils i) wie in Verbindung mit Z₁ definiert sind oder ii) an einen benachbarten Substituenten gebunden sind, um einen anderen kondensierten Ring mit einem benachbarten Ring zu bilden,
n3 bis n5 jeweils unabhängig 0 oder 1 sind,
wenn n3 0 ist, *-(W₃)ₙ₃-*' nicht vorhanden ist,
wenn n4 0 ist, *-(W₄)ₙ₄-*' nicht vorhanden ist,
wenn n5 0 ist, *-(W₅)ₙ₅-*' nicht vorhanden ist,
in Formel 1C-1 die Summe von n3, n4 und n5 1 oder mehr ist,
in Formel 1C-2 die Summe von n4 und n5 1 oder mehr ist,
in Formel 1C-3 und 1C-4 die Summe von n3 und n5 1 oder mehr ist,
in Formel 1C-5, 1D-1 und 1E-1 die Summe von n3 und n4 1 oder mehr ist,
in Formel 1D-2, 1D-3, 1E-2 und 1E-3 n3 1 ist, und
in Formel 1D-4, 1D-5, 1E-4 und 1E-5 n4 1 ist.

10. Lichtemittierende Vorrichtung, umfassend:
eine erste Elektrode;
eine zweite Elektrode; und
eine Zwischenschicht, die zwischen der ersten Elektrode und der zweiten Elektrode angeordnet ist und eine Emissionsschicht umfasst,
wobei die Zwischenschicht die kondensierte polycyclische Verbindung nach einem der Ansprüche 1-9 umfasst.

11. Lichtemittierende Vorrichtung nach Anspruch 10, wobei die Emissionsschicht die kondensierte polycylische Verbindung umfasst;
bevorzugt, wobei eine Emissionsspitzenwellenlänge von Licht, das aus der Emissionsschicht emittiert wird, 440 nm bis 470 nm beträgt.

12. Lichtemittierende Vorrichtung nach Anspruch 11, wobei die in der Emissionsschicht beinhaltete kondensierte polycyclische Verbindung ein Emitter ist.

13. Lichtemittierende Vorrichtung nach Anspruch 11 oder 12, wobei die Emissionsschicht ferner einen Sensibilisator umfasst und sich der Sensibilisator von der kondensierten polycyclischen Verbindung unterscheidet;
bevorzugt, wobei der Sensibilisator eine organometallische Verbindung, ein verzögert fluoreszierendes Material, ein prompt fluoreszierendes Material oder eine beliebige Kombination davon ist;
bevorzugt,
wobei die organometallische Verbindung ein Übergangsmetall und einen vierzähnigen Liganden, der an das Übergangsmetall gebunden ist, umfasst,
das Übergangsmetall Platin oder Palladium ist und
der vierzähnige Ligand eine Carben-Moietät umfasst, die an das Übergangsmetall gebunden ist.

14. Lichtemittierende Vorrichtung nach Anspruch 11, wobei die in der Emissionsschicht beinhaltete kondensierte polycyclische Verbindung ein Sensibilisator ist.

15. Elektronische Vorrichtung, umfassend die lichtemittierende Vorrichtung nach einem der Ansprüche 10-14.

## Revendications

1. Composé polycyclique condensé, qui ne comprend pas de métal et qui comprend un cycle condensé,
dans lequel le cycle condensé comprend un cycle à 9 chaînons comprenant de l'azote et du carbone en tant qu'atomes formant le cycle et un cycle à 6 chaînons comprenant de l'azote, du carbone et du bore en tant qu'atomes formant le cycle, dans lequel le cycle à 9 chaînons et le cycle à 6 chaînons sont condensés l'un avec l'autre tout en partageant un azote et un carbone.

2. Composé polycyclique condensé de la revendication 1, dans lequel le cycle condensé comprend un fragment représenté par la Formule 1(1) : 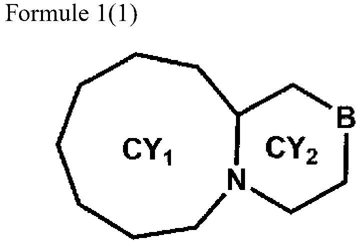 dans lequel, dans la Formule 1(1),
le cycle CY₁ est un cycle à 9 chaînons comprenant de l'azote et du carbone, et
le cycle CY₂ est un cycle à 6 chaînons comprenant de l'azote, du carbone et du bore.

3. Composé polycyclique condensé de la revendication 2, dans lequel le nombre de fragments représentés par la Formule 1(1) du composé polycyclique condensé est égal à 1, 2, 3 ou 4 ; et/ou
dans lequel le composé polycyclique condensé est un matériau à fluorescence retardée activée thermiquement à résonance multiple.

4. Composé polycyclique condensé de l'une quelconque des revendications 1 à 3, dans lequel le composé polycyclique condensé est représenté par la Formule 1, 2 ou 3 : 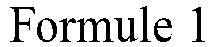 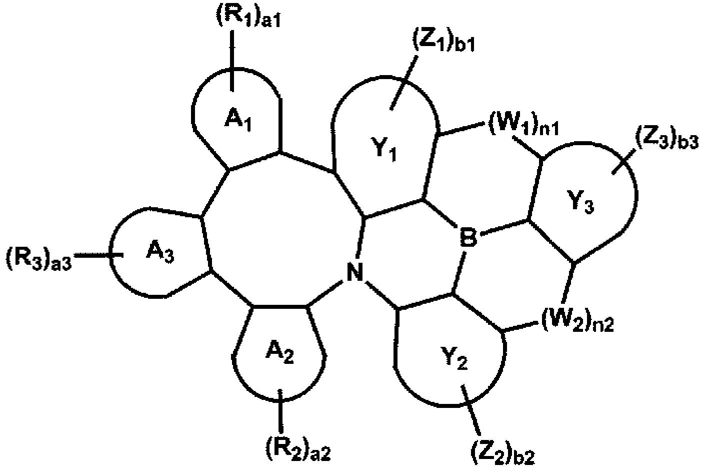 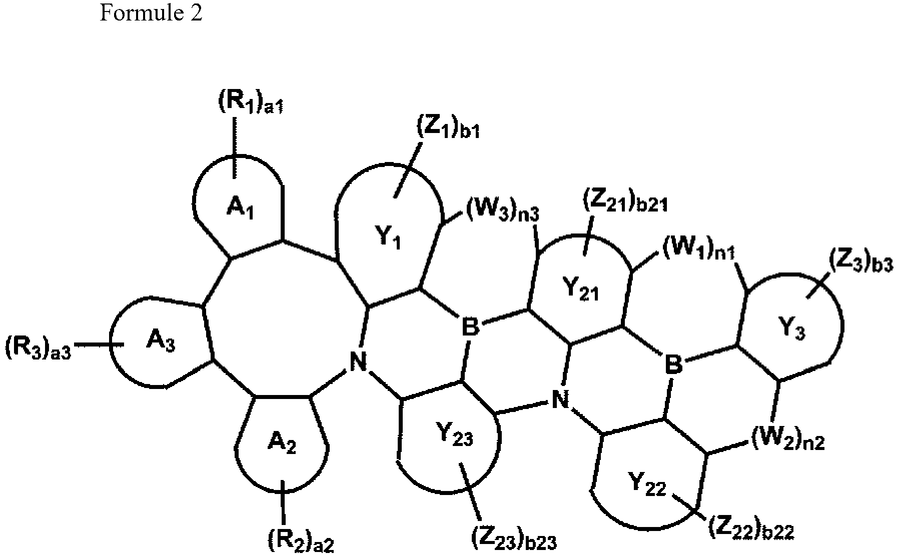 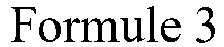 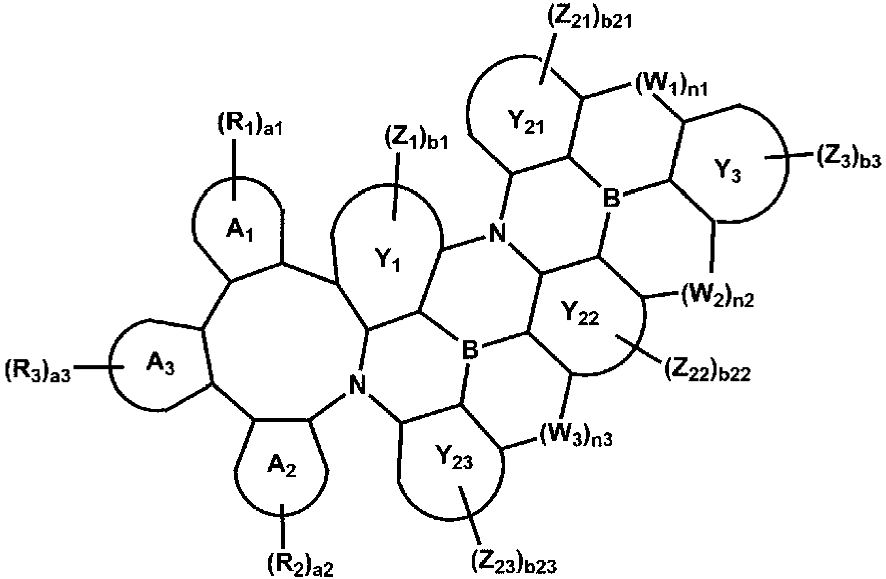 dans lequel, dans les Formules 1, 2 et 3,
les cycles A₁ à A₃, les cycles Y₁ à Y₃ et les cycles Y₂₁ à Y₂₃ sont chacun indépendamment un groupe carbocyclique en C₅-C₆₀ ou un groupe hétérocyclique en C₃-C₆₀,
W₁ est une liaison simple, O, S, N(T₁₁), C(T₁₁)(T₁₂) ou Si(T₁₁)(T₁₂),
W₂ est une liaison simple, O, S, N(T₂₁), C(T₂₁)(T₂₂) ou Si(T₂₁)(T₂₂),
W₃ est une liaison simple, O, S, N(T₃₁), C(T₃₁)(T₃₂) ou Si(T₃₁)(T₃₂),
n1, n2 et n3 valent chacun indépendamment 0 ou 1,
lorsque n1 vaut 0, *-(W₁)ₙ₁-*' n'est pas présent,
lorsque n2 vaut 0, *-(W₂)ₙ₂-*' n'est pas présent,
lorsque n3 vaut 0, *-(W₃)ₙ₃-*' n'est pas présent,
la somme de n1 et n2 dans la Formule 1 est égale à 1 ou plus et la somme de n1, n2 et n3 dans les Formules 2 et 3 est égale à 1 ou plus,
R₁ à R₃, Z₁ à Z₃ et Z₂₁ à Z₂₃ sont chacun indépendamment un hydrogène, un deutérium, - F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe alkylthio en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -Ge(Q₃)(Q₄)(Q₅), -B(Q₆)(Q₇), - P(=O)(Q₈)(Q₉) ou -P(Q₈)(Q₉),
a1 à a3, b1 à b3 et b21 à b23 sont chacun indépendamment un nombre entier de 0 à 10,
T₁₁, T₁₂, T₂₁, T₂₂, T₃₁ et T₃₂ sont chacun i) tels que définis en relation avec Z₁, ou ii) liés à un substituant voisin pour former un cycle condensé avec un cycle voisin, deux de R₁, R₂, R₃, Z₁, Z₂, Z₃, Z₂₁, Z₂₂, Z₂₃, T₁₁, T₁₂, T₂₁, T₂₂, T₃₁ et T₃₂ ou plus sont éventuellement liés l'un à l'autre pour former un groupe carbocyclique en C₅-C₃₀ substitué ou non substitué ou un groupe hétérocyclique en C₁-C₃₀ substitué ou non substitué,
un substituant du groupe carbocyclique en C₅-C₃₀ substitué, du groupe hétéropolycyclique en C₁-C₃₀ substitué, du groupe alkyle en C₁-C₆₀ substitué, du groupe alcényle en C₂-C₆₀ substitué, du groupe alcynyle en C₂-C₆₀ substitué, du groupe alcoxy en C₂-C₆₀ substitué, du groupe alkylthio en C₂-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non aromatique monovalent substitué et du groupe hétéropolycyclique condensé non aromatique monovalent substitué est :
un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀ ou un groupe alkylthio en C₁-C₆₀ ;
un groupe alkyle en C₁-C₆₀, un groupe alcényle en C₂-C₆₀, un groupe alcynyle en C₂-C₆₀, un groupe alcoxy en C₁-C₆₀ ou un groupe alkylthio en C₁-C₆₀, chacun étant substitué par un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, - N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), - P(Q₁₈)(Q₁₉) ou toute combinaison de ceux-ci ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent ou un groupe hétéropolycyclique condensé non aromatique monovalent, chacun étant non substitué ou substitué par un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀, un groupe alkylthio en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), -P(Q₂₈)(Q₂₉) ou toute combinaison de ceux-ci ;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉) ou - P(Q₃₈)(Q₃₉) ; ou
toute combinaison de ceux-ci, et
Q₁ à Q₉, Q₁₁ à Q₁₉, Q₂₁ à Q₂₉ et Q₃₁ à Q₃₉ sont chacun indépendamment : un hydrogène ; un deutérium ; -F ; -Cl ; -Br ; -I ; un groupe hydroxyle ; un groupe cyano ; un groupe nitro ; un groupe amino ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; ou un groupe alkyle en C₁-C₆₀, un groupe alcényle en C₂-C₆₀, un groupe alcynyle en C₂-C₆₀, un groupe alcoxy en C₁-C₆₀, un groupe alkylthio en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent ou un groupe hétéropolycyclique condensé non aromatique monovalent, chacun étant non substitué ou substitué par un deutérium, -F, -Cl, -Br, -I, un groupe alkyle en C₁-C₆₀, un groupe aryle en C₆-C₆₀ ou toute combinaison de ceux-ci.

5. Composé polycyclique condensé de la revendication 4, dans lequel les cycles A₁ à A₃, les cycles Y₁ à Y₃ et les cycles Y₂₁ à Y₂₃ sont chacun indépendamment un groupe benzène, un groupe naphtalène, un groupe phénanthrène, un groupe pyridine, un groupe pyrimidine, un groupe pyridazine, un groupe pyrazine, un groupe quinoline, un groupe isoquinoline, un groupe dibenzofurane, un groupe dibenzothiophène, un groupe carbazole, un groupe fluorène, un groupe dibenzosilole, un groupe azadibenzofurane, un groupe azadibenzothiophène, un groupe azacarbazole, un groupe azafluorène ou un groupe azadibenzosilole.

6. Composé polycyclique condensé des revendications 4 ou 5, dans lequel dans la Formule 1, n1 vaut 1, W₁ est N(T₁₁), et la Condition 1A ou 1B est satisfaite :
Condition 1A
l'un de Z₁, au nombre de b1, et T₁₁ sont liés l'un à l'autre pour former un cycle condensé avec un cycle voisin ; et
Condition 1B
l'un de Z₃, au nombre de b3, et T₁₁ sont liés l'un à l'autre pour former un cycle condensé avec un cycle voisin ; et/ou
dans lequel dans la Formule 1, n2 vaut 1, W₂ est N(T₂₁), et la Condition 1C ou 1D est satisfaite :
Condition 1C
l'un de Z₂, au nombre de b2, et T₂₁ sont liés l'un à l'autre pour former un cycle condensé avec un cycle voisin ; et
Condition 1D
l'un de Z₃, au nombre de b3, et T₂₁ sont liés l'un à l'autre pour former un cycle condensé avec un cycle voisin.

7. Composé polycyclique condensé de l'une quelconque des revendications 4 à 6, dans lequel la Formule 1 satisfait au moins l'une des Conditions 1E, 1F et 1G :
Condition 1E
le cycle Y₁ est un groupe hétéropolycyclique en C₃-C₆₀ comprenant au moins un bore en tant qu'atome formant le cycle,
dans lequel le groupe hétéropolycyclique en C₃-C₆₀ est un groupe hétéropolycyclique comprenant
i) un groupe benzène, un groupe naphthalène, un groupe phénanthrène, un groupe pyridine, un groupe pyrimidine, un groupe pyridazine, un groupe pyrazine, un groupe quinoline, un groupe isoquinoline, un groupe dibenzofurane, un groupe dibenzothiophène, un groupe carbazole, un groupe fluorène, un groupe dibenzosilole, un groupe azadibenzofurane, un groupe azadibenzothiophène, un groupe azacarbazole, un groupe azafluorène, un groupe azadibenzosilole ou toute combinaison de ceux-ci, et
ii) au moins un cycle à 6 chaînons contenant du bore,
dans lequel i) et ii) sont condensés l'un avec l'autre ;
Condition 1F
le cycle Y₂ est un groupe hétéropolycyclique en C₃-C₆₀ comprenant au moins un bore en tant qu'atome formant le cycle,
dans lequel le groupe hétéropolycyclique en C₃-C₆₀ est un groupe hétéropolycyclique comprenant
i) un groupe benzène, un groupe naphthalène, un groupe phénanthrène, un groupe pyridine, un groupe pyrimidine, un groupe pyridazine, un groupe pyrazine, un groupe quinoline, un groupe isoquinoline, un groupe dibenzofurane, un groupe dibenzothiophène, un groupe carbazole, un groupe fluorène, un groupe dibenzosilole, un groupe azadibenzofurane, un groupe azadibenzothiophène, un groupe azacarbazole, un groupe azafluorène, un groupe azadibenzosilole ou toute combinaison de ceux-ci, et
ii) au moins un cycle à 6 chaînons contenant du bore,
dans lequel i) et ii) sont condensés l'un avec l'autre ; et
Condition 1G
le cycle Y₃ est un groupe hétéropolycyclique en C₃-C₆₀ comprenant au moins un bore en tant qu'atome formant le cycle,
dans lequel le groupe hétéropolycyclique en C₃-C₆₀ est un groupe hétéropolycyclique comprenant
i) un groupe benzène, un groupe naphthalène, un groupe phénanthrène, un groupe pyridine, un groupe pyrimidine, un groupe pyridazine, un groupe pyrazine, un groupe quinoline, un groupe isoquinoline, un groupe dibenzofurane, un groupe dibenzothiophène, un groupe carbazole, un groupe fluorène, un groupe dibenzosilole, un groupe azadibenzofurane, un groupe azadibenzothiophène, un groupe azacarbazole, un groupe azafluorène, un groupe azadibenzosilole ou toute combinaison de ceux-ci, et
ii) au moins un cycle à 6 chaînons contenant du bore,
dans lequel i) et ii) sont condensés l'un avec l'autre.

8. Composé polycyclique condensé de l'une quelconque des revendications 4 à 7, dans lequel R₁ à R₃, Z₁ à Z₃, Z₂₁ à Z₂₃, T₁₁, T₁₂, T₂₁, T₂₂, T₃₁ et T₃₂ sont chacun indépendamment :
un hydrogène ou un deutérium ;
un groupe alkyle en C₁-C₂₀, un groupe phényle, un groupe biphényle ou un groupe carbazolyle, chacun étant non substitué ou substitué par un deutérium, un groupe alkyle en C₁-C₂₀, un groupe phényle, un groupe biphényle, un groupe carbazolyle ou toute combinaison de ceux-ci ; ou
-N(Q₁)(Q₂), et
Q₁ et Q₂ sont chacun indépendamment un groupe phényle, un groupe biphényle ou un groupe carbazolyle, chacun étant non substitué ou substitué par un deutérium, un groupe alkyle en C₁-C₂₀, un groupe phényle, un groupe biphényle, un groupe carbazolyle ou toute combinaison de ceux-ci.

9. Composé polycyclique condensé de l'une quelconque des revendications 4 à 8, dans lequel un fragment représenté par 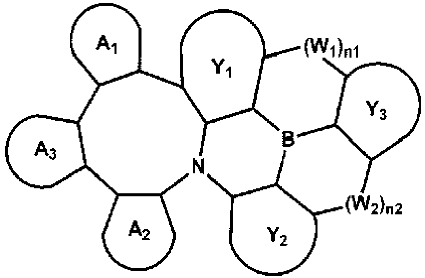 dans la Formule 1 est représenté par l'une des Formules 1A-1 à 1A-3, 1B-1 à 1B-2, 1C-1 à 1C-5, 1D-1 à 1D-5 et 1E-1 à 1E-5 : 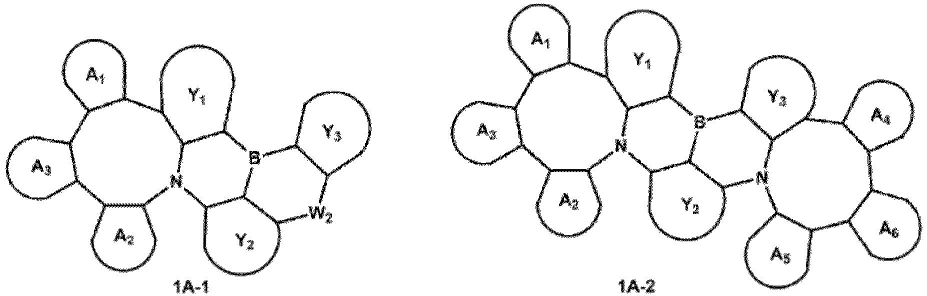 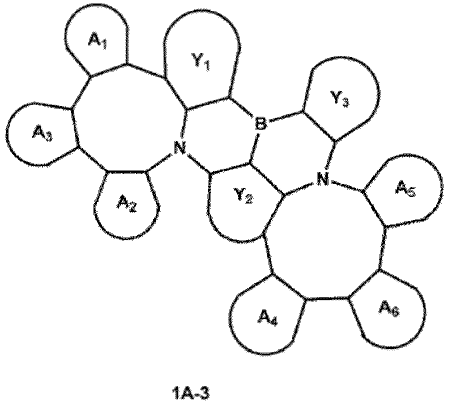 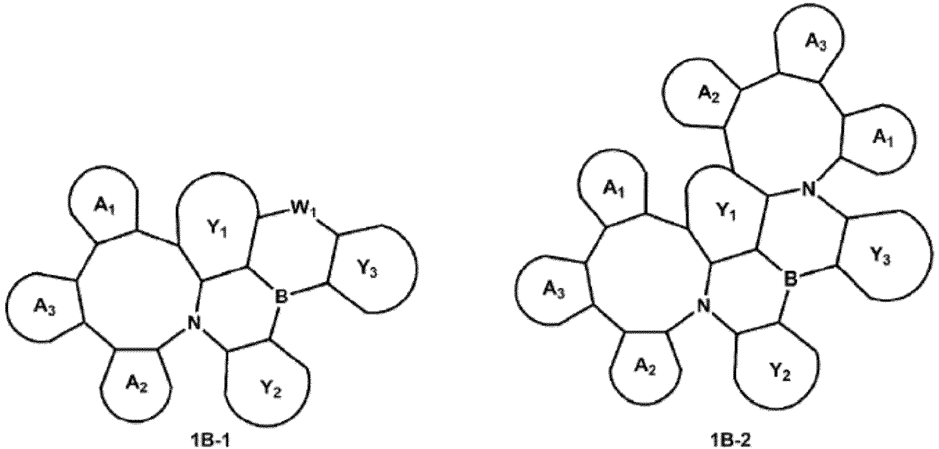 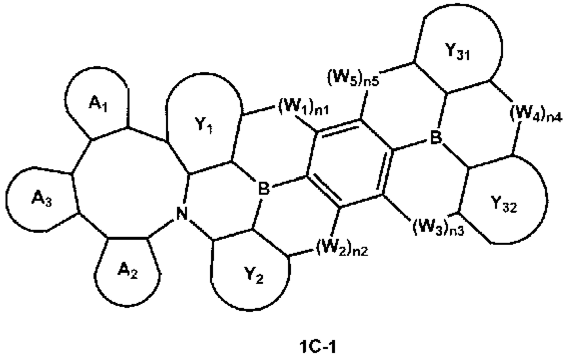 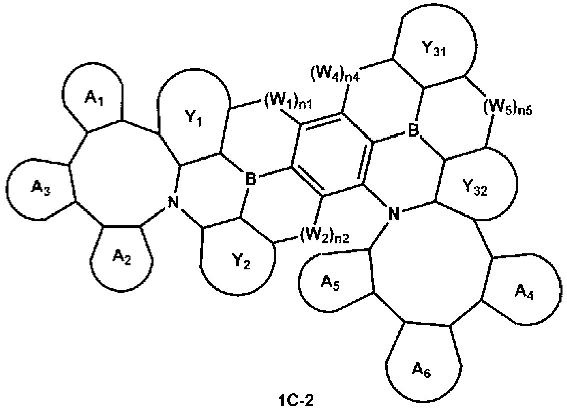 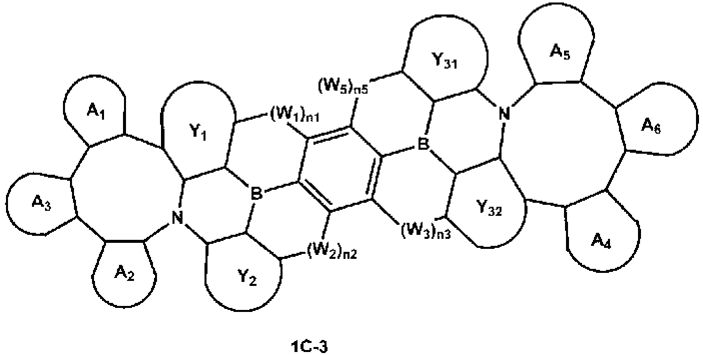 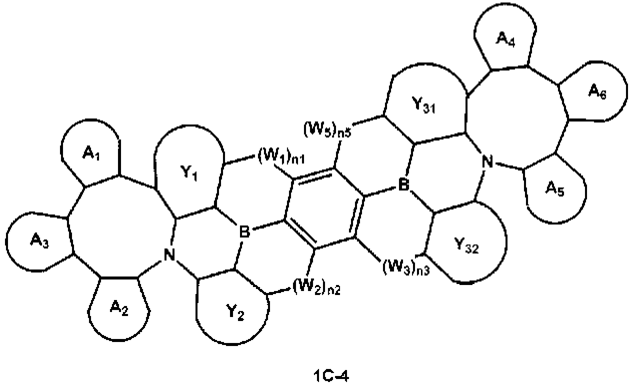 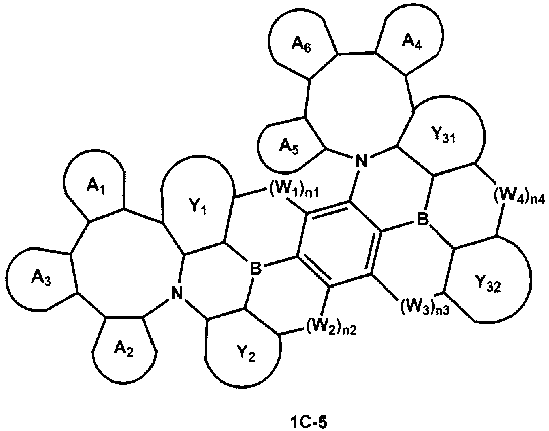 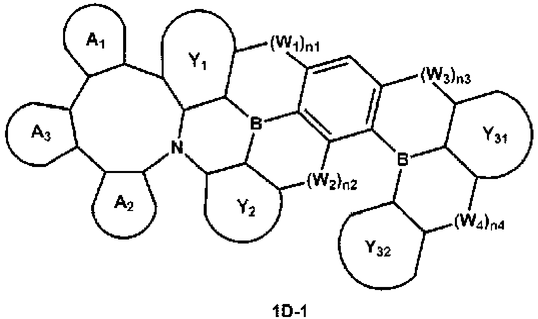 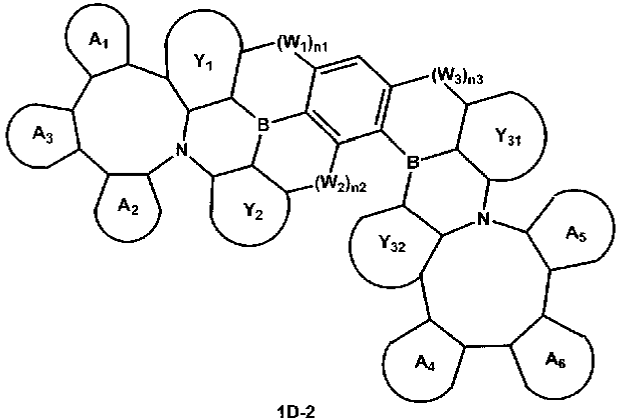 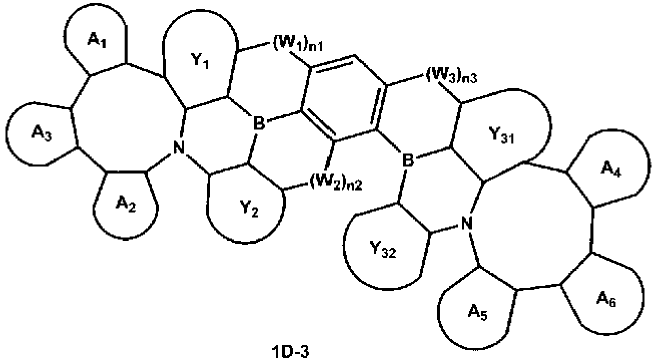 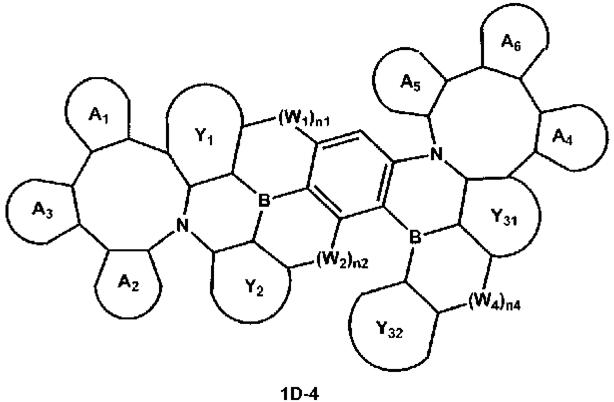 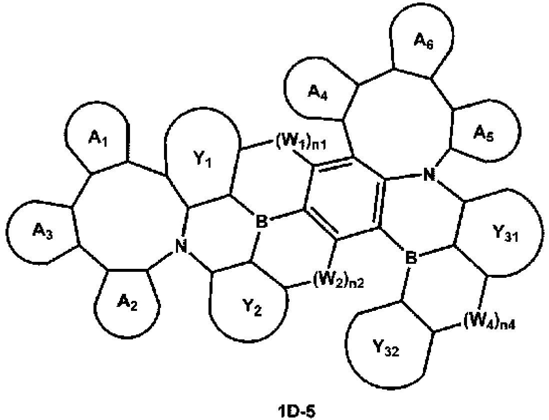 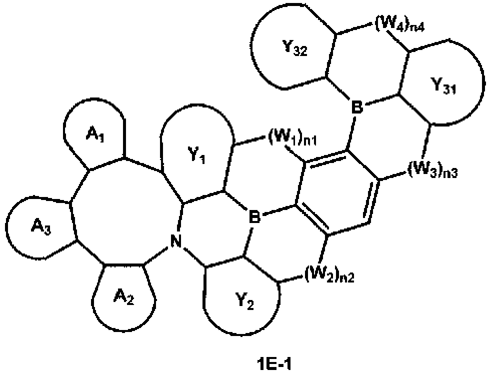 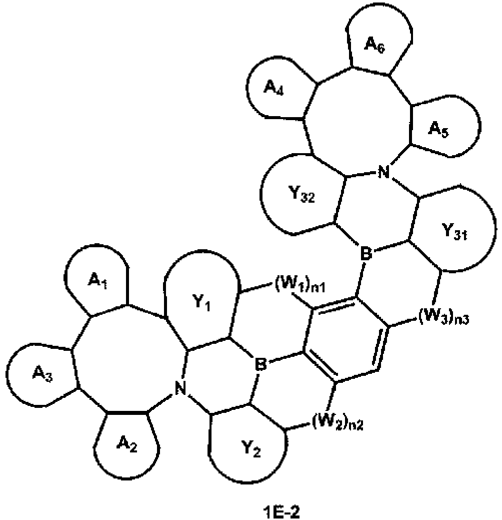 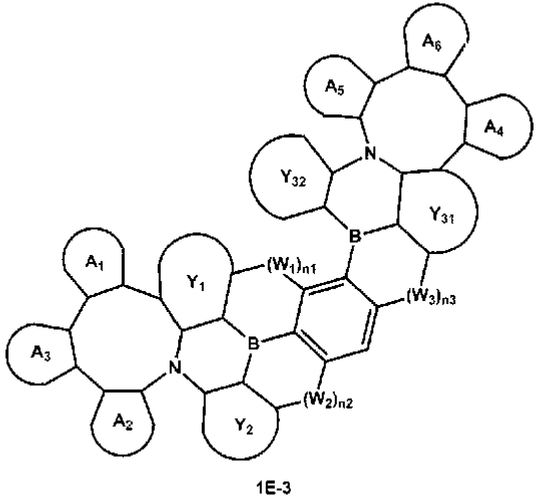 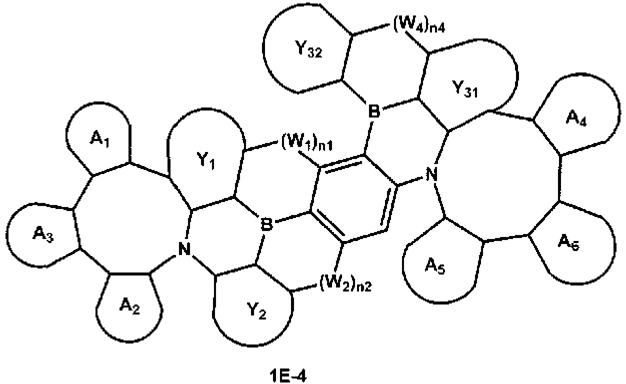 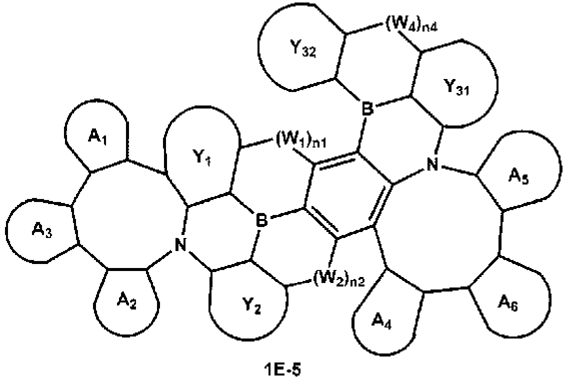
dans lequel, dans les Formules 1A-1 à 1A-3, 1B-1 à 1B-2, 1C-1 à 1C-5, 1D-1 à 1D-5 et 1E-1 à 1E-5,
les cycles A₁ à A₃, les cycles Y₁ à Y₃, W₁, W₂, n1 et n2 sont chacun tels que définis dans la revendication 5,
les cycles A₄ à A₆ sont chacun tels que définis en relation avec le cycle A₁,
les cycles Y₃₁ à Y₃₂ sont chacun tels que définis en relation avec le cycle Y₃,
W₃ est une liaison simple, O, S, N(T₃₁), C(T₃₁)(T₃₂), ou Si(T₃₁)(T₃₂),
W₄ est une liaison simple, O, S, N(T₄₁), C(T₄₁)(T₄₂), ou Si(T₄₁)(T₄₂),
W₅ est une liaison simple, O, S, N(T₅₁), C(T₅₁)(T₅₂), ou Si(T₅₁)(T₅₂),
T₃₁, T₃₂, T₄₁, T₄₂, T₅₁ et T₅₂ sont chacun i) tels que définis en relation avec Z₁, ou ii) liés à un substituant voisin pour former un autre cycle condensé avec un cycle voisin,
n3 à n5 valent chacun indépendamment 0 ou 1,
lorsque n3 vaut 0, *-(W₃)ₙ₃-*' n'est pas présent,
lorsque n4 vaut 0, *-(W₄)ₙ₄-*' n'est pas présent,
lorsque n5 vaut 0, *-(W₅)ₙ₅-*' n'est pas présent,
dans la Formule 1C-1, la somme de n3, n4 et n5 est égale à 1 ou plus,
dans la Formule 1C-2, la somme de n4 et n5 est égale à 1 ou plus,
dans les Formules 1C-3 et 1C-4, la somme de n3 et n5 est égale à 1 ou plus,
dans les Formules 1C-5, 1D-1 et 1E-1, la somme de n3 et n4 est égale à 1 ou plus,
dans les Formules 1D-2, 1D-3, 1E-2 et 1E-3, n3 vaut 1, et
dans les Formules 1D-4, 1D-5, 1E-4 et 1E-5, n4 vaut 1.

10. Dispositif électroluminescent comprenant :
une première électrode ;
une seconde électrode ; et
une couche intermédiaire agencée entre la première électrode et la seconde électrode et comprenant une couche d'émission ;
dans lequel la couche intermédiaire comprend le composé polycyclique condensé de l'une quelconque des revendications 1 à 9.

11. Dispositif électroluminescent de la revendication 10, dans lequel la couche d'émission comprend le composé polycyclique condensé ;
de préférence, dans lequel une longueur d'onde de pic d'émission de lumière émise par la couche d'émission est de 440 nm à 470 nm.

12. Dispositif électroluminescent de la revendication 11, dans lequel le composé polycyclique condensé compris dans la couche d'émission est un émetteur.

13. Dispositif électroluminescent des revendications 11 ou 12, dans lequel la couche d'émission comprend en outre un sensibilisateur, et le sensibilisateur est différent du composé polycyclique condensé ;
de préférence, dans lequel le sensibilisateur est un composé organométallique, un matériau à fluorescence retardée, un matériau à fluorescence rapide, ou toute combinaison de ceux-ci ;
de préférence, dans lequel le composé organométallique comprend un métal de transition et un ligand tétradenté lié au métal de transition,
le métal de transition est le platine ou le palladium, et
le ligand tétradenté comprend un fragment carbène lié au métal de transition.

14. Dispositif électroluminescent de la revendication 11, dans lequel le composé polycyclique condensé compris dans la couche d'émission est un sensibilisateur.

15. Appareil électronique comprenant le dispositif électroluminescent de l'une quelconque des revendications 10 à 14.
